# EUROPEAN PATENT APPLICATION

(11) **EP 4 679 102 A1**
(43) Date of publication of application: **14.01.2026**
(21) Application number: 25156385.4
(22) Date of filing: 06.02.2025
(51) Int. Cl.: G01R 15/20

(54) **CURRENT SENSOR DEVICES AND SYSTEMS FOR MEASURING MULTIPLE CURRENTS**

(71) Applicant: Melexis Technologies SA, 2022 Bevaix (CH)
(72) Inventor: BRONUZZI, JACOPO, 2022 Bevaix (CH); BOURY, Bruno, 3980 Tessenderlo (BE); TOMBEZ, Lionel, 2022 Bevaix (CH)
(74) Representative: Jacobs, Lambert

(57) **Abstract**

An integrated current sensor device (1200) for measuring two independent currents (11, 12), comprising: a semiconductor substrate (1201) comprising a plurality of at least two magnetic sensors (H1, H2, H3, H4); a processing circuit (4113) connected to said magnetic sensors, and configured for determining a value (11) of a first current flowing through a first conductor portion (C1), and a value (12) of a second current flowing through a second conductor portion (C2), based on signals obtained from magnetic sensors, e.g. based on pairwise differences. The conductor portions may be internal or external, may be crossing or parallel, may have a zig-zag, may have a U-shape. The magnetic sensors may comprise two to four Hall elements, with or without integrated magnetic concentrators.

## Description

### Field of the invention

The present invention relates in general to the field of current sensors, and more in particular to current sensors and systems capable of measuring two independent currents flowing through two conductors using magnetic sensors.

### Background of the invention

Current sensor systems using magnetic sensors are known in the art. They offer the advantage of being able to measure a current without making physical contact, thus avoiding problems of different voltage domains, short-circuits, etc.

Electrical power is typically provided via two or more electrical conductors. For example, in "three-phase systems" power is provided via three conductors, often carrying currents which are 120° phase shifted.

Electrical motors for industrial and automotive applications require precise control, hence precise current measurements for each of the phases, over a broad frequency range.

Many variants of current sensor systems exist, addressing one or more of the following requirements: using a simple or cheap sensor device, being able to measure over a relatively large current range, being able to measure over a relatively large frequency range (e.g. from DC up to 2 kHz), being able to measure with great accuracy, requiring only simple arithmetic, being able to measure at high speed, being highly robust against positioning errors, being highly robust against an external disturbance field, providing redundancy, having a good signal-to-noise ratio (SNR), being compact (e.g. small printed circuit board), etc. Often two or more of these requirements conflict with each other, hence a trade-off needs to be made.

There is always room for improvements or alternatives.

### Summary of the invention

It is an object of embodiments of the present invention to provide a current sensor device capable of measuring two electrical currents flowing in two separate conductors, and to systems comprising one or more of such current sensor devices and one or more conductors, e.g. bus bars.

It is an object of embodiments of the present invention to provide a compact current sensor device for accurately measuring currents through a plurality of conductors.

It is an object of embodiments of the present invention to provide a current sensor device or system which is more compact than prior art solutions.

It is an object of embodiments of the present invention to provide a current sensor device or system capable of measuring the two current with high accuracy, e.g. with with reduced cross-talk, and/or with reduced influence from an external disturbance field, preferably without using a magnetic shielding.

It is an object of embodiments of the present invention to provide a current sensor device or system capable of measuring said two currents in a redundant manner, and/or that also has error detection capabilities.

It is an object of embodiments of the present invention to provide such a device and system, suitable for use in an industrial, automotive and/or robotic environment.

It is an object of embodiments of the present invention to provide such a device and system, wherein the mounting requirements and/or the mounting tolerances of the sensor device relative to the electrical conductors are relaxed.

It is an object of embodiments of the present invention to provide such a current sensor device and system, requiring a less powerful processor, and/or requiring less processing power, and/or using a simpler algorithm, e.g. to remove any cross-talk between the conductors.

It is an object of particular embodiments of the present invention to provide a current sensor device with two integrated conductor portions and with a plurality of magnetic sensors, where the conductors have particular geometrical features, and where the magnetic sensors are arranged in a particular manner, for reducing cross-talk between the conductors in a passive manner.

It is an object of particular embodiments of the present invention to provide a current sensor device with two integrated conductor portions and with a plurality of magnetic sensors, where cross-talk between the conductors is reduced by means of a simple calculation.

It is an object of particular embodiments of the present invention to provide a current sensor device or system, where the currents are calculated in a manner that requires only a very small number of parameters (e.g. only two, or only four) that can be determined during a calibration test in a very simple manner.

It is an object of particular embodiments of the present invention to provide a current sensor device with two integrated conductor portions that are co-planar.

It is an object of particular embodiments of the present invention to provide a current sensor device capable of measuring the two currents in an accurate manner, using a reduced number of magnetic sensor elements.

These and other objectives are accomplished by embodiments of the present invention.

According to a first aspect, the present invention provides an integrated current sensor device for measuring two currents (e.g. I1, I2) flowing through two conductor portions (e.g. C1, C2), the integrated current sensor device comprising: a semiconductor substrate comprising a plurality of at least two (or at least three or at least four) magnetic sensors; a processing circuit connected to said plurality of magnetic sensors, and configured for determining a first current value (e.g. I1) of a first current flowing through a first conductor portion (e.g. C1) and for determining a second current value (e.g. I2) of a second current flowing through a second conductor portion (e.g. C2), based on signals obtained from said plurality of magnetic sensors.

In an embodiment, the two currents are two independent currents.

In an embodiment, the processing circuit is implemented on the same substrate that also contains the magnetic sensor elements.

In an embodiment, the processing circuit is implemented on a second semiconductor substrate, different from the first semiconductor substrate, but communicatively connected to the first substrate containing the magnetic sensors.

In an embodiment, each magnetic sensor is configured for measuring one (e.g. only one) magnetic field component at a particular sensor location.

In an embodiment, each magnetic sensor is configured for measuring only one magnetic field component at a particular sensor location. Such magnetic sensor is sometimes referred to as a "1D magnetic pixel".

In some embodiments, at least two of the plurality of magnetic sensors are spaced apart by a distance of at least 1100 micrometer, or at least 1200 micrometer, or at least 1300 micrometer.

In an embodiment, the plurality of magnetic sensors comprises at least two magnetic sensors situated at two different sensor locations, e.g. at least two 1D magnetic pixels.

In an embodiment, the plurality of magnetic sensors comprises at least three magnetic sensors situated at three different sensor locations, e.g. at least three 1D magnetic pixels.

In an embodiment, the plurality of magnetic sensors comprises at least four magnetic sensors situated at four different sensor locations, e.g. at least four 1D magnetic pixels.

In an embodiment, the integrated current sensor device is a packaged semiconductor device (also known as "chip"), and at least one of the first conductor portion (e.g. C1) and the second conductor portion (e.g. C2) is integrated in the packaged semiconductor device.

In preferred embodiments, the package may be a QFN package (which is an acronym for quad flat no-lead package), or an SOIC package (which is an acronym for small outline integrated circuit), but other packages may also be used.

In an embodiment, the at least one integrated conductor portion is integrally formed with the contacts (e.g. leads or package terminals) of the package. For example, the leads (or contacts) and the internal conductor(s) of an SOIC package can be made of the same piece of conductive material (e.g. Al or Cu). The same applies for a QFN package, where the contacts (e.g. leads or package terminals) and the internal conductor(s) can be made of the same piece of conductive material (e.g. a leadframe).

In an embodiment, the semiconductor substrate comprising the magnetic sensor elements also comprises the processing unit.

Alternatively, the processing unit may be implemented on a second semiconductor substrate also incorporated in the same packaged device.

The packaged semiconductor device may be packaged using "molded interconnect substrate" (MIS) technology.

In an embodiment, the the integrated current sensor device is a packaged semiconductor device (also known as "chip"), and each of the first conductor portion (e.g. C1) and the second conductor portion (e.g. C2) is integrated in the packaged semiconductor device.

In an embodiment, the two conductor portions (e.g. C1, C2) are coplanar.

In an embodiment, the two conductor portions (e.g. C1, C2) are situated in different planes.

In an embodiment, each of the first and the second conductor portion (e.g. C1, C2) has an elongated shape with a constant thickness; and the first conductor portion (e.g. C1) is oriented in a first direction (e.g. X); and the second conductor portion (e.g. C2) is oriented in a second direction (e.g. Y) perpendicular to the first direction; and the first and the second conductor portions partially overlap each other in an overlapping region.

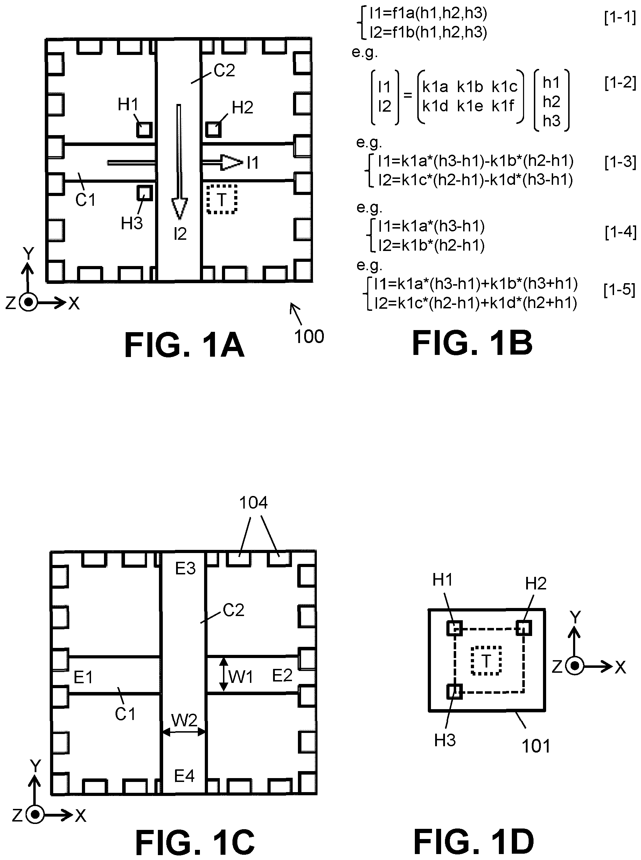

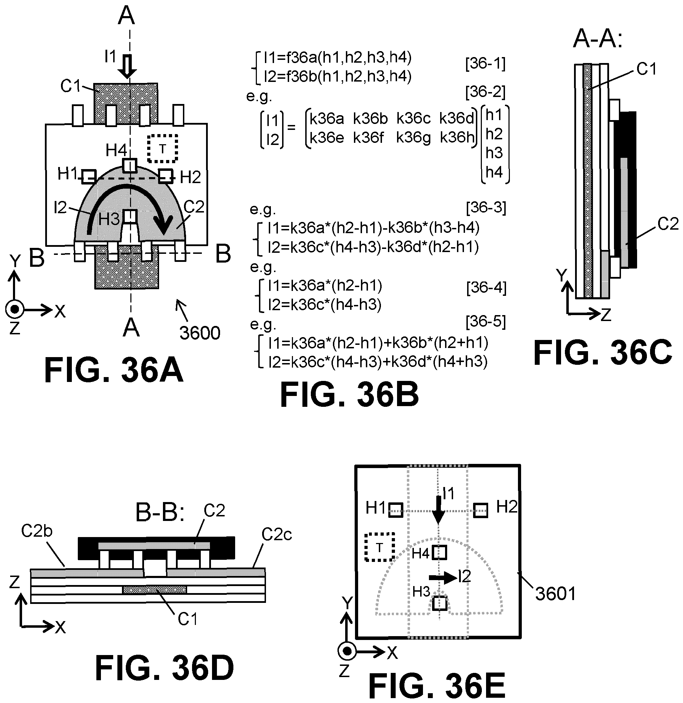

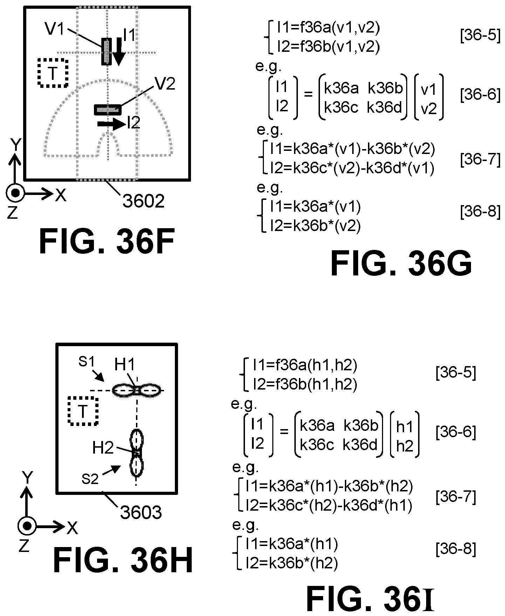

Examples of this embodiment are illustrated (inter alia) in FIG. 1 to FIG. 8, but also in FIG. 36 to FIG. 40.

In an embodiment, the semiconductor substrate comprising the plurality of magnetic sensors is situated in a plane located between a first plane that contains the first conductor portion, and a second plane that contains the second conductor portion, (e.g. at different positions in the Z-direction).

In an embodiment, the semiconductor substrate comprising the plurality of magnetic sensors is situated above the first and the second conductor. (e.g. in a plane distal from the contacts of the package).

In an embodiment, the first conductor portion (e.g. C1) and the second conductor portion (e.g. C2) are located next to each other, without overlapping each other.

In an embodiment, the first conductor portion (e.g. C1) and the second conductor portion (e.g. C2) are co-planar.

In an embodiment, each of the first and the second conductor portion (e.g. C1, C2) has an elongated shape; and the first conductor portion (e.g. C1) and the second conductor portion (e.g. C2) extend in the same direction, or are parallel to each.

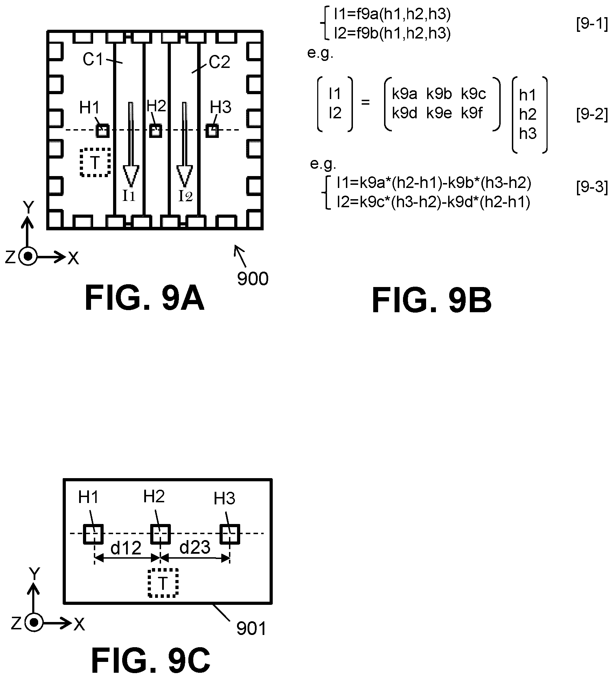

Examples of this embodiment are shown (inter alia) in FIG. 9 to FIG. 20.

In an embodiment, the second conductor portion (C2) has a constant cross-section.

In an embodiment, the second conductor portion (C2) has at least one cut-out for narrowing the width of the second conductor portion. (e.g. on side side, or on two opposite sides).

In an embodiment, the second conductor portion (C2) has two cut-outs on opposite sides forming a second zigzag.

In an embodiment, each of the first and the second conductor portion (e.g. C1, C2) has an overall elongated shape extending along two parallel lines; and the first conductor portion (e.g. C1) has two cut-outs (e.g. co1, co2) on opposite sides forming a first zigzag (e.g. zz1) for forcing the first current (e.g. I1) to flow in a direction different from the first direction (e.g. X), e.g. in a direction forming an angle of 80° to 100° with the first direction, or e.g. in a direction forming an angle of 35° to 55° with the first direction.

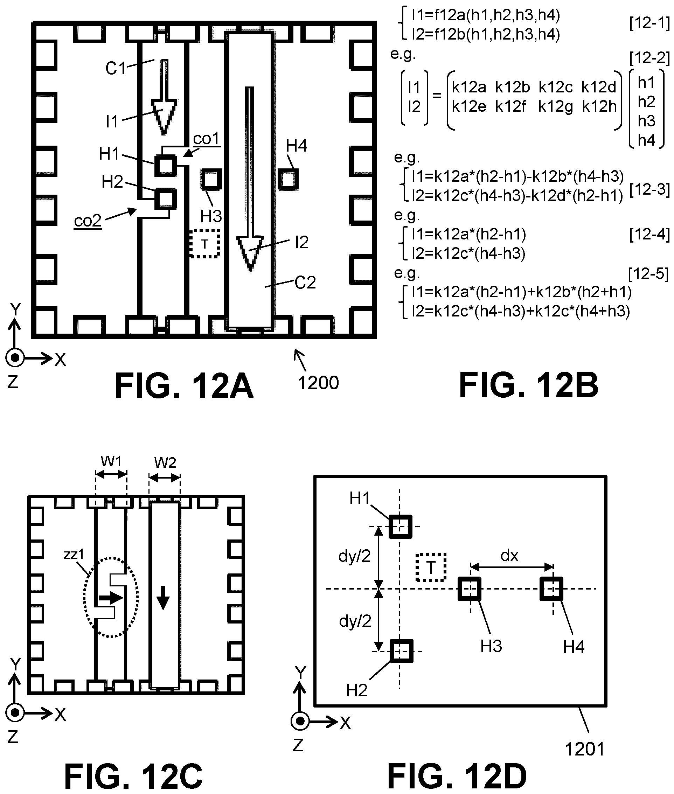

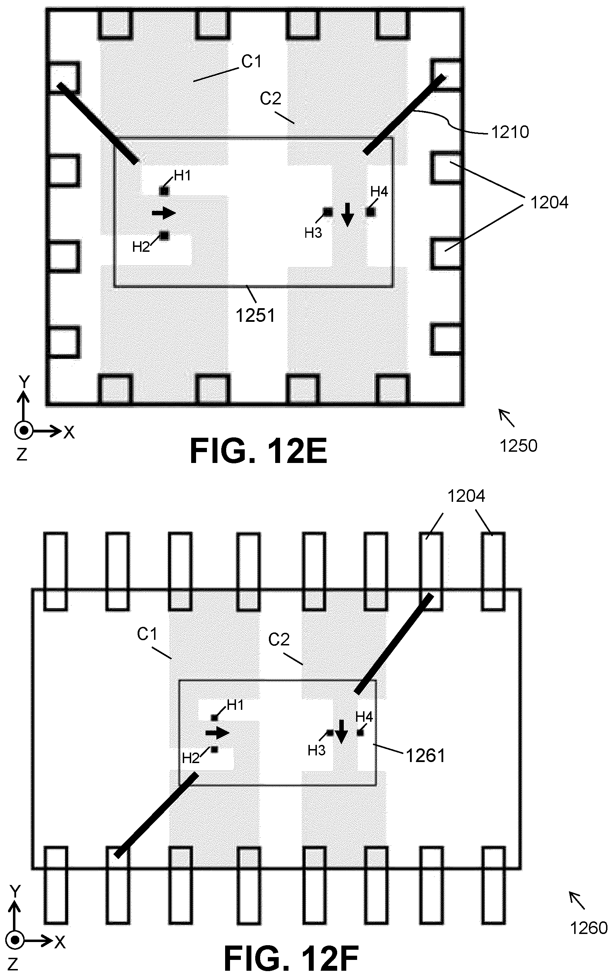

Examples of this embodiment are shown (inter alia) in FIG. 12 to FIG. 21.

In an embodiment, each of the first and the second conductor portion (e.g. C1, C2) has an overall elongated shape extending along two parallel lines; and the first conductor portion has two cut-outs on opposite sides thereof forming a first zigzag to force the first current to flow in a direction different from the first direction; and the second conductor portion has two cut-outs on opposite sides thereof forming a second zigzag to force the second current to flow in a direction different from the first direction, e.g. in a direction forming an angle of 80° to 100° with the first direction, or e.g. in a direction forming an angle of 35° to 55° with the first direction.

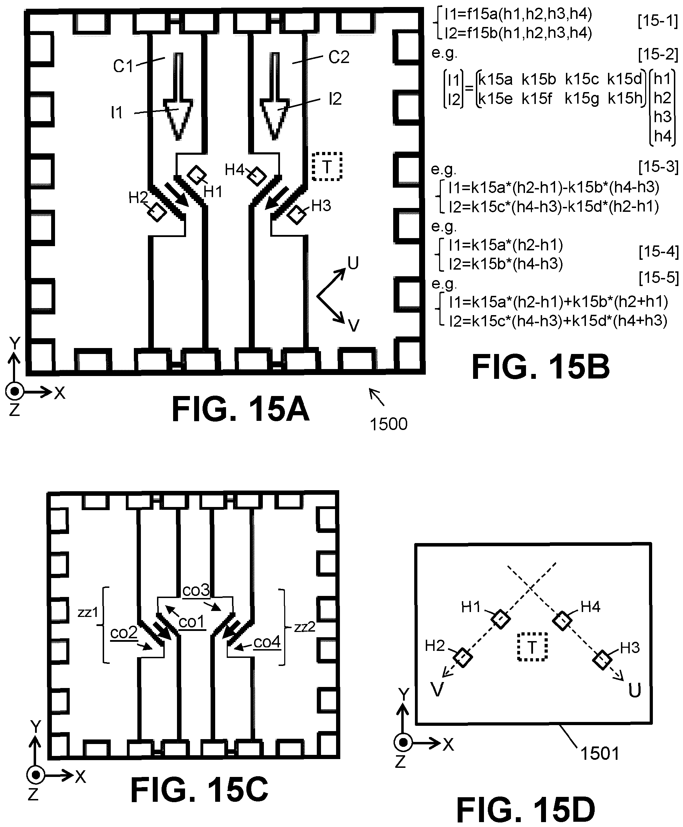

Examples of this embodiment are shown (inter alia) in FIG. 15 to FIG. 20.

In an embodiment, the first and second conductor portion do not overlap each other, and at least one, or both of the first and the second conductor portion (e.g. C1, C2) has a U-shape or a V-shape; and wherein each end (e.g. E1, E2) of the first conductor portion (e.g. C1), and each end (e.g. E3, E4) of the second conductor portion (e.g. C2) is connected to at least two pins or terminals of the package.

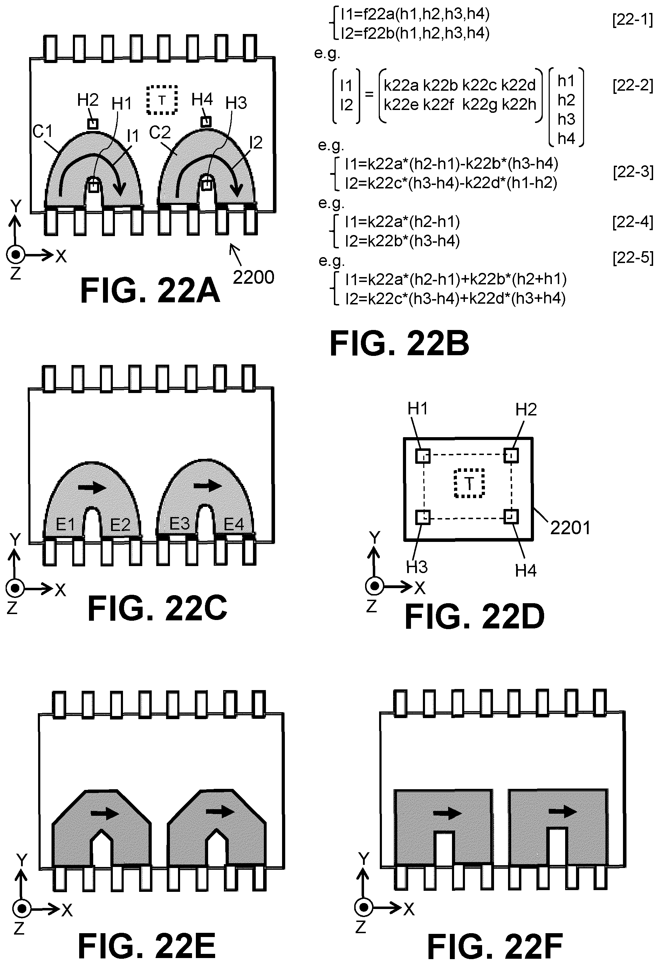

Examples of this embodiment are shown (inter alia) in FIG. 22 to FIG. 35.

In an embodiment, both ends (e.g. E1, E2) of the first conductor portion (e.g. C1) and both ends (e.g. E3, E4) of the second conductor portion (e.g. C2) are situated on a first side of the package.

Examples of this embodiment are illustrated (inter alia) in FIG. 22 to FIG. 27.

In an embodiment, the two ends (e.g. E1, E2) of the first conductor portion (e.g. C1) are situated on a first side of the package, and the two ends (e.g. E3, E4) of the second conductor portion (e.g. C2) are situated on a second side of the package, opposite the first side.

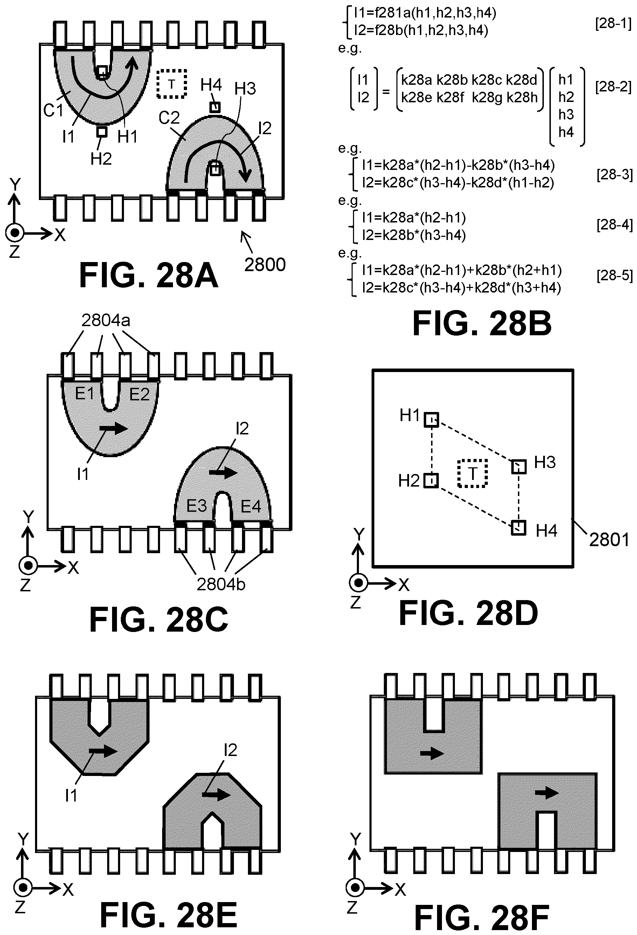

Examples of this embodiment are illustrated (inter alia) in FIG. 28 to FIG. 35.

In an embodiment, the plurality of magnetic sensors are configured for measuring magnetic field components oriented perpendicular to the semiconductor substrate.

The magnetic sensors may be horizontal Hall elements without integrated magnetic concentrator (IMC).

In an embodiment, the plurality of magnetic sensors comprises three horizontal Hall elements (e.g. H1, H2, H3) situated at three corners of a virtual rectangle for measuring three magnetic field components (e.g. Bz1, Bz2, Bz3) oriented in a direction (e.g. Z) perpendicular to the semiconductor substrate.

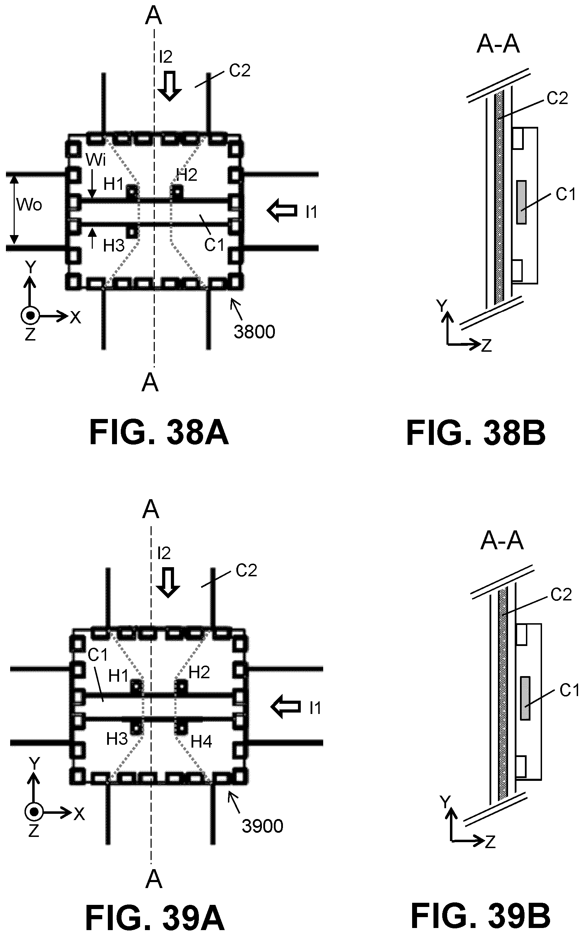

Examples of this embodiment are illustrated (inter alia) in FIG. 1A, and FIG. 38A.

In an embodiment, the plurality of magnetic sensors comprises three horizontal Hall elements (e.g. H1, H2, H3) situated at three corners of a virtual triangle, e.g. an equilateral triangle or an isosceles triangle, or a right-angled triangle for measuring three magnetic field components (e.g. Bz1, Bz2, Bz3) oriented in a direction (e.g. Z) perpendicular to the semiconductor substrate.

Examples of this embodiment are illustrated (inter alia) in FIG. 1A, FIG. 23, and FIG. 31.

In an embodiment, the plurality of magnetic sensors comprises three horizontal Hall elements (e.g. H1, H2, H3) situated on a virtual line for measuring three magnetic field components (Bz1, Bz2, Bz3) oriented in a direction (Z) perpendicular to the semiconductor substrate.

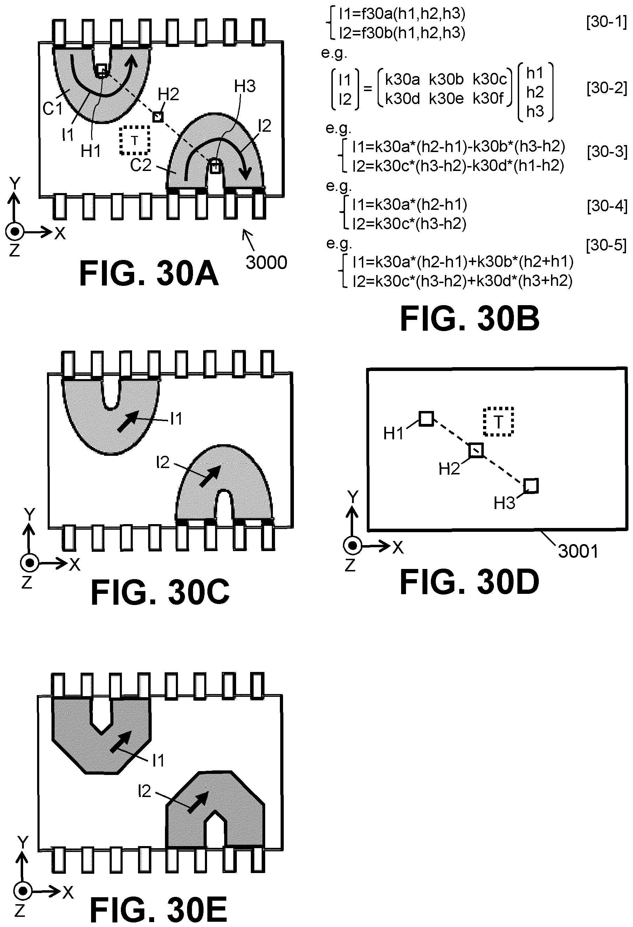

Examples of this embodiment are illustrated (inter alia) in FIG. 9 and FIG. 30.

In an embodiment, the plurality of magnetic sensors comprises four horizontal Hall elements (e.g. H1, H2, H3, H4) situated at the corners of a virtual rectangle or at the corners of a virtual diamond for measuring four magnetic field components (e.g. Bz1, Bz2, Bz3, Bz4) oriented in a direction (e.g. Z) perpendicular to the semiconductor substrate.

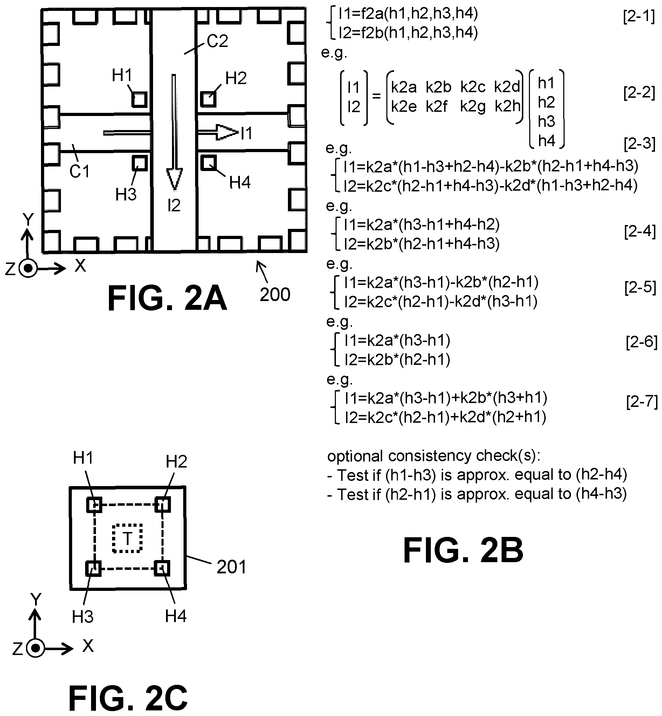

Examples of this embodiment are illustrated (inter alia) in FIG. 2A, FIG. 19A, FIG. 22, FIG. 36, FIG. 39A, FIG. 40.

In an embodiment, the plurality of magnetic sensors comprises four horizontal Hall elements (e.g. H1, H2, H3, H4) including a first and a second horizontal Hall element (e.g. H1, H2) situated on a first line segment, and a third and a fourth horizontal Hall element (e.g. H3, H4) situated on a second line segment perpendicular to the first line segment, for measuring four magnetic field components (e.g. Bz1, Bz2, Bz3, Bz4) oriented in a direction (e.g. Z) perpendicular to the semiconductor substrate.

Examples of this embodiment are illustrated (inter alia) in FIG. 12, FIG. 15, FIG. 29, FIG. 36E.

In an embodiment, the plurality of magnetic sensors comprises four horizontal Hall elements (e.g. H1, H2, H3, H4) situated at the corners of a parallelogram, for measuring four magnetic field components (e.g. Bz1, Bz2, Bz3, Bz4) oriented in a direction (e.g. Z) perpendicular to the semiconductor substrate.

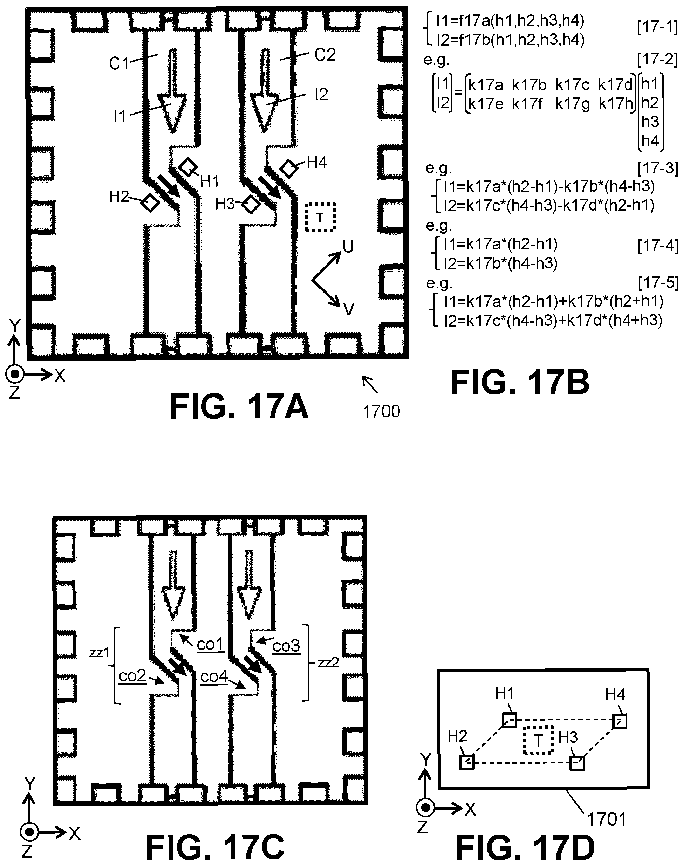

Examples of this embodiment are illustrated (inter alia) in FIG. 17, FIG. 19E, FIG. 19F, FIG. 28.

In an embodiment, the plurality of magnetic sensors are configured for measuring a plurality of magnetic field components parallel to the semiconductor substrate.

The plurality of magnetic sensors may comprise for example two or three or four vertical Hall elements, or two or three or four magnetoresistance (MR) elements, or a combination of vertical Hall elements and magnetoresistive elements.

In an embodiment, the plurality of magnetic sensors comprise two vertical Hall elements (e.g. V1, V2) including a first vertical Hall element (e.g. V1) situated above the first conductor (e.g. C1) for measuring a first magnetic field component oriented in a first direction parallel to the semiconductor substrate, and a second vertical Hall element (e.g. V2) situated above the second conductor (e.g. C2) for measuring a second magnetic field component oriented in a second direction parallel to the semiconductor substrate, perpendicular to the first direction.

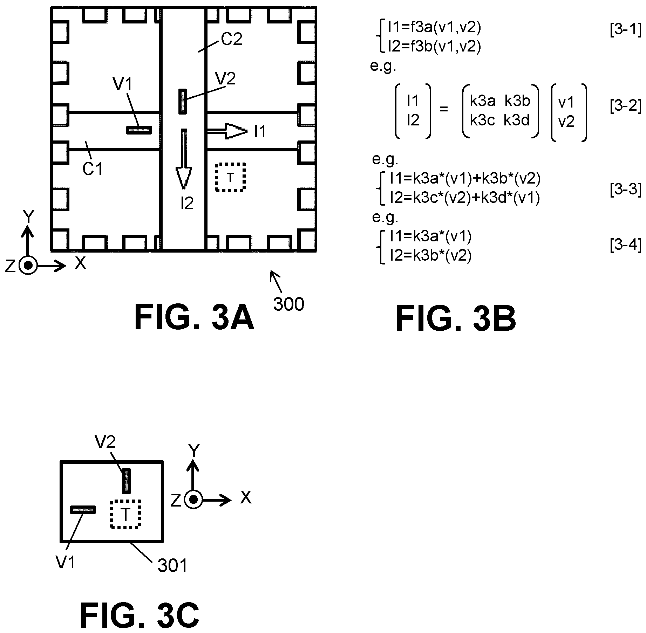

Examples of this embodiment are illustrated (inter alia) in FIG. 3A, FIG. 13, FIG. 16, FIG. 26, FIG. 27, FIG. 34, FIG. 35, FIG. 36.

In an embodiment, the plurality of magnetic sensors comprise a first vertical Hall element (e.g. V1) situated above the first conductor (e.g. C1) for measuring a first magnetic field component oriented in a first direction parallel to the semiconductor substrate, and a second vertical Hall element (e.g. V2) situated above the second conductor (e.g. C2) for measuring a second magnetic field component also oriented in said first direction.

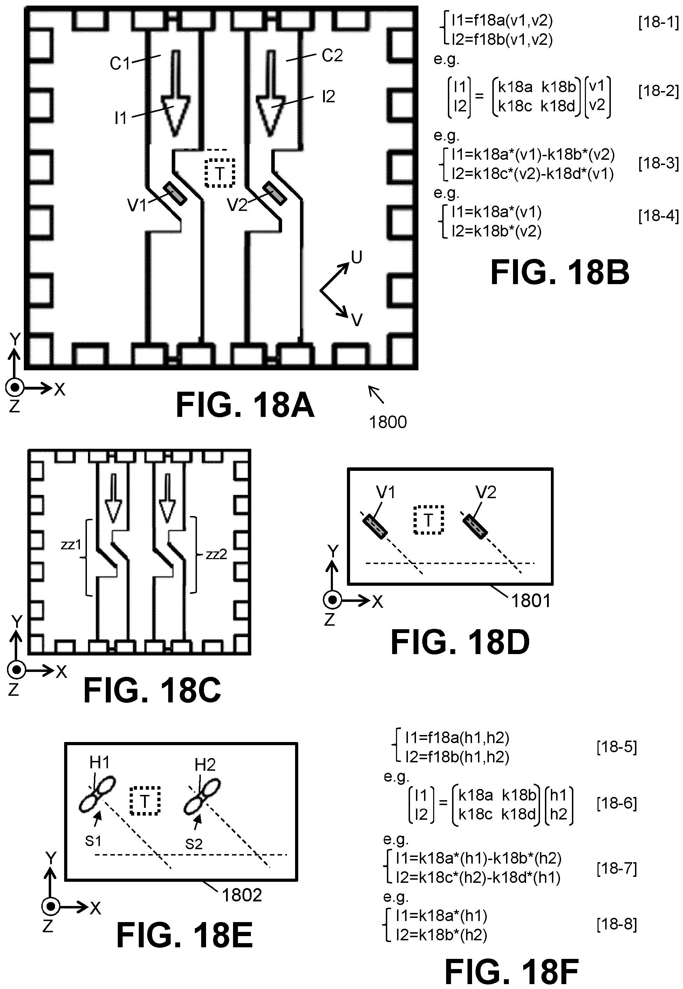

Examples of this embodiment are illustrated (inter alia) in FIG. 18, FIG. 20, FIG. 24, FIG. 32, FIG. 33.

In an embodiment, the plurality of magnetic sensors comprise four vertical Hall elements including two vertical Hall elements (e.g. V1, V3) situated above the first conductor (e.g. C1) for measuring two magnetic field components oriented in a first direction parallel to the semiconductor substrate, and two vertical Hall elements (e.g. V2, V4) situated above the second conductor (e.g. C2) for measuring two magnetic field components oriented in a second direction parallel to the semiconductor substrate, perpendicular to the first direction.

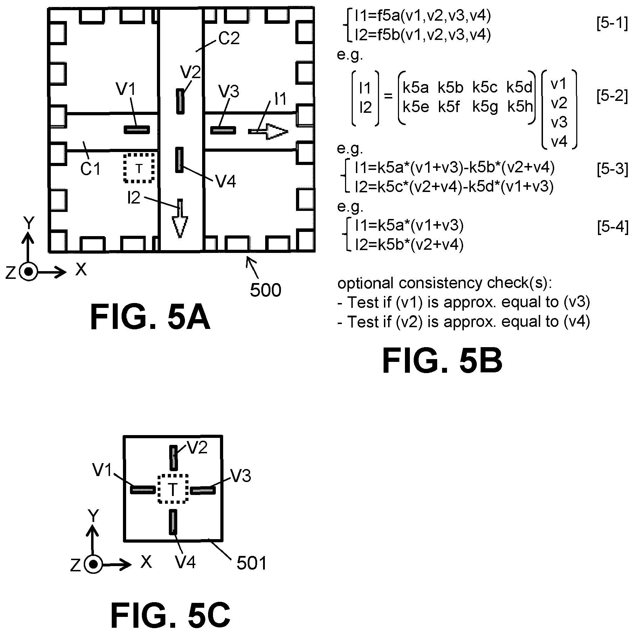

Examples of this embodiment are illustrated (inter alia) in FIG. 5.

In an embodiment, the plurality of magnetic sensors comprise four vertical Hall elements including a first vertical Hall element (e.g. V1) situated above the first conductor (e.g. C1) for measuring a first magnetic field component (e.g. By1) oriented in a first direction (e.g. Y) parallel to the semiconductor substrate, and a second vertical Hall element (e.g. V2) situated above the second conductor (e.g. C2) for measuring a second magnetic field component (e.g. Bx2) oriented in a second direction (e.g. X) perpendicular to the first direction, and a third vertical Hall element (e.g. V3) optionally situated above the first conductor or between the two conductor portions for measuring a third magnetic field component (e.g. Bx3) oriented in the second direction (e.g. X), and a fourth vertical Hall element (e.g. V2) optionally situated above the second conductor or between the two conductor portions for measuring a fourth magnetic field component (e.g. Bx4) oriented in the second direction (e.g. X).

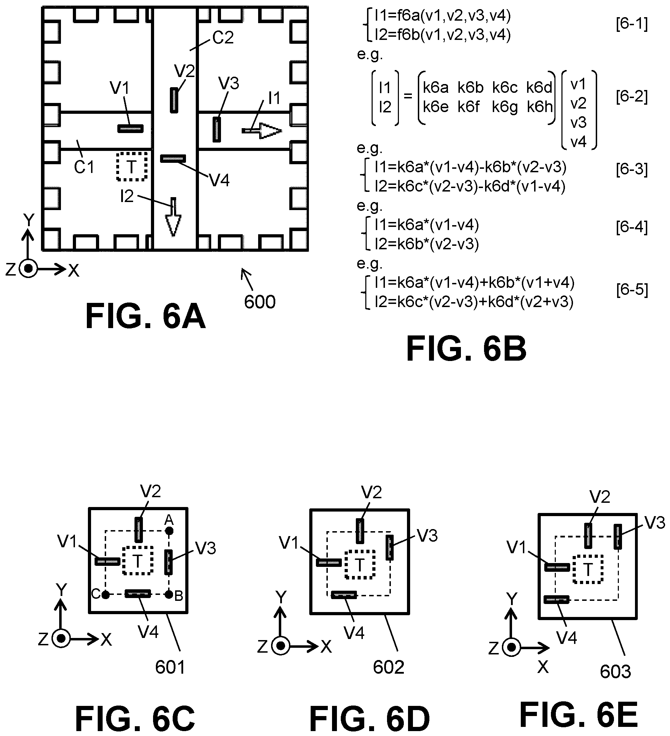

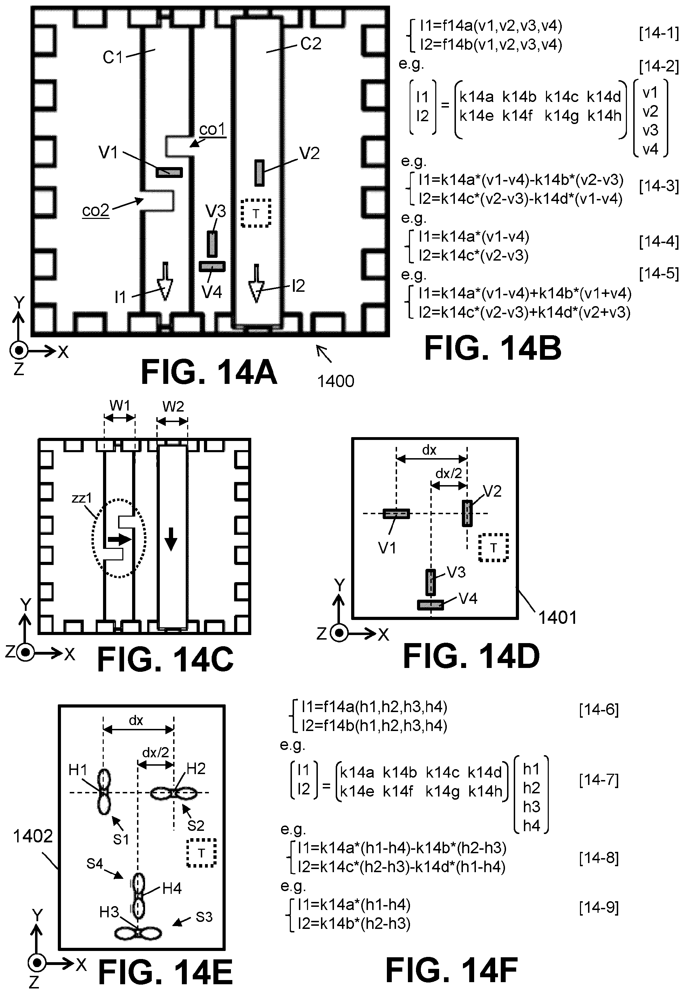

Examples of this embodiment are illustrated (inter alia) in FIG. 6, FIG. 14.

In an embodiment, the plurality of magnetic sensors comprises three vertical Hall elements (e.g. V1, V2, V3) situated on a virtual line for measuring three magnetic field components (e.g. Bx1, Bx2, Bx3) oriented in a direction (e.g. X) perpendicular to the semiconductor substrate.

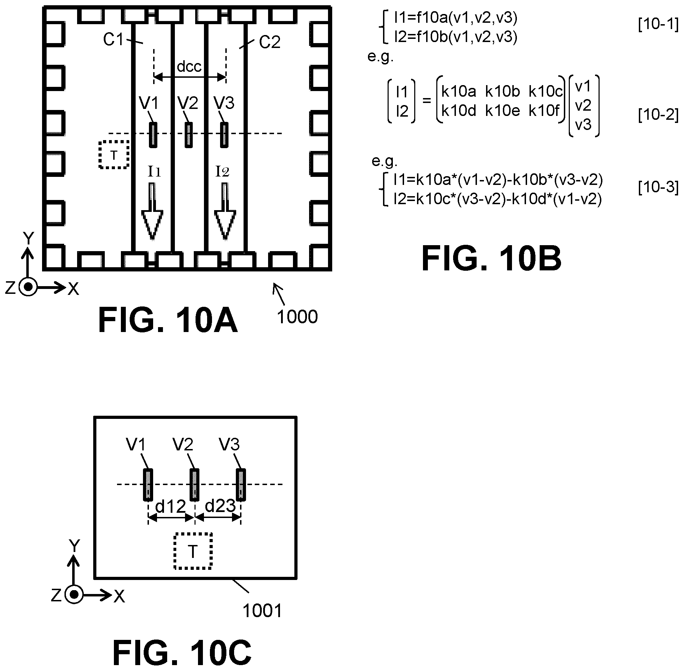

Examples of this embodiment are illustrated (inter alia) in FIG. 10.

In an embodiment, the plurality of magnetic sensors comprises three vertical Hall elements (e.g. V1, V2, V3) situated at the corners of an isosceles triangle for measuring three magnetic field components (e.g. By1, By2, By3) oriented in a direction (e.g. Y) perpendicular to the semiconductor substrate.

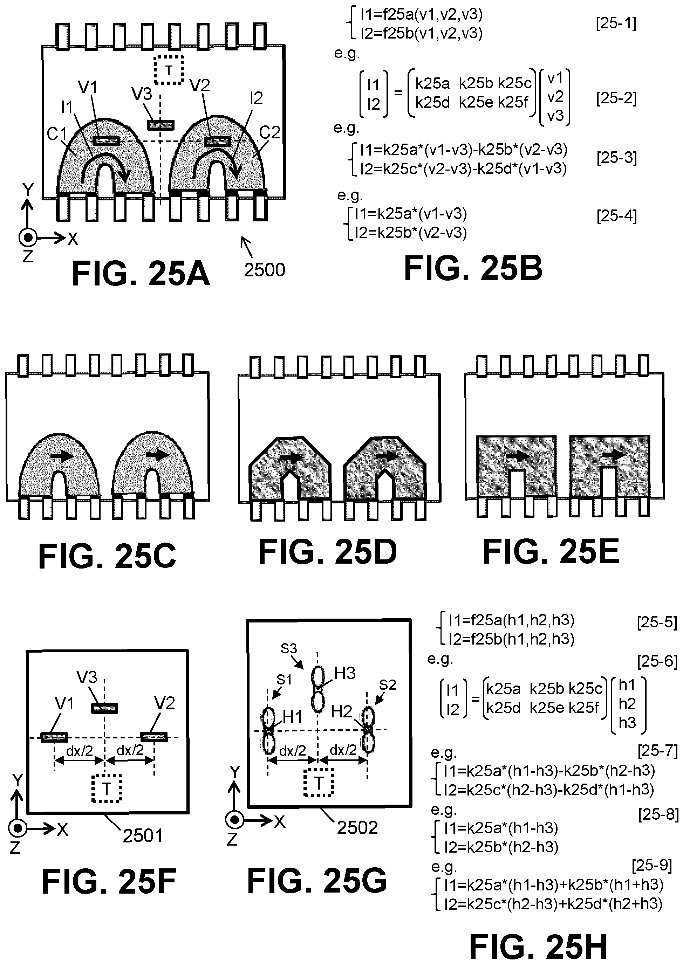

Examples of this embodiment are illustrated (inter alia) in FIG. 25.

In an embodiment, each of the magnetic sensors comprises a horizontal Hall element and a pair of integrated magnetic concentrators, e.g. located on opposite sides of the horizontal Hall element.

In an embodiment, the plurality of magnetic sensors comprise a first horizontal Hall element (e.g. H1) arranged in the vicinity of a first pair of integrated magnetic concentrators (IMC) for measuring a first magnetic field component (e.g. By1) oriented in a first direction (e.g. Y) parallel to the semiconductor substrate, and a second horizontal Hall element (e.g. H2) arranged in the vicinity of a second pair of integrated magnetic concentrators (IMC) for measuring a second magnetic field component (Bx2) oriented in a second direction (e.g. X) parallel to the semiconductor substrate, perpendicular to the first direction.

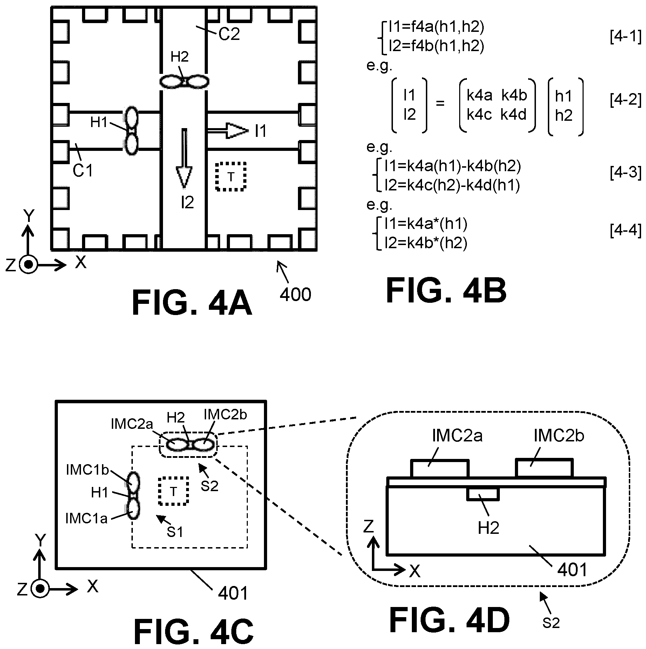

Examples of this embodiment are illustrated (inter alia) in FIG. 4, FIG. 13, FIG. 16, FIG. 26F, FIG. 27F, FIG. 34F, FIG. 35G, FIG. 36H.

In an embodiment, the plurality of magnetic sensors comprise a first horizontal Hall element (e.g. H1) arranged in the vicinity of a first pair of integrated magnetic concentrators (IMC) for measuring a first magnetic field component (e.g. By1) oriented in a first direction (e.g. Y) parallel to the semiconductor substrate, and a second horizontal Hall element (e.g. H2) arranged in the vicinity of a second pair of integrated magnetic concentrators (IMC) for measuring a second magnetic field component (e.g. Bx2) oriented in a second direction (e.g. X) perpendicular to the first direction, and a third horizontal Hall element (e.g. H3) arranged in the vicinity of a third pair of integrated magnetic concentrators (IMC) for measuring a third magnetic field component (e.g. By3 or Bx3) oriented in the first direction (e.g. Y) or oriented in the second direction (e.g. X), and a fourth horizontal Hall element (e.g. H4) arranged in the vicinity of a fourth pair of integrated magnetic concentrators (IMC) for measuring a fourth magnetic field component (e.g. Bx4 or By4) oriented in a second direction (e.g. X) or oriented in the first direction (e.g. Y).

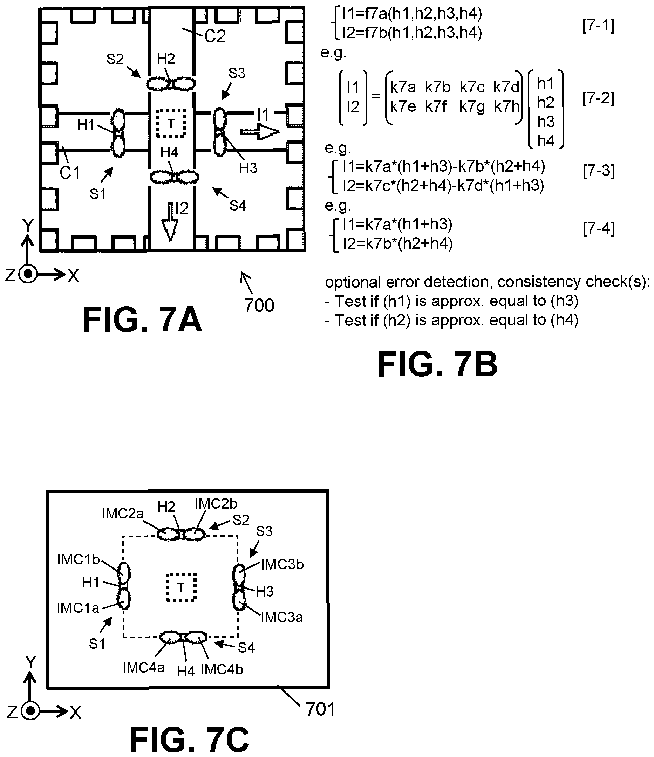

Examples of this embodiment are illustrated (inter alia) in FIG. 7, FIG. 8, FIG. 14.

In an embodiment, the plurality of magnetic sensors comprise a first horizontal Hall element (e.g. H1) arranged in the vicinity of a first pair of integrated magnetic concentrators (IMC) for measuring a first magnetic field component (e.g. By1) oriented in a first direction (e.g. Y) parallel to the semiconductor substrate, and a second horizontal Hall element (e.g. H2) arranged in the vicinity of a second pair of integrated magnetic concentrators (IMC) for measuring a second magnetic field component (e.g. By2) oriented in said first direction (e.g. Y), and a third horizontal Hall element (H3) arranged in the vicinity of a third pair of integrated magnetic concentrators (IMC) for measuring a third magnetic field component (e.g. By3) oriented in said first direction (e.g. Y).

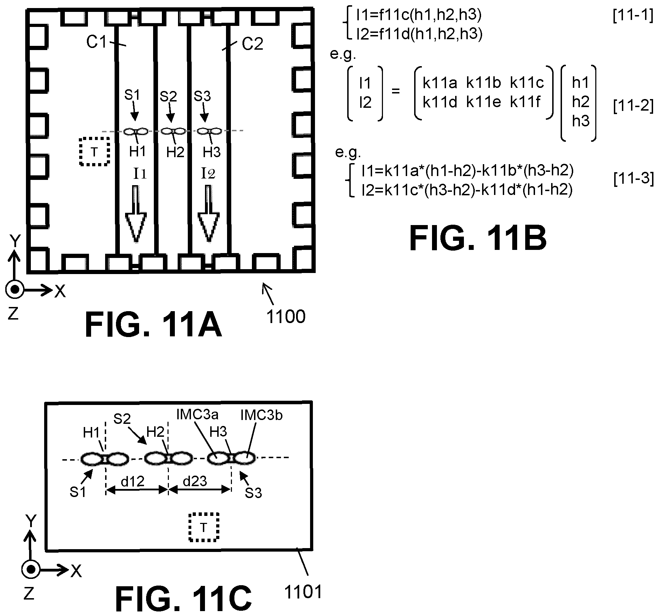

Examples of this embodiment are illustrated (inter alia) in FIG. 11, FIG. 25G

In an embodiment, the plurality of magnetic sensors comprise a first horizontal Hall element (e.g. H1) arranged in the vicinity of a first pair of integrated magnetic concentrators (IMC) for measuring a first magnetic field component (e.g. By1) oriented in a first direction (e.g. Y) parallel to the semiconductor substrate, and a second horizontal Hall element (e.g. H2) arranged in the vicinity of a second pair of integrated magnetic concentrators (IMC) for measuring a second magnetic field component (e.g. By2) also oriented in the first direction (e.g. Y).

Examples of this embodiment are illustrated (inter alia) in FIG. 18, FIG. 20, FIG. 24, FIG. 32G, FIG. 33F.

In an embodiment, the integrated current sensor device further comprises a non-volatile memory, e.g. for storing a plurality of scaling factors or coefficients or weight factors.

In an embodiment, the processing unit is configured for determining the first current (e.g. I1) as a first combination (e.g. linear combination or polygonal expression) of signals obtained from the magnetic sensors using a first set of coefficients; and for determining the second current (e.g. I2) as a second combination (e.g. linear combination or polygonal expression) of signals obtained from the magnetic sensors using a second set of coefficients.

The first set of coefficients and the second set of coefficients may be obtained by simulation or may be obtained by a calibration test, and may be stored in the non-volatile memory during the calibration test, and may be retrieved from the non-volatile memory during actual use of the device.

The first and/or second combination of signals may be a first linear combination, or a first polygonal combination of signals, e.g. a second order polynomial expression.

In an embodiment, the plurality of magnetic sensors comprises three magnetic sensors configured for measuring three parallel magnetic field components at three different locations, or wherein the plurality of magnetic sensors comprises four magnetic sensors configured for measuring four parallel magnetic field components at four different locations; and the processing unit is configured for determining a first pairwise difference (e.g. diff1) between a first pair of said magnetic field components, and for determining a second pairwise difference (e.g. diff2) between a second pair of said magnetic field components, different from the first pair; and the processing unit is configured for determining the first current (e.g. I1) as function of (e.g. a linear function of, or as a value proportional to) the first pairwise difference (e.g. diff1) and the second current (e.g. I2) as a function of (e.g. a linear function of, or as a value proportional to) the second pairwise difference (e.g. diff2), or for determining the first current e.g. (e.g. I1) as a first function or a first combination (e.g. linear combination) of the first and second pairwise difference and the second current (e.g. I2) as a second function or a second combination (e.g. linear combination) of the first and second pairwise difference.

It is noted that, in case of only three sensors, one of the sensor signals may be used in both the first pairwise difference and the second pairwise difference.

The three or four different locations may be located on a single virtual line, on a virtual letter T, at the corners of a virtual parallellogram, at the corners of a virtual rectangle, at the corners of a virtual square, at the corners of a virtual diamond.

In an embodiment, the processing unit is configured for determining a first pairwise difference (diff1) and a first pairwise sum (e.g. sum1) of a first pair of said magnetic field components, and a second pairwise difference (e.g. diff2) and a second pairwise sum (e.g. sum2) of a second pair of said magnetic field components, different from the first pair; and for determining the first current (e.g. I1) as a linear combination of the first pairwise difference (e.g. diff1) and the first pairwise sum (e.g. sum1), and for determining the second current (e.g. I2) as a linear combination of the second pairwise difference (e.g. diff2) and the second pairwise sum (e.g. sum2), using predefined coefficients which can be determined during a calibration procedure.

An example of this embodiment is illustrated by eq. [1-5] of FIG. 1B. The values of the coefficients may be determined during a calibration test, and may be stored in a non-volatile memory.

It is a major advantage of this embodiment that the sensitivities of the magnetic sensors not need to be matched to each other, although they may.

According to a second aspect, the present invention also provides a current sensor system comprising: an integrated current sensor device according to the first aspect; a first conductor portion (C1) for conducting a first current (11) to be measured; a second conductor portion (C2) for conducting a second current (12) to be measured; wherein at least one or both of the first conductor portion (C1) and the second conductor portion (C2) is located outside of the integrated current sensor device.

In an embodiment, one or both of the first and second conductor portion is/are situated outside of the packaged semiconductor device, e.g. underneath or above the packaged device, e.g. as one or more tracks of a printed circuit board (PCB), or as a clips or bridge mounted over the packaged device.

According to a third aspect, the present invention also provides a power inverter comprising a current sensor device according to the first aspect, or a current sensor system according to the second aspect.

Particular and preferred aspects of the present invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

It is noted that different sets of formulas may use the same notations for coefficients having different values. (to avoid long subscripts).
**FIG. 1A to FIG. 40** show illustrative examples of integrated current sensor devices proposed by the present invention, for measuring two independent currents flowing through two conductor portions, one or both of which may be incorporated in the current sensor device, and show illustrative examples of semiconductor substrates with magnetic sensors that can be used in such devices, and show sets of formulas for determining a first current and a second current.
**FIG. 1A to FIG. 1D** show an illustrative example with two crossing conductors and three horizontal Hall elements. FIG. 1A to FIG. 1D may be jointly referred to as **FIG. 1****.**
**FIG. 2A to FIG. 2C** show an illustrative example with two crossing conductors and four horizontal Hall elements. FIG. 2A to FIG. 2C may be jointly referred to as **FIG. 2****.**
**FIG. 3A** to **FIG. 3C** show an illustrative example with two crossing conductors and two vertical Hall elements. FIG. 3A to FIG. 3C may be jointly referred to as **FIG. 3****.**
**FIG. 4A** to **FIG. 4D** shows an illustrative example with two crossing conductors and two magnetic sensors, each comprising a horizontal Hall element and a pair of integrated magnetic concentrators. FIG. 4A to FIG. 4D may be jointly referred to as **FIG. 4****.**
**FIG. 5A to FIG. 5C** show an illustrative example with two crossing conductors and four vertical Hall elements. FIG. 5A to FIG. 5C may be jointly referred to as **FIG. 5****.**
**FIG. 6A** to **FIG. 6E** show another illustrative examples with two crossing conductors and four vertical Hall elements. FIG. 6A to FIG. 6E may be jointly referred to as **FIG. 6****.**
**FIG. 7A** to **FIG. 7C** show an illustrative example with two crossing conductors and four magnetic sensors, each comprising a horizontal Hall element and a pair of integrated magnetic concentrators. FIG. 7A to FIG. 7C may be jointly referred to as **FIG. 7****.**
**FIG. 8A** to **FIG. 8C** show another illustrative example with two crossing conductors and four magnetic sensors, each comprising a horizontal Hall element and a pair of integrated magnetic concentrators. FIG. 8A to FIG. 8C may be jointly referred to as **FIG. 8****.**
**FIG. 9A** to FIG. 9C show an illustrative example with two parallel conductors and three horizontal Hall elements. FIG. 9A to FIG. 9C may be jointly referred to as **FIG. 9****.**
**FIG. 10A** to FIG. 10C show an illustrative example with two parallel conductors and three vertical Hall elements. FIG. 10A to FIG. 10C may be jointly referred to as **FIG. 10**.
**FIG. 11A** to FIG. 11C show an illustrative example with two parallel conductors and three magnetic sensors, each comprising a horizontal Hall element and a pair of integrated magnetic concentrators. FIG. 11A to FIG. 11C may be jointly referred to as **FIG. 11****.**
**FIG. 12A** to FIG. 12F show an illustrative example with two overall parallel conductors, one conductor having two cut-outs forming a zigzag, and four horizontal Hall elements. FIG. 12A to FIG. 12F may be jointly referred to as **FIG. 12****.**
**FIG. 13A** to **FIG. 13F** show illustrative examples with two overall parallel conductors, one conductor having two cut-outs forming a zigzag, and two vertical Hall elements or two magnetic sensors, each having a horizontal Hall element and two integrated magnetic concentrators. FIG. 13A to FIG. 13F may be jointly referred to as **FIG. 13****.**
**FIG. 14A** to **FIG. 14F** show illustrative examples with two overall parallel conductors, one conductor having two cut-outs forming a zigzag, and four vertical Hall elements or four magnetic sensors, each having a horizontal Hall element and two integrated magnetic concentrators. FIG. 14A to FIG. 14F may be jointly referred to as **FIG. 14****.**
**FIG. 15A** to **FIG. 15D** show an illustrative example with two overall parallel conductors, each conductor having two cut-outs forming a zigzag, and four horizontal Hall elements. FIG. 15A to FIG. 15D may be jointly referred to as **FIG. 15****.**
**FIG. 16A** to **FIG. 16F** show illustrative examples with two overall parallel conductors, each conductor having two cut-outs forming a zigzag, and two vertical Hall elements, or two magnetic sensors, each comprising a horizontal Hall element and two integrated magnetic concentrators. FIG. 16A to FIG. 16F may be jointly referred to as **FIG. 16****.**
**FIG. 17A** to **FIG. 17D** show an illustrative example with two overall parallel conductors, each conductor having two cut-outs forming a zigzag, and four horizontal Hall elements. FIG. 17A to FIG. 17D may be jointly referred to as **FIG. 17****.**
**FIG. 18A** to **FIG. 18F** show illustrative examples with two overall parallel conductors, each conductor having two cut-outs forming a zigzag, and two vertical Hall elements, or two magnetic sensors, each comprising a horizontal Hall element and two integrated magnetic concentrators. FIG. 18A to FIG. 18F may be jointly referred to as **FIG. 18****.**
**FIG. 19A** to **FIG. 19F** show an illustrative example with two overall parallel conductors, each conductor having two cut-outs forming a zigzag, and four horizontal Hall elements. FIG. 19A to FIG. 19F may be jointly referred to as **FIG. 19****.**
**FIG. 20A** to **FIG. 20F** show illustrative examples with two overall parallel conductors, each conductor having two cut-outs forming a zigzag, and two vertical Hall elements, or two magnetic sensors, each comprising a horizontal Hall element and two integrated magnetic concentrators. FIG. 20A to FIG. 20F may be jointly referred to as **FIG. 20****.**
**FIG. 21A** to **FIG. 21E** show illustrative examples of integrated current sensor devices having two electrical conductors extending in a same direction, with or without a zigzag, as may be used in embodiments of the present invention.
**FIG. 22A** to **FIG. 22F** show illustrative examples with two U-shaped conductors and four horizontal Hall elements. FIG. 22A to FIG. 22F may be jointly referred to as **FIG. 22****.**
**FIG. 23A** to **FIG. 23E** show illustrative examples with two U-shaped conductors and three horizontal Hall elements. FIG. 23A to FIG. 23E may be jointly referred to as **FIG. 23****.**
**FIG. 24A** to **FIG. 24H** show illustrative examples with two U-shaped conductors and two vertical Hall elements, or two magnetic sensors each comprising a horizontal Hall element and two integrated magnetic concentrators. FIG. 24A to FIG. 24H may be jointly referred to as **FIG. 24****.**
**FIG. 25A** to **FIG. 25H** show illustrative examples with two U-shaped conductors and three vertical Hall elements, or three magnetic sensors each comprising a horizontal Hall element and two integrated magnetic concentrators. FIG. 25A to FIG. 25H may be jointly referred to as **FIG. 25****.**
**FIG. 26A** to **FIG. 26G** show illustrative examples with two U-shaped conductors and two vertical Hall elements, or two magnetic sensors each comprising a horizontal Hall element and two integrated magnetic concentrators. FIG. 26A to FIG. 26G may be jointly referred to as **FIG. 26****.**
**FIG. 27A** to **FIG. 27G** show illustrative examples with two U-shaped conductors and two vertical Hall elements, or two magnetic sensors each comprising a horizontal Hall element and two integrated magnetic concentrators. FIG. 27A to FIG. 27G may be jointly referred to as **FIG. 27****.**
**FIG. 28A** to **FIG. 28F** show illustrative examples with two U-shaped conductors and four horizontal Hall elements. FIG. 28A to FIG. 28F may be jointly referred to as **FIG. 28****.**
**FIG. 29A** to **FIG. 29C** show another illustrative example with two U-shaped conductors and four horizontal Hall elements. FIG. 29A to FIG. 29C may be jointly referred to as **FIG. 29****.**
**FIG. 30A** to **FIG. 30E** show illustrative examples with two U-shaped conductors and three horizontal Hall elements. FIG. 30A to FIG. 30E may be jointly referred to as **FIG. 30****.**
**FIG. 31A** to **FIG. 31F** show illustrative examples with two U-shaped conductors and three horizontal Hall elements. FIG. 31A to FIG. 31F may be jointly referred to as **FIG. 31****.**
**FIG. 32A** to **FIG. 32H** show illustrative examples with two U-shaped conductors and two vertical Hall elements, or two magnetic sensors each comprising a horizontal Hall element and two integrated magnetic concentrators. FIG. 32A to FIG. 32H may be jointly referred to as **FIG. 32****.**
**FIG. 33A** to **FIG. 33G** show illustrative examples with two U-shaped conductors and two vertical Hall elements, or two magnetic sensors each comprising a horizontal Hall element and two integrated magnetic concentrators. FIG. 33A to FIG. 33G may be jointly referred to as **FIG. 33****.**
**FIG. 34A** to **FIG. 34G** show illustrative examples with two U-shaped conductors and two vertical Hall elements, or two magnetic sensors each comprising a horizontal Hall element and two integrated magnetic concentrators. FIG. 34A to FIG. 34G may be jointly referred to as **FIG. 34****.**
**FIG. 35A** to **FIG. 35H** show illustrative examples with two U-shaped conductors and two vertical Hall elements, or two magnetic sensors each comprising a horizontal Hall element and two integrated magnetic concentrators. FIG. 35A to FIG. 35H may be jointly referred to as **FIG. 35****.**
**FIG. 36A** to **FIG. 36I** show illustrative examples with one internal conductor and one external conductor and four horizontal Hall elements, or two vertical Hall elements, or two sensors each having a horizontal Hall element and two integrated magnetic concentrators. The internal conductor has a U-shape. The external conductor has a linear shape. The conductors overlap each other.
**FIG. 37A** and **FIG. 37B** show a variant of FIG. 38A and FIG. 38C, wherein the external conductor is routed over the packaged device, e.g. by means of a conductive clip.
**FIG. 38A** and **FIG. 38B** show a variant of FIG. 1A, with one internal conductor crossing an external conductor, and with three horizontal Hall elements.
**FIG. 39A** and **FIG. 39B** show a variant of FIG. 2A, with one internal conductor crossing an external conductor, and with four horizontal Hall elements.
**FIG. 40** show another variant of FIG. 1A, with two external conductor crossing each other, and with four horizontal Hall elements.
**FIG. 41** shows a schematic block-diagram of a current sensor device according to embodiments of the present invention.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. **In** other instances, well-known methods, structures and techniques have not been shown in detail in order not to obscure an understanding of this description.

In this document, unless explicitly mentioned otherwise, the term "magnetic sensor device" or "sensor device" refers to a device comprising at least two "magnetic sensor" or at least two magnetic "sensor elements", preferably integrated in a semiconductor substrate. The semiconductor substrate may be at least partially overmolded by a plastic or ceramic molding compound. The sensor device may be comprised in a package with electrical contacts (e.g. pads or pins), also called "chip".

In this document, the term "sensor element" or "magnetic sensor element" or "magnetic sensor" can refer to a component or a group of components or a sub-circuit or a structure capable of measuring a magnetic quantity, such as for example a magneto-resistive (MR) element, a GMR element, an XMR element, a horizontal Hall plate, a vertical Hall plate, a Wheatstone-bridge containing at least one (but preferably four) magneto-resistive elements, etc. or combinations hereof.

In embodiments of the present invention, the term "magnetic sensor" or "magnetic sensor structure" may refer to an arrangement comprising one or two integrated magnetic concentrators (IMC), also known as integrated flux concentrators, and one or more horizontal Hall elements arranged near a periphery of the IMC.

In particular embodiments of the present invention, a magnetic sensor is used that comprises a pair of two elongated (e.g. elliptical shaped, or drop-shaped) IMC, spaced apart from each other by a distance larger than 50 micron but smaller than 250 micron, and one horizontal Hall element situated near an edge of one of these magnetic concentrators.

In this document, the expression "1D magnetic pixel" typically refers to a magnetic sensor element capable of measuring only one magnetic field component.

In this document, the expression "2D magnetic pixel" typically refers to a magnetic sensor structure capable of measuring only two orthogonal magnetic field components.

In this document, the expression "3D magnetic pixel" typically refers to a magnetic sensor structure capable of measuring three orthogonal magnetic field components.

In this document, the expression "in-plane component of a magnetic field vector" and "projection of the magnetic field vector in the sensor plane" mean the same. If the sensor device is or comprises a semiconductor substrate, this also means "magnetic field components parallel to the semiconductor plane". In this document, in-plane components are typically labelled Bx or By.

In this document, the expression "out-of-plane component of a vector" and "Z component of the vector" and "projection of the vector on an axis perpendicular to the sensor plane" mean the same. In this document, out-of-plane components are typically labelled Bz.

Embodiments of the present invention are typically described using an orthogonal coordinate system which is fixed to the sensor device or to a substrate comprising a group of sensors, and having three axes X, Y, Z, where the X and Y axis are parallel to the substrate, and the Z-axis is perpendicular to the substrate.

In this document, horizontal Hall plates are typically referred to by H1, H2, etc., and signals obtained from horizontal Hall plates are referred to as h1, h2, etc.

In this document, vertical Hall plates are typically referred to by V1, V2, etc., and signals obtained from vertical Hall plates are referred to as v1, v2, etc.

In this document, IMC means "integrated magnetic concentrator".

In this document, ADC means "analog to digital convertor".

In this document, DSP means "digital signal processor" or "digital processing circuit". This may comprise a programmable processor.

In this document "NV-memory" means "non-volatile memory", e.g. flash memory.

The expression "a vertical Hall element oriented in the X-direction" is a shortcut for saying "a vertical Hall element with an axis of maximum sensitivity oriented in the X-direction".

The abbreviation PCB stands for Printed Circuit Board.

The abbreviation IC stands for "integrated circuit". In the context of the present invention, an integrated circuit can mean a "semiconductor substrate" (e.g. a CMOS substrate), optionally at least partially surrounded by a moulding compound to form a so called "chip".

In this document, the expression "conductors" and "conductor portions" mean the same, and typically refer to the internal conductors C1 and C2 when situated inside the packaged device, or to a portion of the conductor defined by the size of the packaged device, when situated outside of the packaged device, unless explicitly mentioned otherwise.

In this document the expression "substantially equal to" means "equal to within a predefined tolerance margin".

In this document, the symbol "≈" means "is approximately equal to" within a tolerance margin of ±20%, or ±10%, unless another tolerance margin is specified.

In this document, the statement "the sensor elements are arranged above or below the conductors" means in fact that an orthogonal projection on the semiconductor substrate (i.e. in the Z-direction) of the sensor elements overlap at least partially with an orthogonal projection of the current conductors.

In this document, the statement "the sensor elements are arranged next to the conductors" means in fact that an orthogonal projection on the semiconductor substrate (i.e. in the Z-direction) of the sensor elements does not overlap with an orthogonal projection of the current conductors.

In this document, the statement "The black arrows show the directions of the currents which are measured by the magnetic sensors" actually means: "The black arrows show the local current directions that cause, or contribute strongly to the magnetic field which is measured by the magnetic sensors".

The present invention relates to current sensor devices and current sensor systems, and more in particular to current sensor devices and systems capable of measuring two currents flowing through two conductors using magnetic sensors.

In embodiments of the present invention, the magnetic sensors are incorporated in a packaged semiconductor device, also known as "an integrated circuit" or "chip", comprising at least one semiconductor substrate which is at least partially overmolded by a plastic or ceramic moulding compound.

In embodiments of the present invention, the magnetic sensors are arranged in the vicinity of electrical conductor portions carrying the currents to be measured. One or both of these electrical conductor portions may also be integrated in the packaged device, or may be external to the packaged device.

In many embodiments of the present invention, two conductor portions are integrated in the packaged device, and these conductor portions have particular geometrical features, and the magnetic sensors are arranged in a particular manner, for reducing cross-talk between the conductors in a passive manner.

In most embodiments of the present invention, magnetic field components are measured in at least two different locations, e.g. comprising two locations spaced apart by at least 0.50 mm, or at least 0.75 mm, or at least 1.10 mm, or at least 1.25 mm, or at least 1.60 mm.

For most embodiments of the present invention, multiple sets of mathematical formulas are provided for determining the two currents, based on the signals obtained from the magnetic sensor elements. In some embodiments of the present invention, mathematical formulas are provided which are based (or solely based) on pairwise magnetic field differences, which is beneficial for rejection of unwanted disturbance fields.

Some embodiments use Horizontal Hall elements without integrated magnetic concentrators (IMC) or vertical Hall elements. It is an advantage of such embodiments that no extra processing steps are required for applying the IMC to the device.

Some embodiments use Horizontal Hall elements with integrated magnetic concentrators (IMC). It is an advantage of such embodiments that a magnetic field component parallel to the semiconductor substrate can be measured using only a single horizontal Hall element.

It is an advantage of most embodiments that only one type of magnetic sensor is used.

It is an advantage of most embodiments that the current sensor device comprises only two, or only three, or only four 1D magnetic sensors, preferably spaced apart from each other by at least 300 micron, or at least 400 micron, or at least 500 micron.

These are the main underlying principles of the present invention.

Referring now to the figures.

**FIG. 1A** shows an illustrative example of an integrated current sensor device 100 that comprises two electrical conductors C1, C2 that cross each other perpendicularly without making electrical contact.

In the example shown, C1 extends in the X-direction, from one side of the package to an opposite side, and C2 extends in the Y-direction from one side of the package to an opposite side. A suitable isolation may be provided between the conductors. The current sensor device 100 further comprises a semiconductor substrate (not shown in FIG. 1A but see FIG. 1D), that comprises three horizontal Hall elements H1, H2, H3, and optionally also a temperature sensor T. The three horizontal Hall elements H1, H2, H3 are configured to measure three magnetic field components Bz1, Bz2, Bz3 oriented in the Z-direction, at three different sensor locations. H1 and H2 are preferably arranged near opposite edges of conductor C2. H1 and H3 are preferably arranged near opposite edges of conductor C1. The three magnetic sensors H1, H2, H3 are preferably arranged relatively close together, such that the size of the semiconductor substrate 101, e.g. illustrated in FIG. 1D, can be small.

The semiconductor substrate 101 may be arranged above the two conductors C1, C2, or in a plane between the two conductors C1, C2.

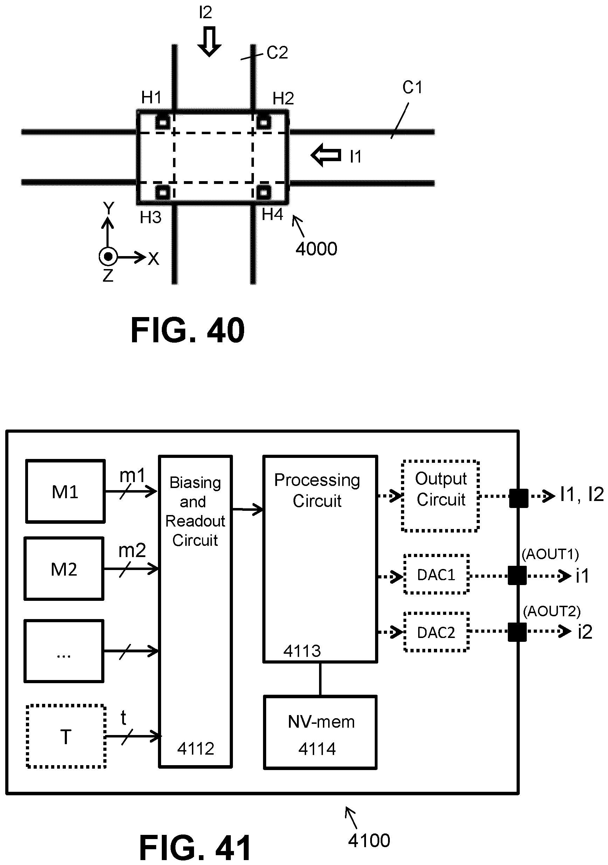

The current sensor device 100 further comprises a processing circuit (not explicitly shown in FIG. 1A to FIG. 1D, but see e.g. FIG. 41).

It is an advantage of this arrangement that two magnetic field differences along two perpendicular directions can be determined using only three horizontal Hall elements H1 to H3.

It is an advantage of this embodiment, that the cross-talk from C1 to C2 and vice versa is strongly reduced in a passive manner, by orienting the two conductor portions C1 and C2 perpendicular to each other, and by arranging the horizontal Hall elements at, or in the vicinity of the corners of a virtual rectangle, such that the sensors H1 and H2 are arranged symmetrically with respect to C2, and such that the sensors H3 and H1 are arranged symmetrically with respect to C1. Preferably an orthogonal projection (in the Z-direction) of the Hall elements H1 to H3 on the semiconductor substrate, do not overlap an orthogonal projection of the conductors C1 and C2.

**FIG. 1B** shows various sets of formulas that can be used to determine a first current I1 flowing through the first conductor portion C1, and a second current I2 flowing through the second conductor portion C2, based on the signals h1, h2, h3 obtained from the magnetic sensors of FIG. 1A.

The set of formulas [1-1] states that each of I1 and I2 can be determined as a function of the signals h1, h2, h3, and optionally also of the temperature T, e.g. by correcting the magnetic sensitivities of the Hall elements as a function of temperature.

The set of formulas [1-2] states that each of I1 and I2 can be calculated as a linear combination of the signals h1, h2, h3, using six coefficients k1a to k1f. Set [1-2] is written as a matrix multiplication. These coefficients can be determined during a calibration procedure or by simulation, and may be stored in a non-volatile memory of the current sensor device, (not shown in FIG. 1A, but see e.g. FIG. 41). It is an advantage of this set of formulas that it can be easily implemented in a programmable processor using simple instructions. This is also true for the sets [1-3] to [1-5].

The set of formulas [1-3] is more specific, and states that each of the currents I1 and I2 can be written as a linear combination of two pairwise difference signals, namely of a first difference (h3-h1) which may be referred to as "diff1", and of a second difference (h2-h1) which may be referred to as "diff2". It is a major advantage of the set [1-3] that it provides values for I1 and I2 which are highly independent of an external disturbance field, and further reduces any cross-talk between C1 and C2 by means of calculations.

The set of formulas [1-4] determine the currents I1, I2 based on pairwise differences. The set [1-4] is a simpler version of the set [1-3], and does not explicitly reduce cross-talk from the other conductor, but provides values for I1 and I2 which are highly independent of an external disturbance field. As can be seen, the set [1-4] requires only two coefficients, two subtractions and two multiplications.

The set of formulas [1-5] determine the currents I1, I2 using pairwise differences and pairwise sums. The set [1-5] can be seen as a variant of the set [1-4], and requires a few more calculations, but this set can be used to provide accurate values of I1 and I2, even if the horizontal Hall elements have magnetic sensitivities that are not matched to one another. In other words, when using the set of formulas [1-5], the magnetic sensitivities of H1 to H3 do not need to be matched, meaning for example that the production process of the semiconductor substrate 101 can be simplified, since no laser trimming is required. In addition, the implementation of the biasing circuitry can be simplified, since no adjustable biasing sources are required, which may moreover reduce the size of the semiconductor substrate. The coefficients k1a to k1d of the set [1-5] are predefined constants, which may be determined during a calibration test, e.g. by measuring the signals h1 to h3 in three tests, including a first test wherein I1= a known current Ical, and I2=0, and applied external magnetic field =0, and assuming k1bb is 0, allowing k1aa to be calculated from the first equation; and a second test wherein I2= a known current Ical, and I1=0, and applied external magnetic field =0, and assuming k1dd is 0, allowing k1cc to be calculated from the second equation; and a third test wherein I1=0 and I2=0 and a known non-zero magnetic field Bz is applied, yielding two equations from which k1bb and k1dd can be determined. It is an important advantage of this embodiment that the currents can be accurately determined, even in the presence of a relatively large external disturbance field, and without having to match the sensitivities of the Hall elements. This can save production time and can simplify the circuit design and testing time (in particular of the biasing circuitry).

Of course, the current sensor device 100 only needs to implement one of these sets of formulas.

**FIG. 1C** shows the relative position of the conductors and the package of FIG. 1A. It is an advantage of the crossing conductor portions C1, C2 oriented in perpendicular directions, that the first and the second current I1, I2 also flow in perpendicular directions, without having to orient the bus bars themselves in perpendicular directions. In the example shown, the package is a QFN package, but of course, other square or rectangular packages having contacts at four sides thereof, can also be used. In the example shown, the conductor C1 is connected at both ends E1, E2 to two contacts, and the conductor C2 is connected at both ends E3, E4 to two contacts, but the present invention is not limited thereto, and more or fewer contacts may be used to connect the ends E1 to E4 of the connectors C1, C2. The other contacts may be connected to the semiconductor substrate 101 in known manners, e.g. using bond wires (not shown in FIG. 1C, but see e.g. FIG. 12E or FIG. 12F), e.g. to provide supply voltages, and/or for readout of the results.

**FIG. 1D** shows an illustrative example of a semiconductor substrate 101 comprising three horizontal Hall elements, as can be used in the current sensor device 100 of FIG. 1A. As mentioned above, H1 to H3 are preferably located at the corners of a virtual rectangle. The length and the width of this virtual rectangle are preferably at least equal to the widths W1, W2 of C1, C2, such that the Hall elements H1 to H3 will be situated exactly above the edges of the conductors C1, C2, but are preferably slightly larger than W1 and W2 such that the elements H1 to H3 are situated at a small distance from said edges (e.g. as illustrated in FIG. 1A).

FIG. 1A to FIG. 1D may be jointly referred to as **FIG. 1****.** In the example shown, C1 and C2 have a same length and a same width, but that is not absolutely required. Also, in the example shown, C1 and C2 have a constant width, and that is not required either. For example, C1 and C2 may be narrowed near the area where they overlap. This offers the advantage that the current density increases, hence the signal-to-noise ratio SNR increases, and also that the magnetic sensors H1 to H4 may be positioned closer to each other.

In a variant of FIG. 1A (e.g. as illustrated in FIG. 38A), one of the conductor portions C1 is situated inside the packaged device, and the other conductor portion C2 is located outside of the packaged device, e.g. implemented as copper tracks of a multi-layer printed circuit board.

In yet another variant of FIG. 1A, e.g. as illustrated in FIG. 40, both conductor portions C1 and C2 are situated outside of the packaged device 4000.

**FIG. 2A** shows an illustrative example of an integrated current sensor device 200 that comprises: two electrical conductors C1, C2 that cross each other, and four horizontal Hall elements H1 to H4.

The current sensor device 200 can be seen as a variant of the current sensor device 100, the main difference being (1) that the device 200 has four horizontal Hall elements H1 to H4 instead of only three, and that (2) the two currents I1 to I4 may be calculated using two to eight coefficients, and that (3) the fourth sensor H4 allows redundancy, and (4) the fourth sensor signal h4 can be used to improve the accuracy (e.g. by adding signals to achieve a higher signal-to-noise ratio, see e.g. set [2-3] and [2-4].

For example, an error can be detected by testing if (h1-h3) is approximately equal to (h2-h4) within a predefined tolerance margin, and/or by testing if (h2-h1) is approximately equal to (h4-h3) within a predefined tolerance margin.

**FIG. 2B** shows formulas to determine a first and a second current based on the signals obtained from some or all of the magnetic sensors of FIG. 2A.

The set [2-2] uses eight coefficients; the sets [2-3], [2-5], [2-7] use four coefficients; the sets [2-4], [2-6] use only two coefficients. As mentioned above, these coefficients can be determined by simulation or by a calibration test, and may be written in a non-volatile memory of the current sensor device.

The sets [2-5] and [2-6] determine the currents I1, I2 based on pairwise differences. The currents thus calculated have a reduced sensitivity to an external disturbance field.

The set [2-7] determines the currents I1, I2 using pairwise differences and pairwise sums. As described above, this set provides accurate results for the currents even if the magnetic sensitivities of the Hall elements are not perfectly matched to each other.

**FIG. 2C** shows an illustrative example of a semiconductor substrate 201 comprising four horizontal Hall elements H1 to H4, as can be used in the current sensor device 200 of FIG. 2A.

FIG. 2A to FIG. 2C may be jointly referred to as **FIG. 2****.**

In a variant (not shown) of FIG. 2, one or both of the conductors C1, C2 may be located outside the packaged device 200.

**FIG. 3A** shows an illustrative example of an integrated current sensor device 300 that comprises two electrical conductor portions C1, C2 that cross each other, and two vertical Hall elements V1, V2.

FIG. 3A can be seen as a variant of FIG. 1A or as a variant of FIG. 2A, the most important difference being that the current sensor device 300 comprises two vertical Hall elements V1, V2 instead of three or four horizontal Hall elements. V1, V2 provide signals v1, v2 respectively. V1 is configured to measure a magnetic field component By1 oriented in the Y-direction, parallel to the substrate, at a first location above the first conductor C1, e.g. at a location where By1 is maximal. V2 is configured to measure magnetic field component Bx2 oriented in the X-direction, at a second location above the second conductor C2, e.g. at a location where Bx2 is maximal. Thus, V1 and V2 are oriented in perpendicular directions, and cross-talk between C1 and C2 is minimal.

**FIG. 3B** shows formulas to determine a first and a second current I1, I2 based on signals obtained from the magnetic sensors of FIG. 3A.

**FIG. 3C** shows an illustrative example of a semiconductor substrate 301 comprising two vertical Hall elements, as can be used in the current sensor device 300 of FIG. 3A. It is an advantage of this embodiment that V1 and V2 can be located very close together, e.g. at a distance smaller than the width of the conductors C1, C2, thus the semiconductor substrate 301 can be very small.

Everything else mentioned above is also applicable here, mutatis mutandis, for example, the sensor device 301 may further comprise a temperature sensor for measuring a temperature of the substrate 301, which can be used e.g. for temperature compensation of the sensitivities of the vertical Hall elements.

FIG. 3A to FIG. 3C may be jointly referred to as **FIG. 3****.**

In a variant (not shown) of FIG. 3, one or both of the conductors C1, C2 may be located outside the packaged device 300.

**FIG. 4A** shows an illustrative example of an integrated current sensor device 400 that comprises two electrical conductor portions C1, C2 that cross each other, and two magnetic sensors S1, S2, each comprising a horizontal Hall element and a pair of integrated magnetic concentrators.

FIG. 4A can be seen as a variant of FIG. 3A, the most important difference being that the current sensor device 400 comprises two horizontal Hall elements H1, H2 with integrated magnetic concentrators instead of two vertical Hall elements V1, V2. The sensor element H1 provides a signal h1 indicative of a magnetic field component By1 oriented in the Y-direction measured at a first sensor location above C2. The sensor element H2 provides a signal h2 indicative of a magnetic field component Bx2 oriented in the X-direction measured at a second sensor location above C1. Since the conductors are oriented perpendicularly, and since the sensors are oriented perpendicularly, accurate current measurements can be provided, with (ideally) minimal cross-talk.

**FIG. 4B** shows formulas to determine a first and a second current based on signals obtained from the magnetic sensors of FIG. 4A.

The set of formulas [4-3] can be used to actively reduce cross-talk between C1 and C2, if desired.

The set of formulas [4-4] can be used in case the cross-talk between C1 and C2 is found to be negligible in practice, despite production tolerances.

**FIG. 4C** shows an illustrative example of a semiconductor substrate 401 comprising two magnetic sensors S1, S2, each comprising a horizontal Hall element and a pair of integrated magnetic concentrators, as can be used in the current sensor device 400 of FIG. 4A. More specifically, sensor S1 has a horizontal Hall element H1 and two integrated magnetic concentrators IMC1a, IMC1b spaced apart in the Y-direction, and sensor S2 has a horizontal Hall element H2 and two integrated magnetic concentrators IMC2a, IMC2b spaced apart in the X-direction.

**FIG. 4D** shows an enlarged view of a cross-section of the magnetic sensor S2 in a plane perpendicular to the semiconductor substrate 401. As can be seen, it comprises a horizontal Hall element H2, e.g. implemented in the active surface of the semiconductor substrate, and two integrated magnetic concentrators IMC2a, IMC2b, spaced apart in the X-direction, and having a suitable shape, e.g. an elliptical shape or a droplet-shape (seen from above, see FIG. 4C).

FIG. 4A to FIG. 4C may be jointly referred to as **FIG. 4****.**

In a variant (not shown) of FIG. 4, one or both of the conductors C1, C2 may be located outside the packaged device 4001.

**FIG. 5A** shows an illustrative example of an integrated current sensor device 500 that comprises two electrical conductor portions C1, C2 that cross each other, and four vertical Hall elements V1 to V4.

FIG. 5A can be seen as a variant of FIG. 4A, the most important difference being that the current sensor device 500 comprises four vertical Hall elements instead of only two. V1 to V4 provide signals v1 to v4 respectively. In the example shown, V1 is configured to measure magnetic field component By1 oriented in the Y-direction at a first sensor location above the first conductor C1. V2 is configured to measure magnetic field component Bx2 oriented in the X-direction at a second sensor location above the second conductor C2. V3 is configured to measure magnetic field component By3 oriented in the Y-direction at a third sensor location above the first conductor C1. V4 is configured to measure magnetic field component Bx4 oriented in the X-direction at a fourth sensor location above the second conductor C2. Ideally, V1 and V3 will provide a same signal (i.e. v1=v3), and V2 and V4 will provide a same signal (i.e. v2=v4). By summing v1 and v3, and v2 and v4, signals with an improved SNR can be achieved, and thus the accuracy of I1 and I2 can be improved.

**FIG. 5B** shows formulas to determine a first and a second current I1, I2 based on the signals v1 to v4 obtained from the magnetic sensors of FIG. 5A.

It is possible to detect an error, e.g. by testing if v1 is substantially equal to v3, and/or by testing if v2 is substantially equal to v4.

**FIG. 5C** shows an illustrative example of a semiconductor substrate 501 comprising four vertical Hall elements V1 to V4, as can be used in the current sensor device 500 of FIG. 5A.

FIG. 5A to FIG. 5C may be jointly referred to as **FIG. 5****.**

In a variant (not shown) of FIG. 5, one or both of the conductors C1, C2 may be located outside the packaged device 500.

**FIG. 6A** shows an illustrative example of an integrated current sensor device 600 that comprises two electrical conductor portions C1, C2 that cross each other, and four vertical Hall elements V1 to V4.

FIG. 6A can be seen as a variant of FIG. 5A, the most important difference being that V3 and V4 are rotatad by 90° about the Z-axis. V1 to V4 provide signals v1 to v4 respectively. In the example shown, V1 is configured to measure magnetic field component By1 oriented in the Y-direction at a first sensor location above the first conductor C1. V2 is configured to measure magnetic field component Bx2 oriented in the X-direction at a second sensor location above the second conductor C2. V3 is configured to measure magnetic field component Bx3 oriented in the X-direction at a third sensor location above the first conductor C1. V4 is configured to measure magnetic field component By4 oriented in the Y-direction at a fourth sensor location above the second conductor C2.

**FIG. 6B** shows formulas to determine a first and a second current I1, I2 based on signals obtained from the magnetic sensors of FIG. 6A.

The sets [6-3] and [6-4] allows to calculate I1 and I2 based on pairwise differences, hence are highly insensitive to an external disturbance field. The set [6-3] allows for active cross-talk reduction.

The set [6-5] can be used to provide accurate values of I1 and I2, even if the magnetic sensitivities of V1 to V4 are not matched to each other (as described above).

**FIG. 6C** to **FIG. 6E** show illustrative examples of semiconductor substrates 601, 602, 603, each comprising four vertical Hall elements V1 to V4, as can be used in the current sensor device of FIG. 6A.

As illustrated by these examples, V3 does not need to be located above C1, and V4 does not need to be located above C2.

FIG. 6A to FIG. 6E may be jointly referred to as **FIG. 6****.**

In a variant (not shown) of FIG. 6, one or both of the conductors C1, C2 may be located outside the packaged device 600.

**FIG. 7A** shows an illustrative example of an integrated current sensor device 700 that comprises two electrical conductor portions C1, C2 that cross each other, and four magnetic sensors s1 to s4, each comprising a horizontal Hall element and a pair of integrated magnetic concentrators.

FIG. 7A can be seen as a variant of FIG. 4A, having four sensors instead of only two. FIG. 7A can also be seen as a variant of FIG. 5A using a different type of sensors.

H1 to H4 provide signals h1 to h4 respectively. In the example shown, H1 is configured to measure magnetic field component By1 oriented in the Y-direction at a first sensor location above the first conductor C1. H2 is configured to measure magnetic field component Bx2 oriented in the X-direction at a second sensor location above the second conductor C2. H3 is configured to measure magnetic field component By3 oriented in the Y-direction at a third sensor location above the first conductor C1. H4 is configured to measure magnetic field component Bx4 oriented in the X-direction at a fourth sensor location above the second conductor C2.

Ideally, H1 and H3 will provide a same signal (i.e. h1=h3), and H2 and H4 will provide a same signal (i.e. h2=h4). By summing h1 and h3, and h2 and h4, signals with an improved SNR can be achieved, and thus the accuracy of I1 and I2 can be improved.

**FIG. 7B** shows formulas to determine a first and a second current based on signals obtained from the magnetic sensors of FIG. 7A.

It is possible to detect an error, e.g. by testing if h1 is substantially equal to h3, and/or by testing if h2 is substantially equal to h4.

**FIG. 7C** shows an illustrative example of a semiconductor substrate 701 comprising four magnetic sensors s1 to s4, each comprising a horizontal Hall element and a pair of integrated magnetic concentrators, as can be used in the current sensor device 700 of FIG. 7A.

FIG. 7A to FIG. 7C may be jointly referred to as **FIG. 7****.**

In a variant (not shown) of FIG. 7, one or both of the conductors C1, C2 may be located outside the packaged device 700.

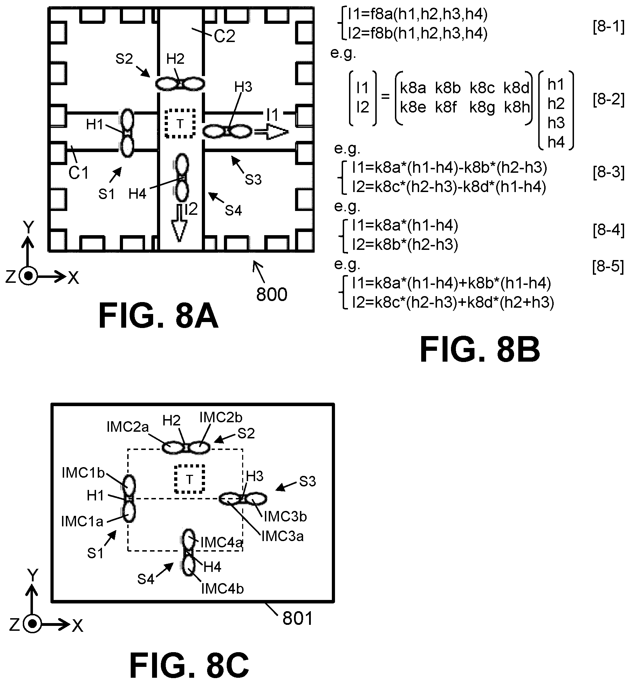

**FIG. 8A** shows an illustrative example of an integrated current sensor device 800 that comprises two electrical conductor portions C1, C2 that cross each other, and four magnetic sensors s1 to s4, each comprising a horizontal Hall element and a pair of integrated magnetic concentrators.

FIG. 8A can be seen as a variant of FIG. 6A, using a different type of magnetic sensors. H1 to H4 provide signals h1 to h4 respectively.

**FIG. 8B** shows formulas to determine a first and a second current based on signals obtained from the magnetic sensors of FIG. 8A.

The sets [8-3] and [8-4] allows to calculate I1 and I2 based on pairwise differences, hence are highly insensitive to an external disturbance field. The set [8-3] allows for active cross-talk reduction.

The set [8-5] can be used to provide accurate values of I1 and I2, even if the magnetic sensitivities of H1 to H4 are not matched to each other (as described above).

**FIG. 8C** shows an illustrative example of a semiconductor substrate 801 comprising four magnetic sensors s1 to s4, each comprising a horizontal Hall element and a pair of integrated magnetic concentrators, as can be used in the current sensor device 800 of FIG. 8A.

As explained in FIG. 6C to FIG. 6E, s3 does not need to be located above C1, and s4 does not need to be located above C2.

FIG. 8A to FIG. 8C may be jointly referred to as **FIG. 8****.**

In a variant (not shown) of FIG. 8, one or both of the conductors C1, C2 may be located outside the packaged device 800.

**FIG. 9A** shows an illustrative example of an integrated current sensor device 900 that comprises two parallel electrical conductors C1, C2, and three horizontal Hall elements H1 to H3.

In the example of FIG. 9A, the two conductors C1, C2 extend parallel to each other in the Y-direction, and they are preferably located in a plane parallel to the semiconductor substrate 901 that contains the magnetic sensors H1 to H3. The semiconductor substrate is not explicitly shown in FIG. 9A, but see e.g. FIG. 9C. The two parallel conductors C1, C2 are preferably co-planar. A distance between the two conductors may be smaller than 5.0 mm, or smaller than 4.0 mm, or smaller than 3.0 mm, which is contrary to the prior art because such a short distance will inevitably cause serious cross-talk.

The three horizontal Hall elements H1, H2, H3 provide signals h1, h2, h3 respectively, indicative of Bz1, Bz2, Bz3 oriented in the Z-direction, at three different sensor locations. The three horizontal Hall elements H1 to H3 are preferably located on a virtual line, perpendicular to the conductors C1, C2. H1 and H2 are preferably located on opposite sides of conductor C1, at equal distances therefrom. H2 and H3 are preferably located on opposite sides of conductor C2, at equal distances therefrom.

**FIG. 9B** shows formulas to determine a first and a second current I1, I2 flowing through conductors C1, C2 respectively, based on signals h1, h2, h3 obtained from the magnetic sensors H1, H2, H3 of FIG. 9A.

The set of formulas [9-3] requires only four coefficients k9a to k9d which can be determined in a calibration test, and allows to calculate I1 and I2 based on pairwise differences, hence the result is highly insensitive to an external disturbance field. The set [9-3] also allows for active cross-talk reduction by a very simple calculation.

**FIG. 9C** shows an illustrative example of a semiconductor substrate 901 comprising three horizontal Hall elements, as can be used in the current sensor device of FIG. 9A. As can be seen, the three horizontal Hall element are preferably located on a virtual line, and preferably the distance d12 between H1 and H2 is equal to the distance d23 between H2 and H3.

FIG. 9A to FIG. 9C may be jointly referred to as **FIG. 9****.**

In a variant (not shown) of FIG. 9, one or both of the conductors C1, C2 may be located outside of the packaged device 900.

In another or further variant of FIG. 9, H1 and H3 are situated above the outer edges of C1 and C2 respectively, or at a distance (in the X-direction) smaller than 1.0 mm therefrom.

In another or a further variant (not shown) of FIG. 9, one or both of the conductors C1, C2 may have a cut-out for locally reducing the width of the conductor, for locally increasing the current density, resulting in a higher magnetic field, which is beneficial for the signal-to-noise ratio. In the example of FIG. 9, a single cutout near H1, and a single cutout near H3 would allow to move the sensors H1 to H3 closer together, thus allowing a smaller, more compact semiconductor substrate 901.

**FIG. 10A** shows an illustrative example of an integrated current sensor device 1000 that comprises two parallel electrical conductors C1, C2 arranged next to each other, and three vertical Hall elements V1, V2, V3.

FIG. 10A can be seen as a variant of FIG. 9A, having vertical Hall elements instead of horizontal Hall elements, and two of these vertical Hall elements V1, V3 being arranged above the conductors rather than outside of the conductors, or near outer edges thereof.

The vertical Hall elements V1, V2, V3 provide signals v1, v2, v3 respectively, indicative of magnetic field components Bx1, Bx2, Bx3 oriented in the X-direction, respectively. The sensors V1 to V3 are preferably arranged on a virtual line, perpendicular to the conductors C1, C2. V1 is arranged above C1. V3 is arranged above C2. V2 is preferably arranged between V1 and V3, e.g. halfway between V1 and V3.

**FIG. 10B** shows formulas to determine a first and a second current I1, I2 based on signals v1, v2, v3 obtained from the magnetic sensors V1, V2, V3 of FIG. 10A.

The set of formulas [10-3] requires only four coefficients k10a to k10d which can be determined in a calibration test, and allows to calculate I1 and I2 based on pairwise differences, hence the result is highly insensitive to an external disturbance field. The set [10-3] also allows for active cross-talk reduction by a simple calculation.

**FIG. 10C** shows an illustrative example of a semiconductor substrate 1001 comprising three vertical Hall elements V1, V2, V3, as can be used in the current sensor device 1000 of FIG. 10A.

As can be seen, the three vertical Hall element V1 to V3 are preferably located on a virtual line, and preferably the distance d12 between V1 and V2 is equal to the distance d23 between V2 and V3.

In the example of FIG. 10A, V1 and V3 are situated substantially in the middle of C1 and C2 respectively (thus d12≈dcc/2, and d23≈dcc/2), but that is not absolutely required, and they can also be be situated closer together, e.g. such that the ratio of d12/dcc and the ratio d23/dcc are values in the range from 30% to 70%.

FIG. 10A to FIG. 10C may be jointly referred to as **FIG. 10****.**

In a variant (not shown) of FIG. 10, one or both of the conductors C1, C2 may be located outside of the packaged device 1000.

In another or a further variant (not shown) of FIG. 10, one or both of the conductors C1, C2 may have a cut-out for locally reducing the width of the conductors, for locally increasing the current densities, which is beneficial for the signal-to-noise ratio (SNR). In the example of FIG. 10, a single cutout near V1, and a single cutout near V3 would also allow to move the sensors V1 to V3 closer together while at the same time increasing the current densities, thus allowing a smaller, more compact semiconductor substrate 1001.

**FIG. 11A** shows an illustrative example of an integrated current sensor device 1100 that comprises two parallel electrical conductors C1, C2 arranged next to each other, and three magnetic sensors s1, s2, s3, each comprising a horizontal Hall element and a pair of integrated magnetic flux concentrators.

FIG. 11A can be seen as a variant of FIG. 10A, using a different kind of magnetic sensors (the same type as explained above, see e.g. FIG. 4C and FIG. 4D).

The horizontal Hall elements H1, H2, H3 provide signals h1, h2, h3 respectively, indicative of magnetic field components Bx1, Bx2, Bx3 oriented in the X-direction. The sensors s1 to s3 are preferably arranged on a virtual line, perpendicular to the conductors C1, C2.

H1 is preferably arranged above C1, and H3 is preferably arranged above C2, and H2 is preferably arranged between H1 and H3, e.g. halfway between H1 and H3.

**FIG. 11B** shows formulas to determine a first and a second current based on signals obtained from the magnetic sensors of FIG. 11A.

The same remarks made for the set of formulas [10-3] of FIG. 10B is also applicable for the set of formulas [11-3] of FIG. 11B.

**FIG. 11C** shows an illustrative example of a semiconductor substrate 1101 comprising three magnetic sensors s1, s2, s3, each comprising a horizontal Hall element and a pair of integrated magnetic flux concentrators, extending the X-direction, as can be used in the current sensor device 1100 of FIG. 11A.

FIG. 11A to FIG. 11C may be jointly referred to as **FIG. 11****.**

The same remarks made for FIG. 10, e.g. regarding the transverse position of H1 and H3, and/or regarding one or both of the conductors C1, C2 being external, and/or regarding C1 and/or C2 having a cut-out for increasing the current densities for increasing the SNR are also applicable for FIG. 11, mutatis mutandis.

**FIG. 12A** shows an illustrative example of an integrated current sensor device 1200 that comprises two parallel electrical conductors C1, C2, and four horizontal Hall elements H1 to H4 situated at four different sensor locations. The horizontal Hall elements H1 to H4 provide signals h1 to h4, indicative of Bz1 to Bz4 oriented in the Z-direction, respectively.

In the example shown, C1 and C2 extend in the Y-direction. The first conductor C1 has two cut-outs co1, co2 situated on opposite sides of the conductor C1, and spaced apart from each other in the Y-direction to form a zigzag zz1 with a portion oriented in the X-direction, perpendicular to the second conductor C2. The zigzag allows to locally redirect the current flow in another direction. The cut-outs co1, co2 may be rectangular cut-outs oriented in a transverse direction forming an angle of 90° with the longitudinal direction of C1.

It is an advantage of this embodiment that the two currents I1, I2 locally flow in perpendicular directions. The magnetic sensors H1 to H4 are preferably arranged for measuring these local current flows (better illustrated in FIG. 12C).

It is an advantage of this arrangement that the difference signal (h2-h1) is highly insensitive to the current I2 flowing through C2, and likewise, that the difference signal (h3-h4) is highly insensitive to the current I1 flowing through the first zigzag-portion. In other words, it is an advantage of this embodiment that the cross-talk between the two conductors is reduced in a passive manner.

**FIG. 12B** shows formulas to determine a first and a second current I1, I2 based on signals obtained from the magnetic sensors of FIG. 12A.

The set [12-2] determines the currents I1, I2 as a linear combination of the signals h1 to h4.

The set [12-3] determines the currents I1, I2 based on pairwise differences, and requires only four coefficients. The currents I1, I2 so determined have a reduced sensitivity to an external disturbance field, and are further actively compensated for cross-talk.

The set [12-4] determines each of the currents I1, I2 as being proportional to a single pairwise difference. In this set, no active cross-talk compensation is performed by calculations, but it fully relies on the passive cross-talk reduction related to the perpendicular directions of the currents.

The set [12-5] calculates in principle the same currents I1 and I2 as the set [12-4], but can be used even if the magnetic sensitivities are not matched, as explained above for set [1-5] of FIG. 1B. Thus, this set of formulas can be used with a semiconductor substrate where the magnetic sensitivities of the horizontal Hall elements H1 to H4 are not matched by laser-trimming, or by using adjustable biasing sources.

**FIG. 12C** shows the relative position of the conductors and the package of FIG. 12A, and shows the currents I1, I2 locally flowing in perpendicular directions, as explained above.

**FIG. 12D** shows an illustrative example of a semiconductor substrate 1201 comprising four horizontal Hall elements H1 to H4 arranged on two perpendicular virtual lines, as can be used in the current sensor device of FIG. 12A.

In the example shown, H1 to H4 are located on a virtual letter "T".

In the example shown, the virtual line passing through H3 and H4 is an perpendicular bisector of the virtual line passing through H1 and H2, meaning that the former intersects the latter substantially in the middle between H1 and H2, but that is not absolutely required.

**FIG. 12E** and **FIG. 12F** show variants of FIG. 12A, wherein the second conductor C2 has a portion with a narrowed width for locally increasing the current density of I2.

In the example shown in FIG. 12E, a QFN-package with sixteen contacts is shown, but of course, the present invention is not limited hereto, and other packages can be used as well. In the example shown, the contacts at the upper edge and bottom edge of FIG. 12E are connected to the conductors C1, C2. The contacts 1204 at the left and right edge of the package can be connected to the semiconductor substrate 1251, e.g. using bond wires 1210 (only two bond wires are shown for illustrative purposes).

In the example shown in FIG. 12F, an SOIC-package with sixteen contacts is shown. In the example shown, the four central contacts on opposite sides are connected to the conductors C1, C2. The other contacts 1204 can be connected to the semiconductor substrate 1261, e.g. using bond wires 1210 (only two bond wires are shown for illustrative purposes).

FIG. 12A to FIG. 12F may be jointly referred to as **FIG. 12****.**

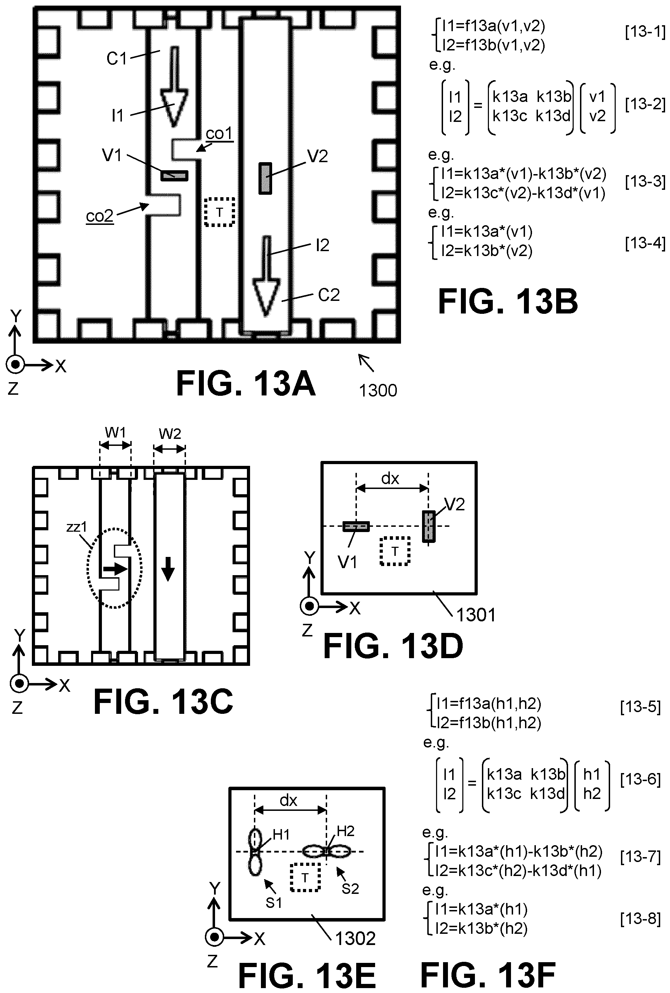

**FIG. 13A** show an illustrative example of a current sensor device 1300 with two overall parallel conductors C1, C2, one conductor C1 having two cut-outs co1, co2 forming a zigzag, and two vertical Hall elements V1, V2 oriented in perpendicular directions.

The current sensor device 1300 of FIG. 13A is a variant of the current sensor device 1200 of FIG. 12A, the main difference being that the sensor device 1300 has two vertical Hall elements V1, V2 arranged above the conductors C1, C2 instead of four horizontal Hall elements arranged next to the conductors. The sensor elements V1, V2 provide signals v1, v2 indicative of By1, Bx2 measured at two different sensor locations.

**FIG. 13B** shows formulas to determine a first and a second current I1, I2 based on signals obtained from the magnetic sensors V1, V2 of FIG. 13A.

In the set [13-3] cross-talk reduction or compensation is performed by calculations.

In the set [13-4] no active cross-talk reduction or compensation is performed by calculations, but it fully relies on the passive cross-talk reduction related to the perpendicular directions of the currents.

**FIG. 13C** is a replica of FIG. 12C, and shows the relative position of the conductors C1, C2 and the package of FIG. 13A.

**FIG. 13D** shows an illustrative example of a semiconductor substrate 1301 comprising two vertical Hall elements V1, V2, as can be used in the current sensor device 1300 of FIG. 13A.

**FIG. 13E** shows an illustrative example of a semiconductor substrate 1302, which is a variant of the semiconductor substrate 1301. The semiconductor substrate 1302 comprises two magnetic sensors s1, s2, each comprising a horizontal Hall element and a pair of integrated magnetic flux concentrators, as can also be used in combination with the package and conductors of FIG. 13C to form a current sensor device. H1 provides a signal h1 indicative of a magnetic field component By1 oriented in the Y-direction. H2 provides a signal h2 indicative of a magnetic field component Bx2 oriented in the X-direction.

**FIG. 13F** shows formulas to determine a first and a second current I1, I2 based on signals h1, h2 obtained from the magnetic sensors s1, s2 of FIG. 13E.

The set [13-7] allows cross-talk reduction by calculations.

The set [13-8] is a simplified version of the set [13-7], and does not allow cross-talk reduction by calculations, but relies on the passive cross-talk reduction related to the geometry of the conductors and the arrangement of the magnetic sensors.

FIG. 13A to FIG. 13F may be jointly referred to as **FIG. 13F****.** Everything else mentioned above for FIG. 12 is also applicable here, mutatis mutandis.

**FIG. 14A** show an illustrative example of a current sensor device 1400 with two overall parallel conductors C1, C2, one conductor C1 having two cut-outs co1, co2 forming a zigzag, and four vertical Hall elements V1 to V4 oriented in two perpendicular directions.

The current sensor device 1400 of FIG. 14A is a variant of the current sensor device 1300 of FIG. 13A, the main difference being that the sensor device 1400 has four vertical Hall elements V1 to V4 arranged in the vicinity of the conductors C1, C2 instead of only two.

The current sensor device 1400 of FIG. 14 can also be seen as a variant of the current sensor device 1200 of FIG. 12.

The sensor elements V1 to V4 provide signals v1 to v4, indicative of By1, Bx2, Bx3, By4 respectively. V1 is preferably located above the zigzag of C1, V2 is preferably located above C2. In the example of FIG. 14A the sensors V3 and V4 are located between the conductors C1 and C2 at a non-zero distance from the zigzag of C1, but V3 and V4 could also be located near an edge of C2, for example.

**FIG. 14B** shows formulas to determine a first and a second current I1, I2 based on signals obtained from the magnetic sensors of FIG. 14A. The sets of formulas [14-2] to [14-5] offer the same advantages as the sets [12-2] to [12-5] of FIG. 12.

**FIG. 14C** is a replica of FIG. 13C, and shows the relative position of the conductors C1, C2 and the package of FIG. 14A.

**FIG. 14D** shows an illustrative example of a semiconductor substrate 1401 comprising four vertical Hall elements, as can be used in the current sensor device of FIG. 14A. V1 and V4 are oriented in parallel, with their axis of main sensitivity oriented in the Y-direction. V2 and V3 are oriented in parallel, with their axis of main sensitivity oriented in the X-direction.

In a variant (not shown) of FIG. 14D, V3 and V4 are arranged on the same virtual line passing through V1 and V2.

**FIG. 14E** shows an illustrative example of a semiconductor substrate 1402 comprising four magnetic sensors s1 to s4, each comprising a horizontal Hall element and a pair of integrated magnetic flux concentrators, as can **also** be used in combination with the conductors of FIG. 14C for determining a first and second current. The Hall elements of the sensors s1 to s4 provide signals h1 to h4, indicative of By1, Bx2, Bx3, By4.

**FIG. 14F** shows formulas to determine a first and a second current I1, I2 based on signals h1 to h4 obtained from the magnetic sensors s1 to s4 of FIG. 14E.

The set of formulas [14-8] can be used to determine the currents based on magnetic field differences. This set provides both high insensitivity to an external disturbance field, as well as active cross-talk reduction or cancelation by a simple calculation.

The set of formulas [14-9] is a simplified version of the set [14-8], and does not provide active cross-talk reduction, but fully relies on the passive cross-talk reduction related to the perpendicular directions of the currents due to the zigzag (e.g. as illustrated in FIG. 14C).

FIG. 14A to FIG. 14F may be jointly referred to as **FIG. 14****.**

**FIG. 15A** show an illustrative example of a current sensor device 1500 with two overall parallel conductors C1, C2, and four horizontal Hall elements H1 to H4.

The current sensor device 1500 of FIG. 15A is a variant of the current sensor device 1200 of FIG. 12A, the main differences being that both conductors have two cut-outs, so as to form a zig-zag with two transverse portions oriented perpendicular to each other. In particular, the first conductor C1 has two cut-outs co1, co2 forming a first zigzag with a first portion where the first current I1 is forced to locally flow in a different direction (e.g. in direction V at 45° relative to the rest of C1). Likewise, the second conductor C2 has two cut-outs co3, co4 forming a second zigzag with a second portion where the second current I2 is forced to locally flow in a different direction (e.g. in direction U at 45° relative to the rest of C2, and perpendicular to the direction of I1). The sensor elements H1, H2 are arranged in the vicinity of the first portion for measuring the first current I1, and the sensor elements H3, H4 are arranged in the vicinity of the second portion for measuring the second current I2.

It is an advantage of this arrangement that the difference signal (h2-h1) is highly insensitive to the current I2 flowing through the second zigzag-portion, and likewise, that the difference signal (h3-h4) is highly insensitive to the current I1 flowing through the first zigzag-portion.

**FIG. 15B** shows formulas to determine a first and a second current I1, I2 based on signals obtained from the magnetic sensors H1 to H4 of FIG. 15A.

In the set [15-3] and [15-4] the currents are determined based on pairwise differences.

In the set [15-3] cross-talk reduction or compensation is performed by calculations.

In the set [15-4] no active cross-talk reduction or compensation is performed by calculations, but it fully relies on the passive cross-talk reduction related to the perpendicular directions of the current in the zigzag portions.

The set [15-5] is a variant of the set [15-4] which can be used with a semiconductor substrate comprising four horizontal Hall elements with magnetic sensitivities that are not matched to each other, as explained above.

**FIG. 15C** shows the relative position of the conductors C1, C2 and the package of FIG. 15A, and shows the four cut-outs co1 to co4, forming the two zigzags with orthogonal portions.

**FIG. 15D** shows an illustrative example of a semiconductor substrate 1501 comprising four horizontal Hall elements, where H1 and H2 are located on a first virtual line, and H3 and H4 are located on a second virtual line, perpendicular to the first virtual line, as can be used in the current sensor device 1500 of FIG. 15A. In the example shown, H1 to H4 are situated on a virtual letter "V".

FIG. 15A to FIG. 15D may be jointly referred to as **FIG. 15****.**

Everything else described above for FIG. 12 is also applicable here, mutatis mutandis. For example, one or both of C1, C2 may be external to the package, etc.

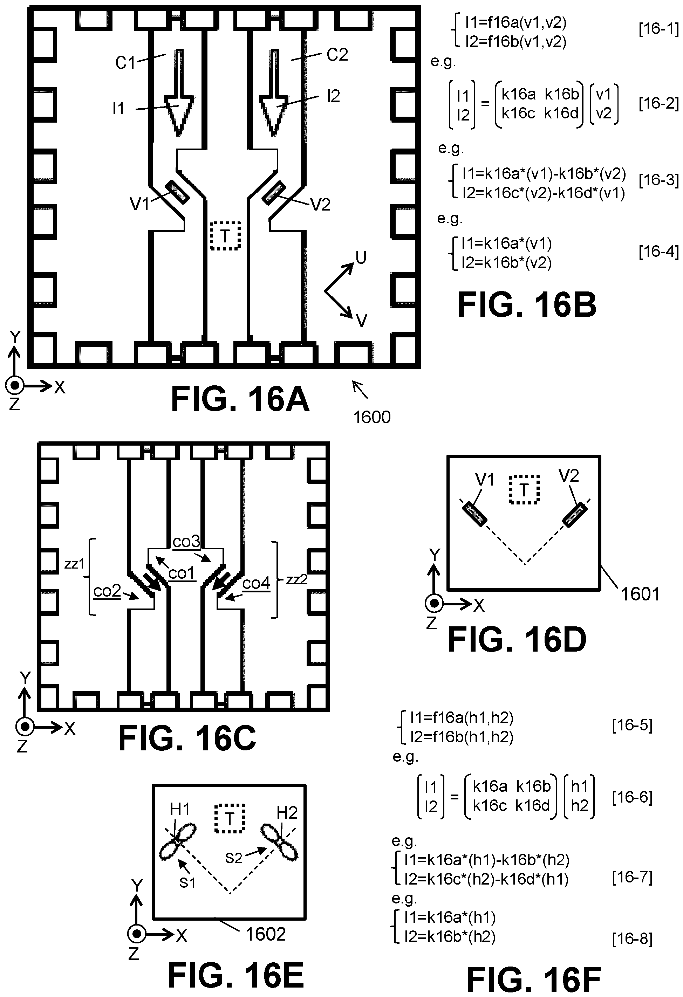

**FIG. 16A** show an illustrative example of a current sensor device 1600 with two overall parallel conductors C1, C2, and two vertical Hall elements V1, V2 oriented in orthogonal directions. Each of the first and second conductor C1, C2 has two cut-outs on opposite sides of the conductor, and spaced apart from each other, so as to form a first and a second zigzag.

Sensor element V1 is located above the zigzag portion of C1 between co1 and co2, and provides a signal v1 indicative of magnetic field component Bu1 oriented in the U-direction. Sensor element V2 is located above the zigzag portion of C2 between co3 and co4, and provides signal v2 indicative of magnetic field component Bv2 oriented in the V-direction.

The current sensor device 1600 of FIG. 16A can be seen as a variant of the current sensor device 1500 of FIG. 15A, the main difference being that the current sensor device 1600 has two vertical Hall elements V1, V2 instead of four horizontal Hall elements H1 to H4.

The current sensor device 1600 of FIG. 16A can also be seen as a variant of the current sensor device 1300 of FIG. 13A, the main difference being that both conductors of the current sensor device 1600 have two cut-outs forming a zigzag, whereas only the first conductor C1 of the current sensor device 1300 of FIG. 13 has a zigzag.

**FIG. 16B** shows formulas to determine a first and a second current I1, I2 based on signals v1, v2 obtained from the magnetic sensors of FIG. 16A.

These are similar formulas as shown in FIG. 13B, but the values of the coefficients may be different, of course. The same comments and advantages as described above, are applicable.

**FIG. 16C** shows the relative position of the conductors and the package of FIG. 16A.

**FIG. 16D** shows an illustrative example of a semiconductor substrate 1601 comprising two vertical Hall elements V1, V2, as can be used in the current sensor device of FIG. 16A. The two vertical Hall elements are preferably oriented in perpendicular directions, within a predefined tolerance margin, e.g. ±5°, or ±3°, or ±2°, or ±1°.

**FIG. 16E** shows an illustrative example of a semiconductor substrate 1602 comprising two magnetic sensors s1, s2, each comprising a horizontal Hall element and a pair of integrated magnetic flux concentrators, as can also be used in combination with the conductors of FIG. 16C for determining a first and second current.

**FIG. 16F** shows formulas to determine a first and a second current I1, I2 based on signals h1,.? h2 obtained from the magnetic sensors s1, s2 of FIG. 16E, when used in combination with the conductors of FIG. 16C.

The sets of formulas of FIG. 16F are similar to those of FIG. 13F, but the values of the coefficients may be different, of course.

FIG. 16A to FIG. 16F may be jointly referred to as FIG. 16. Everything else mentioned above for FIG. 13 and FIG. 15 is also applicable here, mutatis mutandis.

**FIG. 17A** show an illustrative example of a current sensor device 1700 with two overall parallel conductors C1, C2, and four horizontal Hall elements H1 to H4.

Each of the first and second conductor C1, C2 has two cut-outs (co1, co2; co3, co4) on opposite sides of the conductor, spaced apart from each other in the longitudinal direction (Y), so as to form a first and a second zigzag zz1, zz2. The cut-outs are shaped such that the currents I1 and I2 are forced to locally flow in the V-direction, e.g. at 45° angle with respect to the Y-direction.

In the example shown, an orthogonal projection of H1 is situated in co1, an orthogonal projection of H2 is situated in co2, an orthogonal projection of H3 is situated in co4, an orthogonal projection of H4 is situated in co3, but that is not absolutely required, and the horizontal Hall elements could also be arranged in the vicinity of the edges, or above the edges of the conductor portions of the zigzag.

The current sensor device 1700 of FIG. 17A can be seen as a variant of the current sensor device 1500 of FIG. 15A, the main difference being that the zig-zag of C2 is mirrored such that the two currents I1 and I2 flow in parallel directions through the first and second zigzag.

**FIG. 17B** shows formulas to determine a first and a second current I1, I2 based on signals h1 to h4 obtained from the magnetic sensors H1 to H4 of FIG. 17A. The formulas of FIG. 17B are very similar to those of FIG. 15B, and the same characteristics mentioned above are applicable here, except that more cross-talk is to be expected in the current sensor device of FIG. 17, but the set of formulas [17-3] allows to reduce or compensate cross-talk by simple calculations.

**FIG. 17C** shows the relative position of the conductors C1, C2 and the package of FIG. 17A.

**FIG. 17D** shows an illustrative example of a semiconductor substrate 1701 comprising four horizontal Hall elements H1 to H4, as can be used in the current sensor device of FIG. 17A. As can be seen, the four horizontal Hall elements are preferably located at the corners of a virtual parallelogram.

FIG. 17A to FIG. 17D may be jointly referred to as **FIG. 17****.**

Everything else described above for FIG. 15 is also applicable here, mutatis mutandis. For example, one or both of C1, C2 may be external to the package, etc.

**FIG. 18A** show an illustrative example of a current sensor device 1800 with two overall parallel conductors C1, C2, and two vertical Hall elements.

The current sensor device 1800 of FIG. 18A can be seen as a variant of the current sensor device 1700 of FIG. 17A, the main difference being that the current sensor device 1800 comprises two vertical Hall elements instead of four horizontal Hall elements.

The zig-zag portions extend in V-direction, e.g. at 45° angle with respect to the Y-direction in which the conductors extend. The vertical Hall elements V1, V2 are preferably arranged above the zigzag portions of C1 and C2. V1 and V2 provide signals v1, v2 indicative of magnetic field component Bu1, Bu2 oriented in the U-direction, perpendicular to the V-direction.

**FIG. 18B** shows formulas to determine a first and a second current I1, I2 based on signals obtained from the magnetic sensors of FIG. 18A. The formulas of FIG. 18B are very similar to those of FIG. 16B, but the coefficients may be quite different, because the sensors V1, V2 will likely experience more cross-talk. Nevertheless, the set of formulas [18-3] allows to strongly reduce cross-talk by simple calculations. Since the set [18-3] calculates the currents based on pairwise differences of parallel magnetic field components, the currents so calculated are also highly insensitive to an external disturbance field.

**FIG. 18C** shows the relative position of the conductors C1, C2 and the package of FIG. 18A.

**FIG. 18D** shows an illustrative example of a semiconductor substrate 1801 comprising two vertical Hall elements V1, V2, as can be used in the current sensor device of FIG. 18A. As can be seen, the two vertical Hall elements V1, V2 are preferably spaced apart in the X-direction, and are preferably oriented with their axis of main sensitivity oriented in the U-direction, e.g. at 45° with respect to the X-axis, but the present invention is not limited hereto, and another angle can also be used.

**FIG. 18E** shows an illustrative example of a semiconductor substrate 1802 comprising two magnetic sensors s1, s2, each comprising a horizontal Hall element and a pair of integrated magnetic flux concentrators, arranged for measuring magnetic field components Bu1, Bu2 at two sensor locations spaced apart in the X-direction; This semiconductor substrate can also be used in combination with the conductors and the package of FIG. 18C for determining a first and second current I1, I2.

**FIG. 18F** shows formulas to determine a first and a second current I1, I2 based on signals h1, h2 obtained from the magnetic sensors s1, s2 of FIG. 18E, when used in combination with the conductors and package of FIG. 18C.

FIG. 18A to FIG. 18F may be jointly referred to as **FIG. 18****.**

Everything else described above for FIG. 17 is also applicable here, mutatis mutandis. For example, one or both of C1, C2 may be external to the package, etc.

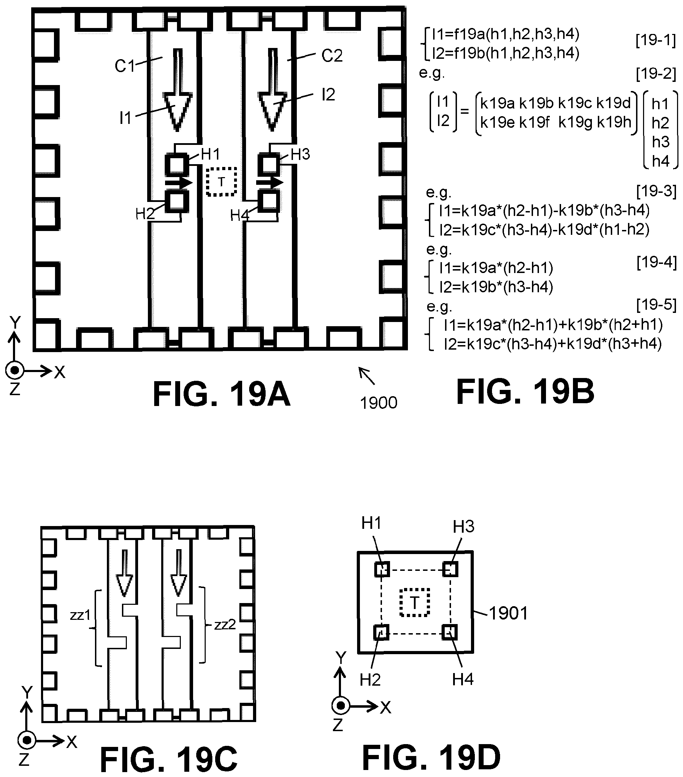

**FIG. 19A** show an illustrative example of a current sensor device 1900 with two overall parallel conductors C1, C2, and four horizontal Hall elements H1 to H4.

Each of the first and second conductor C1, C2 has two cut-outs (on opposite sides of the conductor, spaced apart from each other in the longitudinal direction (Y), so as to form a first and a second zigzag zz1, zz2 (see also FIG. 19C). The cut-outs are shaped such that the currents I1 and I2 are forced to locally flow in the X-direction, perpendicular to the Y-direction in which the conductors extend.

In the example shown in FIG. 19A, the horizontal Hall elements are arranged above the edges of the transverse conductor portions of the first and second zigzag zz1, zz2.

The current sensor device 1900 of FIG. 19A can be seen as a variant of the current sensor device 1700 of FIG. 17A, the main difference being that the transverse portion of the zigzags of FIG. 19A are oriented in the X-direction, perpendicular to the Y-direction in which the conductors extend.

**FIG. 19B** shows formulas to determine a first and a second current I1, I2 based on signals h1 to h4 obtained from the magnetic sensors H1 to H4 of FIG. 19A. The formulas of FIG. 19B are very similar to those of FIG. 17B, and the same comments made for the sets [17-1] to [17-5] are also applicable for the sets [19-1] to [19-5], mutatis mutandis.

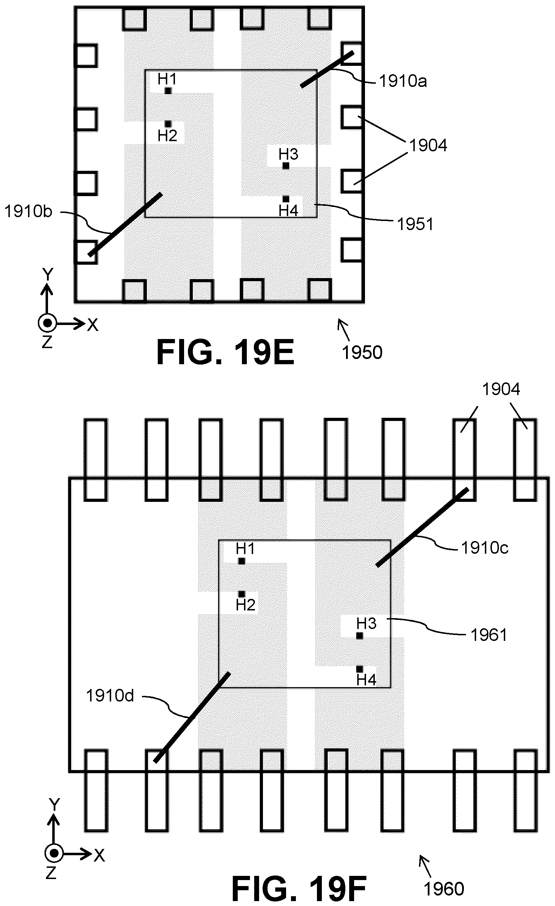

**FIG. 19C** shows the relative position of the conductors C1, C2 and the package of FIG. 19A. In the example of FIG. 19C, the two zigzags are situated substantially next to each other, at approximately the same Y-position. That is not absolutely required, however, as illustrated e.g. in FIG. 19E and FIG. 19F, where the zigzags are offset in the Y-direction.

**FIG. 19D** shows an illustrative example of a semiconductor substrate 1901 comprising four horizontal Hall elements, as can be used in the current sensor device of FIG. 19A. In the example shown, the horizontal Hall elements H1 to H4 are located at the corners of a virtual rectangle.

**FIG. 19E** and **FIG. 19F** show variants of FIG. 19A, wherein the two zigzags are shifted relative to each other in the Y-direction. The horizontal Hall elements H1 to H4 of the semiconductor substrate 1902 are preferably located at the corners of a virtual parallelogram (not shown). The horizontal Hall elements are preferably located in close vicinity of the edges, or above the edges of the transverse portions, e.g. at a distance smaller than 300 µm, or smaller than 200 µm, or smaller than 150 µm therefrom.

In the example shown in FIG. 19E, a QFN-package with sixteen contacts 1904 is shown, but of course, the present invention is not limited hereto, and other packages can be used as well. In the example shown, the contacts at the upper edge and bottom edge of FIG. 19E are connected to the conductors C1, C2. The contacts 1904 at the left and right edge of the package of FIG. 19E can be connected to the semiconductor substrate 1951, e.g. using bond wires 1910 (only two bond wires are shown for illustrative purposes).

In the example shown in FIG. 19F, an SOIC-package with sixteen contacts 1904 is shown. In the example shown, the four central contacts on opposite sides are connected to the conductors C1, C2. The other contacts 1904 can be connected to the semiconductor substrate 1961, e.g. using bond wires 1910 (only two bond wires are shown for illustrative purposes).

FIG. 19A to FIG. 19F may be jointly referred to as **FIG. 19****.**

Everything else described above for FIG. 17 is also applicable here, mutatis mutandis. For example, one or both of C1, C2 may be external to the package, etc.

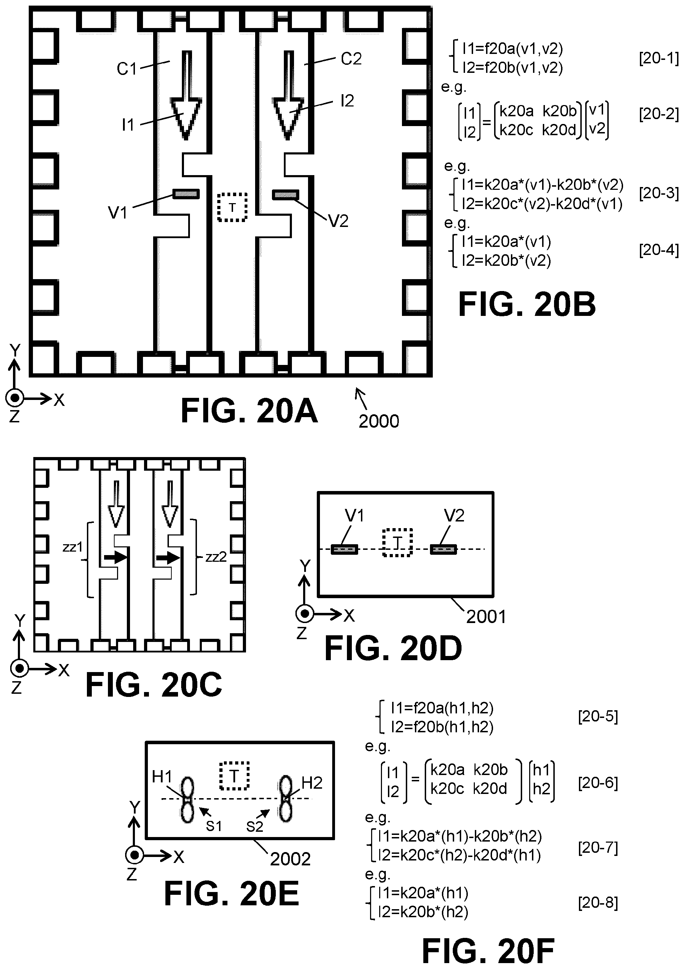

**FIG. 20A** show an illustrative example of a current sensor device 2000 with two overall parallel conductors C1, C2, and two vertical Hall elements V1, V2.

Each of the first and second conductor C1, C2 has two cut-outs (on opposite sides of the conductor, spaced apart from each other in the longitudinal direction (Y), so as to form a first and a second zigzag zz1, zz2 (see also FIG. 20c). The cut-outs are shaped such that the currents I1 and I2 are forced to locally flow in the X-direction, perpendicular to the Y-direction in which the conductors extend.

The magnetic sensors V1, V2 provide signals v1, v2 indicative of magnetic field components By1, By2 at two different sensor locations above the first and second conductor C1, C2, more specifically, above the first and second zigzag zz1, zz2.

The current sensor device 2000 of FIG. 20A can be seen as a variant of the current sensor device 1900 of FIG. 19A, the main difference being that the current sensor device 2000 comprises two vertical Hall elements instead of four horizontal Hall elements.

The current sensor device 2000 of FIG. 20A can also be seen as a variant of the current sensor device 1800 of FIG. 18A, the main difference being that the cut-outs and the zig-zags are shaped differently, the currents flow differently in the zig-zag portions, and the magnetic field generated by these currents, especially in the vicinity of the zigzag portions is quite differently.

**FIG. 20B** shows formulas to determine a first and a second current I1, I2 based on signals v1, v2 obtained from the magnetic sensors V1, V2 of FIG. 20A. The formulas of FIG. 20B are very similar to those of FIG. 18B, and the same comments made for the sets [18-1] to [18-4] are also applicable for the sets [20-1] to [20-4], mutatis mutandis.

**FIG. 20C** shows the relative position of the conductors C1, C2 and the package of FIG. 20A.

**FIG. 20D** shows an illustrative example of a semiconductor substrate 2001 comprising two vertical Hall elements V1, V2, as can be used in the current sensor device 2000 of FIG. 20A.

In a variant (not shown), the first and second zig-zag zz1, zz2 are offset from each other in the Y-direction, and the positions of the vertical Hall elements V1, V2 are offset in the X-direction and the Y-direction, correspondingly.

**FIG. 20E** shows a semiconductor substrate 2002 comprising two magnetic sensors s1, s2, each comprising a horizontal Hall element and a pair of integrated magnetic concentrators, as can also be used in combination with the conductors and package of FIG. 20C for determining a first and second current.

**FIG. 20F** shows formulas to determine a first and a second current I1, I2 based on signals h1, h2 obtained from the magnetic sensors s1, s2 of FIG. 20E.

FIG. 20E and FIG. 20F can be seen as a variant of FIG. 18E and FIG. 18F, and the same remarks made for FIG. 18E and FIG. 18F are applicable for FIG. 20E and FIG. 20F, mutatis mutandis.

FIG. 20A to FIG. 20F may be jointly referred to as FIG. 20.

In another or a further variant of FIG. 20, one or both of the conductors C1, C2 may be external to the package.

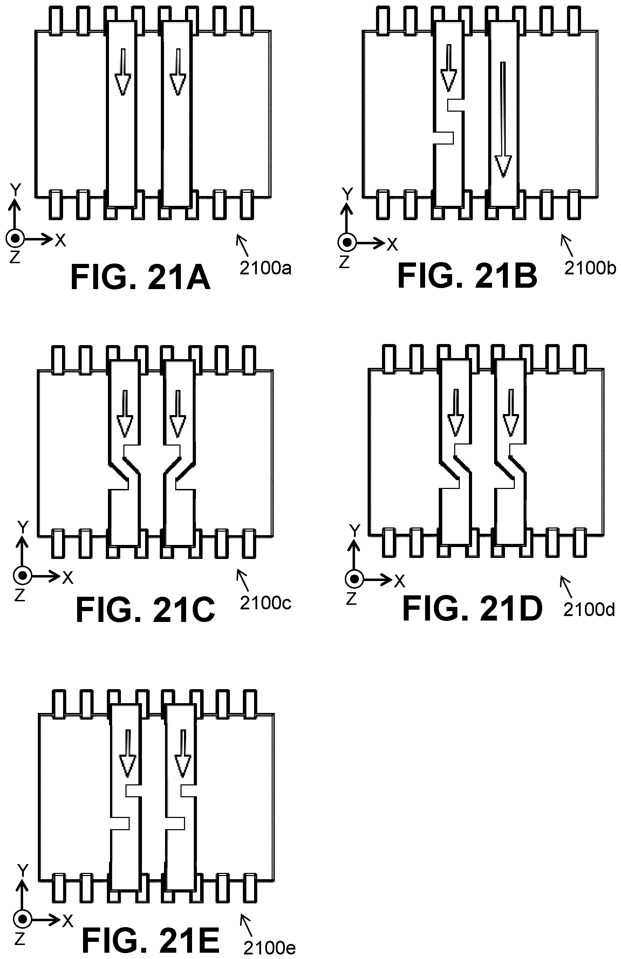

**FIG. 21A** to **FIG. 21E** show illustrative examples of integrated current sensor devices 2100a to 2100e having two electrical conductors C1, C2 extending in a same direction, with or without a zigzag, as may be used in embodiments of the present invention. While not shown, these current sensor devices further comprise a semiconductor substrate with a plurality of magnetic sensors, e.g. 1D magnetic pixels, for measuring magnetic field components at various locations, e.g. at 2 different locations, or at 3 different locations, or at 4 different locations. The current sensor devices further comprise a processing unit, e.g. a programmable processor, integrated in the same semiconductor substrate or in another semiconductor substrate comprised in the same packaged semiconductor device.

The main purpose of FIG. 21A to FIG. 21E is to illustrate that not only QFN packages can be used to form extremely compact current sensor devices, but for example also SOIC-packages, and that the two parallel conductors may be straight, or may have one or two zigzags.

**FIG. 22A** shows an illustrative example of an integrated current sensor device 2200 that comprises two electrical conductors C1, C2 having a C-shape or a U-shape, and four horizontal Hall elements H1 to H4 arranged in the vicinity of the conductors, e.g. in close vicinity of an inner edge and an outer edge of each conductor.

In the example shown, each end E1,E2; E3,E4 of each conductor C1, C2 is connected to two adjacent contacts (e.g. pins) of the package, and in the example of FIG. 22A, all the contacts that are connected to the conductor ends E1 to E4 are located on one side of the package (the bottom of FIG. 22A).

The four magnetic sensors H1 to H4 provide signals h1 to h4, indicative of four magnetic field components Bz1 to Bz4 measured at four different locations, and oriented in the Z-direction, perpendicular to the semiconductor substrate 2201 (e.g. as illustrated in FIG. 22D) that contains the magnetic sensors H1 to H4.

In the example of FIG. 22A, the four horizontal Hall elements are situated on a virtual rectangle.

**FIG. 22B** shows formulas to determine a first and a second current I1, I2 based on signals h1 to h4 obtained from the magnetic sensors H1 to H4 of FIG. 22A.

The formulas of FIG. 22B are very similar to those of FIG. 19B, and the same comments made for the sets of formulas [19-1] to [19-5] are also applicable for the sets [22-1] to [22-5], mutatis mutandis.

In brief, set [22-2] expresses each of I1 and I2 as a linear combination of the signals h1 to h4 using predefined coefficients.

The set [22-3] expresses each of the currents I1, I2 as a linear combination of two magnetic field differences, namely of a first difference (h2-h1) and a second difference (h4-h3). The set [22-3] provides current values with a reduced sensitivity to an external disturbance field, and also allows active cross-talk reduction by a simple calculation.

The set [22-4] is a simplied version of the set [22-3]. The resulting current values have a reduced sensitivity to an external disturbance field, but the set [22-4] does not reduce cross-talk by calculations.

The set [22-5] is a variant of the set [22-4], and can be used even if the magnetic sensitivity of the horizontal Hall elements H1 to H4 are not matched to each other (as explained for set [1-5] of FIG. 1B).

Of course, the current sensor device 2200 only needs to implement one of these sets of formulas. As described above, the coefficients for the set of formulas that is implemented in the current sensor device can be determined by simulation or by calibration, and the values of the coefficients may be stored in a non-volatile memory of the current sensor device during calibration, and may be obtained from the non-volatile memory during actual use of the device.

**FIG. 22C** shows the relative position of the conductors C1, C2 and the package of FIG. 22A. The black arrows show the directions of the currents which are measured by the magnetic sensors H1 to H4.

**FIG. 22D** shows an illustrative example of a semiconductor substrate 2201 comprising four horizontal Hall elements H1 to H4, as can be used in the current sensor device of FIG. 22A. In the example shown in FIG. 22D, the four horizontal Hall elements H1 to H4 are arranged on a virtual rectangle, but that is not absolutely required, as will be explained and illustrated further.

**FIG. 22E** and **FIG. 22F** show variants of FIG. 22C, as can also be used in combination with the semiconductor substrate of FIG. 22D for determining a first and second current. As can be understood from these figures, the conductors can have various shapes, e.g. ring shaped, elliptical shaped, V-shaped, omega shaped, but also a polygonal shape or a bridge shape can be used. The black arrows show the directions of the currents which are measured by the magnetic sensors.

FIG. 22A to FIG. 22F may be jointly referred to as **FIG. 22****.**

In a variant of FIG. 22, one or both of the conductors C1, C2 may be located outside of the packaged semiconductor device.

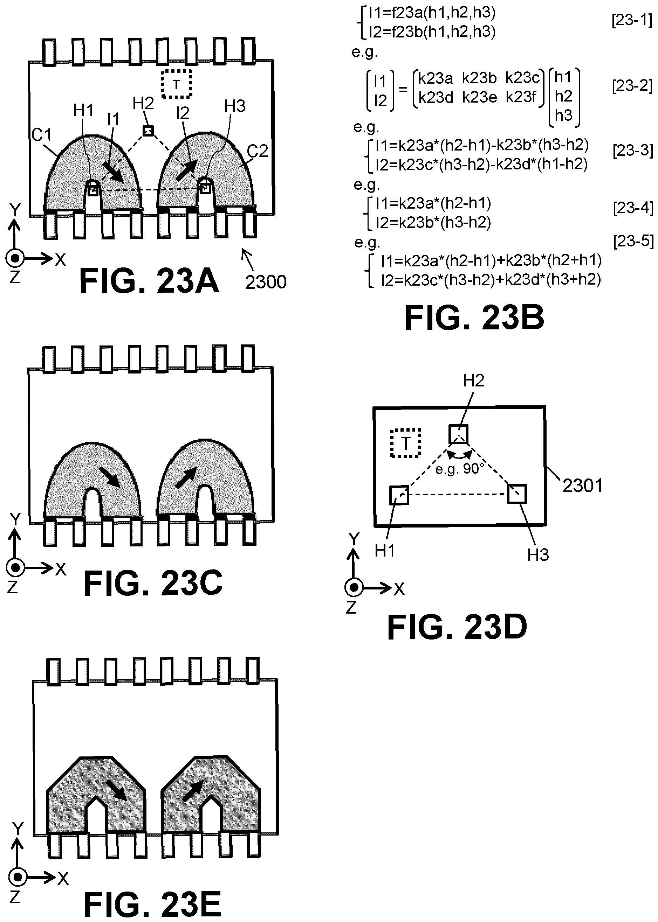

**FIG. 23A** shows an illustrative example of an integrated current sensor device 2300 that comprises two electrical conductors C1, C2 having a C-shape or a U-shape or the like, and only three horizontal Hall elements H1 to H3.

FIG. 23A can be seen as a variant of FIG. 22A, the main difference being that the current sensor device 2300 of FIG. 23A comprises only three horizontal Hall elements instead of four.

In the example shown, H1 is arranged near an inner edge of the first conductor C1, H3 is arranged near an inner edge of the second conductor C2, and H2 is arranged at a location between C1 and C2, preferably chosen such that an angle formed between a first line segment passing through H3 and H2 forms substantially a right angle (i.e. 90° ±10°, or 90° ±5°, or 90° ±2°) with a second line segment passing through H2 and H1.

The three magnetic sensors H1 to H3 provide signals h1 to h3, indicative of three magnetic field components Bz1 to Bz3 measured at three different locations, and oriented in the Z-direction, perpendicular to the semiconductor substrate that contains the magnetic sensors H1 to H3 (e.g. as illustrated in FIG. 23D).

FIG. 23A also shows two arrows, indicating the directions of the currents which are measured by the magnetic sensors H1 to H3.

In the example of FIG. 23A, the three horizontal Hall elements H1 to H3 are preferably situated on a virtual right-angled triangle, which offers the advantage that the two arrows are oriented perpendicular to each other, which may reduce the amount of cross talk between C1 and C2 in a passive manner (i.e. without performing calculations).

**FIG. 23B** shows formulas to determine a first and a second current I1, I2 based on the signals h1, h2, h3 obtained from the magnetic sensors H1, H2, H3 of FIG. 23A.

These sets of formulas are a bit similar to those of FIG. 22B, but not quite, since there are only three sensor signals h1 to h3.

The set [23-3] allows to determine the currents I1, I2 based on pairwise differences of magnetic field components, and provides current values I1, I2 with a reduced sensitivity to an external disturbance field, and allow active cross-talk reduction by simple calculations.

The set [23-4] is a simplified version of the set [23-3] but in contrast to the set [22-4], the set [23-4] may provide more accurate values for I1 and I2, because the pairwise differences signals (h1-h2) and (h3-h2) are related to the local current directions represented by the arrows in FIG. 23A and FIG. 23C, which are perpendicular to each other, hence may be less susceptible to cross-talk.

**FIG. 23C** shows the relative position of the conductors C1, C2 and the package of FIG. 23A. The black arrows show the directions of the currents which are measured by the magnetic sensors H1 to H3.

**FIG. 23D** shows an illustrative example of a semiconductor substrate 2301 comprising three horizontal Hall elements H1 to H3, as can be used in the current sensor device of FIG. 23A. In the example shown, the three horizontal Hall elements H1 to H3 are situated at the corners of a virtual right-angled triangle, but the present invention is not limited hereto, and the same advantages may also be obtained if the magnetic sensors H1 to H3 are situated on a virtual isosceles triangle, e.g. when H2 is situated on a perpendicular bisector of the line segment passing through H1 and H3, but the angle formed by the line segments [H3-H2] and [H2-H1] is an angle in the range from about 70° to about 110°, or in the range from about 80° to about 100°.

**FIG. 23E** shows a variant of FIG. 23C, as can also be used in combination with the semiconductor substrate of FIG. 23D for determining a first and second current. As can be seen, the conductors also have an overall C-shape or U-shape, but the inner and/or outer edges polygonal rather than rounded. Such a shape may offer the advantage that the directions of the arrows (corresponding to current flow) may be (slightly) better defined, and thus that the passive cross-talk rejection may be (slightly) improved.

FIG. 23A to FIG. 23E may be jointly referred to as **FIG. 23****.**

In a variant of FIG. 23, one or both of the conductors C1, C2 may be located outside of the packaged semiconductor device 2300.

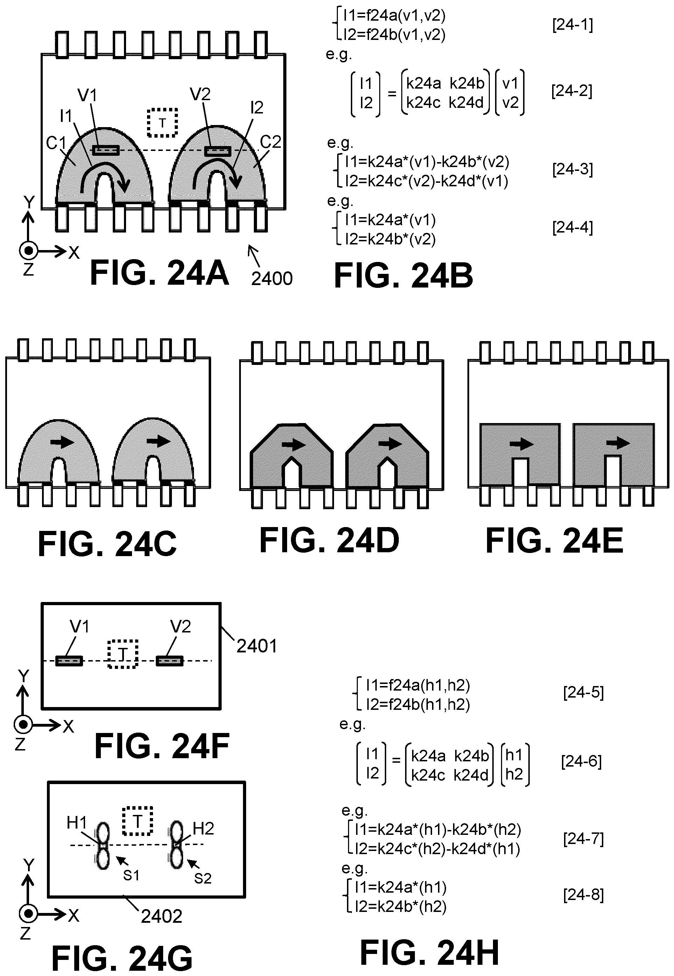

**FIG. 24A** shows an illustrative example of an integrated current sensor device 2400 that comprises two electrical conductors C1, C2 having a C-shape or a U-shape or the like, and two vertical Hall elements V1, V2.

FIG. 24A can be seen as a variant of FIG. 22A, and also measures the magnetic field generated by the current flowing in the X-direction at the locations indicated by the arrows in FIG. 24C to FIG. 24E, which is the same location as shown in FIG. 22C, FIG. 22E and FIG. 22F. The main difference between the current sensor device 2400 of FIG. 24A and the current sensor device 2200 of FIG. 22A is that the former comprises two vertical Hall elements V1, V2 instead of four horizontal Hall elements.

In the example shown, the vertical Hall element V1 is located above the conductors C1 substantially halfway between the ends E1, E2 of C1 (see FIG. 22C). Likewise, the vertical Hall element V2 is located above the conductors C2 substantially halfway between the ends E3, E4 of C2 (see FIG. 22C). V1 and V2 are preferably located halfway in the width direction of C1 and C2 (i.e. substantially halfway between the inner edge and the outer edge), but that is not absolutely required, and positions offset in the Y-direction will also work.

V1, V2 provide signals v1, v2 indicative of magnetic field components By1, By2 oriented in the Y-direction.

**FIG. 24B** shows formulas to determine a first and a second current I1, I2 based on signals v1, v2 obtained from the magnetic sensors V1, V2 of FIG. 24A. The set [24-3] allows active cross-talk reduction by a simple calculation. The set [24-4] is a simplified version of the set [24-3] and does not allow active cross-talk reduction.

**FIG. 24C** shows the relative position of the conductors and the package of FIG. 24A. The black arrows show the directions of the currents which are measured by the magnetic sensors V1, V2.

**FIG. 24D and FIG. 24E** show variants of FIG. 24C, as can also be used in combination with the semiconductor substrate of FIG. 24F for determining a first and second current.

**FIG. 24F** shows an illustrative example of a semiconductor substrate 2401 comprising two vertical Hall elements V1, V2, as can be used in the current sensor device of FIG. 24A. In the example shown, V1 and V2 are situated on a virtual line extending in the X-direction, but as already mentioned above, the present invention is not limited hereto, and the invention will also work if one or both of V1 and V2 are moved in the Y-direction to another position above the conductors C1, C2.

**FIG. 24G** shows an illustrative example of a semiconductor substrate 2402 comprising two magnetic sensors s1, s2, each comprising a horizontal Hall element H1, H2 and a pair of integrated magnetic concentrators, as can also be used in combination with the conductors and packages of FIG. 24C to FIG. 24E for determining a first and second current.

**FIG. 24H** shows formulas to determine a first and a second current I1, I2 based on signals h1, h2 obtained from the magnetic sensor elements H1, H2 of the magnetic sensors s1, s2 of FIG. 24G.

FIG. 24A to FIG. 24H may be jointly referred to as **FIG. 24****.**

In a variant of FIG. 24, one or both of the conductors C1, C2 may be located outside of the packaged semiconductor device 2500.

**FIG. 25A** shows an illustrative example of an integrated current sensor device 2400 that comprises two electrical conductors C1, C2 having a C-shape or a U-shape or the like, and three vertical Hall elements V1, V2, V3 spaced apart from each other, and oriented in the Y-direction.

FIG. 25A can be seen as a variant of FIG. 24A, the main difference being that the sensor device 2500 has three vertical Hall elements instead of only two.

In the example shown, V1 is located above the conductor C1, V2 is located above the conductor C2, and V3 is located between conductors C1 and C2, e.g. on a virtual line perpendicular to the line segment between V1 and V2.

V1, V2, V3 provide signals v1, v2, v3 indicative of magnetic field components By1, By2, By3 oriented in the Y-direction.

**FIG. 25B** shows formulas to determine a first and a second current I1, I2 based on signals v1, v2, v3 obtained from the magnetic sensors V1 to V3 of FIG. 25A.

The set [25-3] allows to calculate I1 and I2 based on pairwise differences, hence the result is highly insensitive to an external disturbance field. The set [25-3] also allows for active cross-talk reduction by a simple calculation.

The set [25-4] is a simplified version of [25-3], and determines the currents I1, I2 based on a single pairwise difference, result is highly insensitive to an external disturbance field, but does not allow to actively reduce cross-talk between the conductors C1 and C2.

**FIG. 25C** to FIG. 25E are a replica of FIG. 24C to FIG. 24E.

**FIG. 25F** shows a semiconductor substrate 2501 comprising three vertical Hall elements V1, V2, V3, as can be used in the current sensor device of FIG. 25A and FIG. 25E.

**FIG. 25G** shows an illustrative example of a semiconductor substrate 2502 comprising three magnetic sensors s1, s2, s3, each comprising a horizontal Hall element H1, H2, H3 and a pair of integrated magnetic concentrators, as can also be used in combination with the conductors and packages of FIG. 25C to FIG. 25E for determining a first and second current. The magnetic sensor elements H1 to H3 provide signals h1, h2, h3, indicative of magnetic field components By1, By2, By2 at the respective sensor locations.

**FIG. 25H** shows formulas to determine a first and a second current I1, I2 based on signals h1, h2, h3 obtained from the magnetic sensors s1, s2, s3 of FIG. 25G.

The set [25-7] allows to determine each of I1, I2 as a linear combination of h1, h2, h3 using predefined coefficients, which can be determined by calibration in known manners.

The set [25-8] expresses each of I1, I2 as a linear combination of two pairwise magnetic field differences, namely a first pairwise difference (h1-h3), and a second pairwise difference (h2-h3). The result is highly insensitive to an external disturbance field, and cross-talk between C1 and C2 is actively reduced.

The set [25-8] is a simplified version of [25-7], is based on a single pairwise difference, and hence the result is highly insenstive to an external disturbance field.

The set [25-9] is a variant of the set [25-8], and can be used even if the magnetic sensitivites of H1 to H3 are not matched. (as explained above, e.g. in FIG. 1B for set [1-5]).

FIG. 25A to FIG. 25H may be jointly referred to as **FIG. 25****.**

In a variant of FIG. 25, one or both of the conductors C1, C2 may be located outside of the packaged semiconductor device 2500.

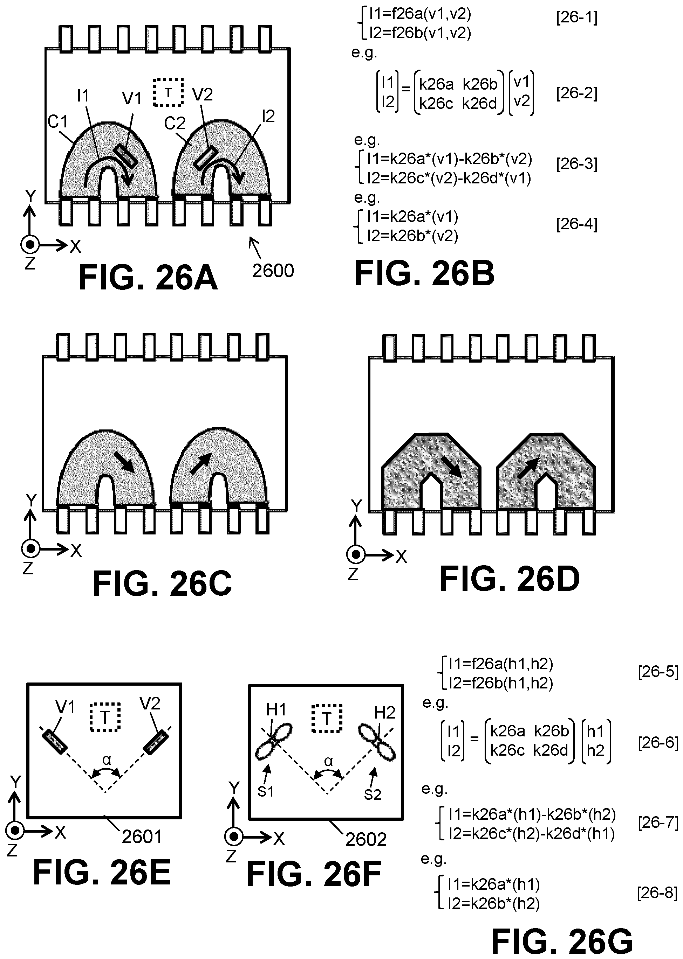

**FIG. 26A** shows an illustrative example of an integrated current sensor device 2600 that comprises two electrical conductors having a C-shape, or a U-shape or the like, and two vertical Hall elements V1, V2 oriented in perpendicular directions.

FIG. 26A can be seen as a variant of FIG. 24A, the main difference being that the two vertical Hall elements are rotated such that they are oriented in perpendicular directions, and they are also moved slightly closer towards each other. Thanks to the perpendicular orientations of V1 and V2, cross-talk between C1 and C2 is reduced in a passive manner.

**FIG. 26B** shows formulas to determine a first and a second current I1, I2 based on signals v1, v2 obtained from the magnetic sensors V1, V2 of FIG. 26A. These formulas are very simular to those of FIG. 24B, but the coefficients may be quite different. The set [26-3] allows to further reduce cross-talk between the conductors by simple calculations.

**FIG. 26C** shows the relative position of the conductors and the package of FIG. 26A. The black arrows show the directions of the currents which are measured by V1 and V2.

**FIG. 26E** shows an illustrative example of a semiconductor substrate 2601 comprising two vertical Hall elements V1, V2 spaced apart from other, and oriented perpendicular to each other, as can be used in the current sensor device 2600 of FIG. 26A. The angle α formed between a first line segment comprising V1 and a second line segment comprising V2 is preferably an angle of 90° ±10°, or 90° ±5°.

**FIG. 26D** shows a variant of FIG. 26C, as can also be used in combination with the semiconductor substrate 2601 of FIG. 26E for determining a first and second current I1, I2 flowing through the conductors C1, C2.

**FIG. 26F** shows an illustrative example of a semiconductor substrate 2602 comprising two magnetic sensors s1, s2, each comprising a horizontal Hall element and a pair of integrated magnetic concentrators, as can also be used in combination with the conductors and packages of FIG. 26C and FIG. 26D for determining a first and second current.

**FIG. 26G** shows formulas to determine a first and a second current I1, I2 based on signals h1, h2 obtained from the horizontal Hall elements H1, H2 of the magnetic sensors s1, s2 of FIG. 26F. These formulas are very simular to those of FIG. 24H, but the coefficients may be quite different.

FIG. 26A to FIG. 26G may be jointly referred to as **FIG. 26****.**

In a variant of FIG. 26, one or both of the conductors C1, C2 may be located outside of the packaged semiconductor device 2600.

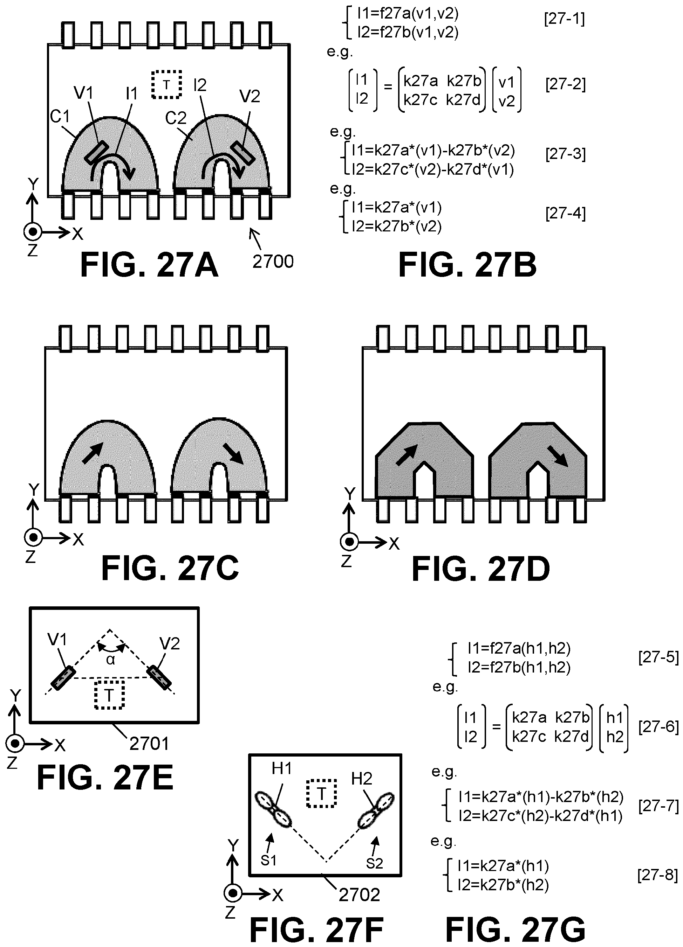

**FIG. 27A to FIG. 27G** may be jointly referred to as FIG. 27, and show a current sensor device 2700 which can be seen as a variant of the current sensor device 2600 of FIG. 26 where the vertical Hall elements V1, V2 are also oriented in perpendicular directions, but are moved slightly further apart. This may further reduce the cross-talk between C1 and C2 in a passive manner. Everything else mentioned for FIG. 26 is also applicable here.

**FIG. 28A to FIG. 28F** may be jointly referred to as FIG. 28, and show a current sensor device 2800 which can be seen as a variant of the current sensor device 2200 of FIG. 22 where the two ends E1, E2 of the first conductor C1 are connected to a first plurality of contacts 2804a located on a first side of the package, and where the two ends E3, E4 of the second conductor C2 are connected to a second plurality of contacts 2804b located on a second side of the package, different from the first side, e.g. opposite the first side; and where the four horizontal Hall elements H1 to H4 are located on a parallelogram (see FIG. 28D). Everything else mentioned for FIG. 22 is also applicable here, mutatis mutandis.

In a variant of FIG. 28 (not shown), the position of H1 and H3 is the same as in FIG. 28A, but H2 and H4 are located on a virtual line passing through H1 and H3, thus the four sensors are located on a single line. The same formulas as mentioned in FIG. 28B are applicable.

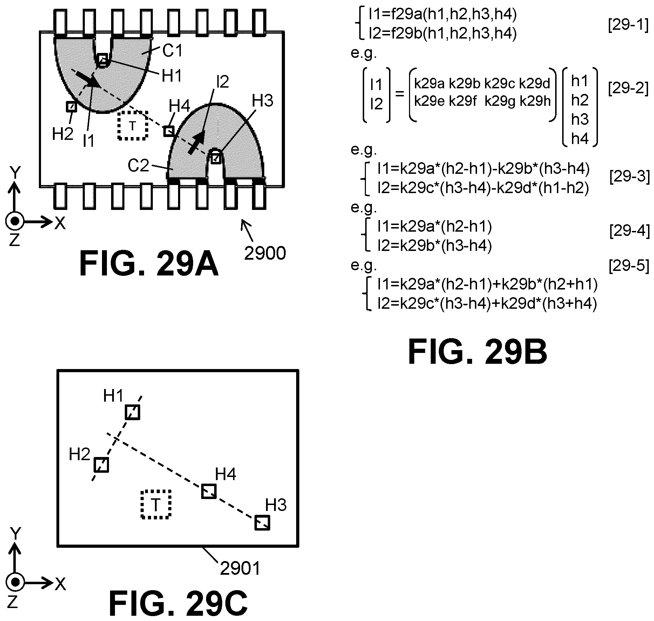

**FIG. 29A** shows an illustrative example of an integrated current sensor device 2900 that comprises two electrical conductors C1, C2 having a C-shape, or a U-shape or the like, and four horizontal Hall elements H1 to H4. The current sensor device 2900 of FIG. 29A can be seen as a variant of the current sensor device 2800 of FIG. 28A, the main difference being that the four Horizontal Hall elements are not located on a parallelogram, but are located on two perpendicular line segments forming a virtual letter T. More specifically, H1 and H2 are located on a first line segment, and H3 and H4 are located on a second line segment substantially perpendicular to the first line segment. H1 and H3 are situated near an inner edge of the U-shape. H2 and H4 are situated near an outer edge of the U-shape. An advantage of this arrangement is that cross-talk between the currents I1, I2 flowing through the conductors C1, C2 is reduced in a passive manner.

**FIG. 29B** shows formulas to determine a first and a second current I1, I2 based on signals h1 to H4 obtained from the magnetic sensors H1 to H4 of FIG. 29A. These formulas are very similar to the formulas of FIG. 28B, but of course, the values of the coefficients may be different.

**FIG. 29C** shows an illustrative example of a semiconductor substrate 2901 comprising four horizontal Hall elements H1 to H4 situated on a virtual letter T, as can be used in the sensor device 2900 of FIG. 29A.

**FIG. 29A to FIG. 29C** may be jointly referred to as FIG. 29. Everything else mentioned for FIG. 28 is also applicable here, mutatis mutandis.

**FIG. 30A** shows an illustrative example of an integrated current sensor device 3000 that comprises two electrical conductors C1, C2 having a C-shape or a U-shape or the like, and three horizontal Hall elements H1, H2, H3, preferably arranged on a single virtual line.

FIG. 30A can be seen as a variant of FIG. 28A, and/or as a variant of FIG. 29A, the main difference being that the current sensor device 3000 has only three horizontal Hall elements instead of four.

In the example shown in FIG. 30A, H1 is located near an inner edge of C1, H3 is located near an inner edge of C2, and H2 is situated between the two conductors C1, C2, preferably on a virtual line passing through H1 and H3, e.g. substantially in the middle between H1 and H3.

**FIG. 30B** shows formulas to determine a first and a second current based on signals obtained from the magnetic sensors of FIG. 30A. The set [30-3] allows for active cross-talk reduction. The set [30-4] is a simplified version of the set [30-3]. The set [30-5] is similar to the set [30-4] but can be used even if the magnetic sensitivities of H1 to H3 are not matched to each other.

**FIG. 30C** shows the relative position of the conductors C1, C2 and the package of FIG. 30A. The black arrows show the directions of the currents which are measured by the magnetic sensors H1 to H3.

**FIG. 30D** shows an illustrative example of a semiconductor substrate 3001 comprising only three horizontal Hall elements H1 to H3 situated on a virtual line, as can be used in the current sensor device of FIG. 30A.

**FIG. 30E** shows a variant of FIG. 30C, as can also be used in combination with the semiconductor substrate 3001 of FIG. 30D for determining a first and second current I1, I2.

**FIG. 30A to FIG. 30E** may be jointly referred to as FIG. 30. Everything else described above for FIG. 28 or FIG. 29 is also applicable here, mutatis mutandis. For example, one or both of the conductors may be situated outside of the package.

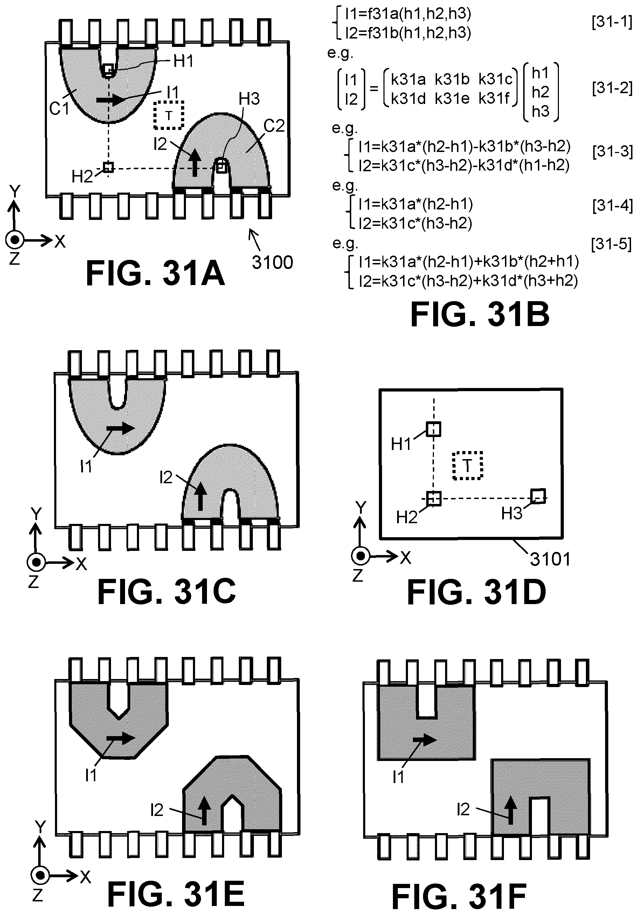

**FIG. 31A** shows an illustrative example of an integrated current sensor device 3100 that comprises two electrical conductors C1, C2 having a C-shape or a U-shape or the like, and only three horizontal Hall elements arranged on two perpendicular line segments.

FIG. 31A can be seen as a variant of FIG. 30A, where the position of H1 and H3 are maintained, but H2 is moved to another position, such that a first line segment passing through H1 and H2, and a second line segment passing through H2 and H3 are substantially perpendicular to each other. This may reduce the cross-talk between the currents I1 and I2 flowing through C1 and C2.

**FIG. 31B** shows formulas to determine a first and a second current I1, I2 based on signals h1 to h3 obtained from the magnetic sensors H1 to H3 of FIG. 31A. These formulas are very similar to those of FIG. 30B, but of course, the values of the coefficients may be quite different.

**FIG. 31C** shows the relative position of the conductors and the package of FIG. 31A. The black arrows show the directions of the currents which are measured by the magnetic sensors H1 to H3.

**FIG. 31D** shows an illustrative example of a semiconductor substrate 3101 comprising three horizontal Hall elements H1, H2, H3 arranged on two perpendicular line segments, as can be used in the current sensor device 3100 of FIG. 31A.

**FIG. 31E and FIG. 31F** show variants of FIG. 31C, as can also be used in combination with the semiconductor substrate 3101 of FIG. 31D for determining a first and second current.

**FIG. 31A to FIG. 31E** may be jointly referred to as FIG. 31. Everything else described above for FIG. 30 is also applicable here, mutatis mutandis. For example, one or both of the conductors may be situated outside of the package.

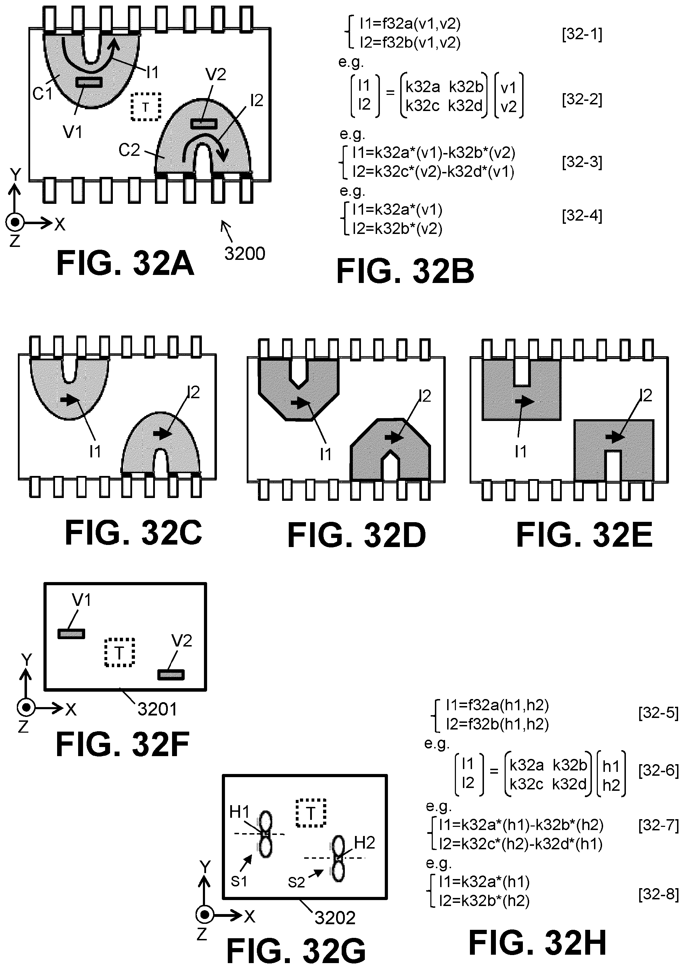

**FIG. 32A** shows an integrated current sensor device 3200 that comprises two electrical conductors C2, C2 having a U-shape or V-shape or the like, and two vertical Hall elements V1, V2 oriented in the same direction, but spaced relatively far apart (e.g. at least 1.0 mm, or at least 1.5 mm).

The current sensor device 3200 of FIG. 32A can be seen as a variant of the current conductor device 2800 of FIG. 28A, the main difference being that current sensor device 3200 has two vertical Hall elements instead of four horizontal Hall elements. In the example shown, V1 is located above C1, and V2 is located above C2. V1 and V2 provide signals v1, v2 indicative of By1 and By2.

**FIG. 32B** shows formulas to determine a first and a second current I1, I2 based on signals v1, v2 obtained from the magnetic sensors V1, V2 of FIG. 32A.

**FIG. 32C** shows the relative position of the conductors and the package of FIG. 32A. The black arrows show the directions of the currents which are measured by the magnetic sensors V1, V2.

**FIG. 32F** shows an illustrative example of a semiconductor substrate 3201 comprising two vertical Hall elements V1, V2 spaced apart from each other and oriented in the same direction, as can be used in the current sensor device 3200 of FIG. 32A.

**FIG. 32D and FIG. 32E** show variants of FIG. 32C, as can also be used in combination with the semiconductor substrate 3201 of FIG. 32F for determining the first and second current.

**FIG. 32G** shows an illustrative example of a semiconductor substrate 3202 comprising two magnetic sensors s1, s2, each comprising a horizontal Hall element and two integrated magnetic concentrators, as can also be used in combination with the conductors and packages of FIG. 32C to FIG. 32E for determining the first and second current.

**FIG. 32H** shows formulas to determine a first and a second current based on signals h1, h2 obtained from the magnetic sensor elements H1, H2 of the magnetic sensors s1, s2 of FIG. 32G.

**FIG. 32A to FIG. 32H** may be jointly referred to as FIG. 32.

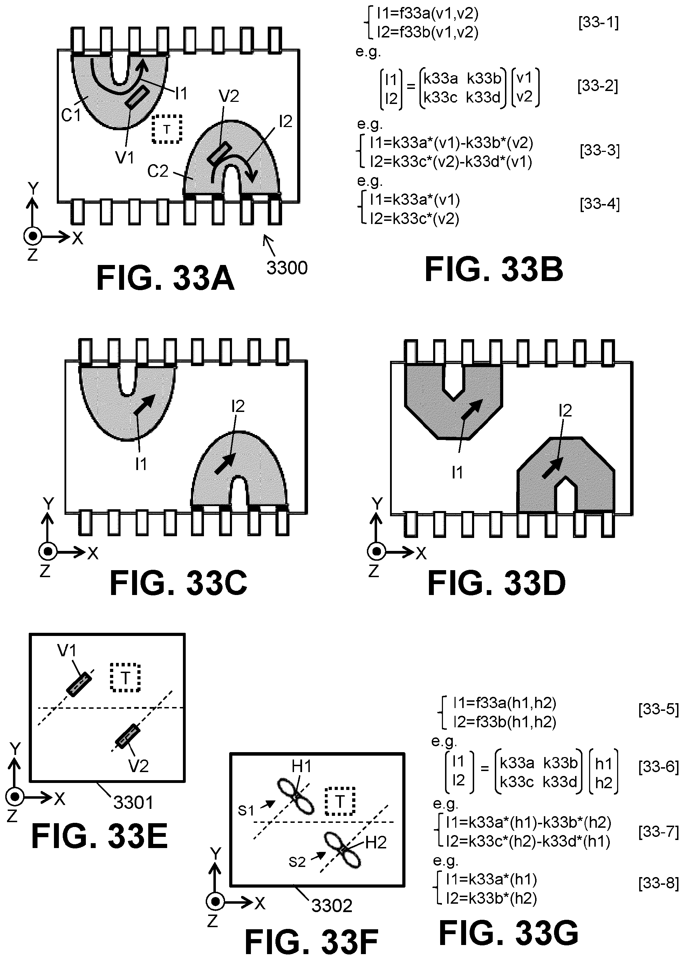

**FIG. 33A to FIG. 33G** may be jointly referred to as FIG. 33, and show a current sensor device 3300 which can be seen as a variant of the current sensor device 3200 of FIG. 32 where the two vertical Hall elements V1, V2 are slightly rotated, and slightly moved towards each other. V1 and V2 are still oriented in a same direction. This can be implemented on a smaller (more compact) substrate 3301.

In a particular embodiment, the two sensors V1, V2 are situated on a virtual line that coincides with the axes or their highest sensitivity.

In another or a further embodiment, the vertical Hall elements V1, V2 are slightly shifted towards the outer edges of the conductors C1, C2, but are still located above the conductors. In this way the distance between them can be further reduced, and the size of the semiconductor substrate can be further decreased.

Everything else described above for FIG. 32 is also applicable here, mutatis mutandis.

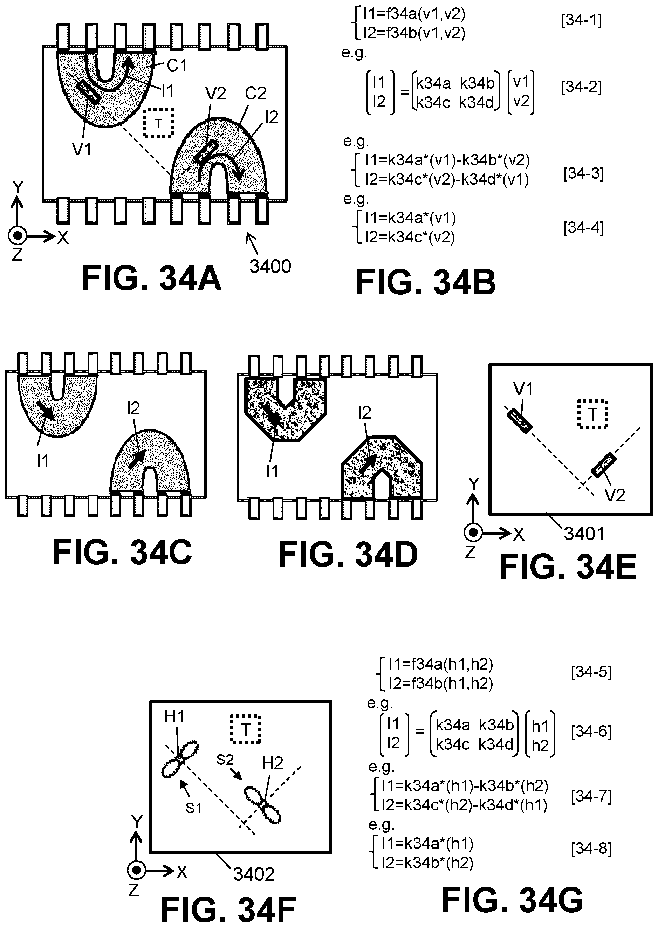

**FIG. 34A to FIG. 34G** may be jointly referred to as FIG. 34, and show a current sensor device 3400 which can be seen as another variant of the current sensor device 3200 of FIG. 32, or as another variant of the current sensor device 3300 of FIG. 33, where the two vertical Hall elements V1, V2 are oriented in perpendicular directions, and are slightly moved away from each other. The perpendicular orientations of the sensors V1, V2 may provide an improved cross-talk rejection.

In a particular embodiment (not shown), the sensor V1 is situated on a virtual line that coincides with the axes of highest sensitivity of V2.

In another or a further embodiment, the vertical Hall element V2 is slightly shifted towards the outer edge of the conductor C2, but is still located above the conductor C2. In this way the distance between V1 and V2 can be reduced, and the size of the substrate 3401 may be reduced.

Everything else described above for FIG. 32 and FIG. 33 is also applicable here, mutatis mutandis, e.g. one or both of the conductors C1, C2 may be located outside of the packaged device.

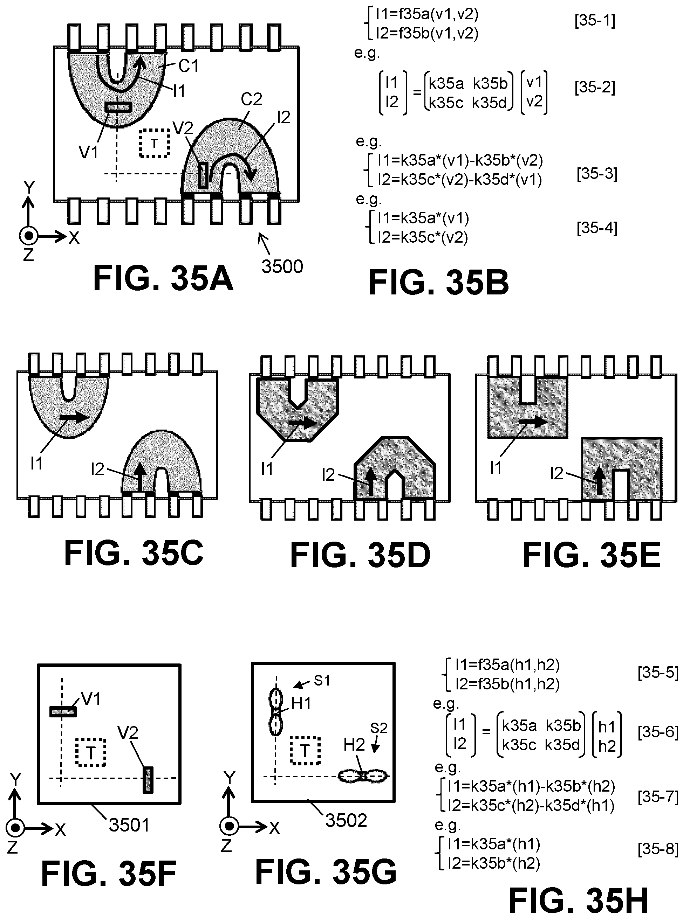

**FIG. 35A to FIG. 35G** may be jointly referred to as FIG. 35, and shows a current sensor device 3500 which can be seen as a variant of the current sensor devices 3400 of FIG. 34, and thus also as a further variant of FIG. 32 and FIG. 33. In the example shown in FIG. 35A, V1 is oriented with its axes of maximum sensitivity oriented in the Y-direction, and V2 is oriented with its axes of maximum sensitivity oriented in the X-direction.

Everything else described above for FIG. 32 to FIG. 34 is also applicable here, mutatis mutandis, e.g. one or both of the conductors C1, C2 may be located outside of the packaged device.

**FIG. 36A** shows an illustrative example of a multi-layer printed circuit board (PCB) comprising a first current conductor portion C1, and comprising an integrated current sensor device 3600 mounted on the PCB, above the first current conductor portion C1. The current sensor device 3600 is configured for measuring a first current I1 flowing through the first conductor portion C1 situated outside of the packaged device. The current sensor device 3600 further comprises a second current conductor portion C2, having a C-shape or a U-shape, and is further configured for measuring also a second current I2 flowing through the second conductor portion C2 situated inside the packaged device.

The current sensor device 3600 further comprises a semiconductor substrate comprising a plurality of magnetic sensors, for example four horizontal Hall elements H1 to H4 arranged on two perpendicular virtual lines.

In the example shown, the horizontal Hall elements H1 and H2 are preferably situated such that orthogonal projections of H1 and H2 on the semiconductor substrate containing them are situated outside of an orthogonal projection of the conductor C1, but preferably relatively close to the edges of C1. H3 is preferably situated near an inner edge of C2, and H4 is preferably situated near an outer edge of C2. By arranging the sensor elements in this way, cross-talk between I1 and I2 can be reduced in a passive manner (i.e. without calculations).

**FIG. 36B** shows formulas to determine a first and a second current I1, I2 based on signals h1 to h4 obtained from the magnetic sensors H1 to H4 of FIG. 36A.

The set [36-3] allows to further reduce cross-talk by simple calculations. Each of the currents is based on pairwise difference signals, hence the currents have a reduced sensivity to an external disturbance field.

The set [36-4] is a simplified version of the set [36-3], and does not allow to further reduce cross-talk by simple calculations, but is also based on pairwise difference signals, hence also offers a reduced sensitivity to an external disturbance field.

The set [36-5] is a variant of the set [36-4] that can be used if the magnetic sensitivities of the horizontal Hall elements H1 to H4 are not matched (as explained for set [1-5] of FIG. 1B).

**FIG. 36C** shows an illustrative example of a possible cross-sectional view in a plane A-A perpendicular to a printed circuit board containing the straight conductor portion C1.

**FIG. 36D** shows an illustrative example of a possible cross-sectional view in a plane B-B perpendicular to the printed circuit board containing the straight conductor portion C1.

**FIG. 36E** show an example of a semiconductor substrate 3601 comprising four horizontal Hall elements H1 to H4, arranged on two perpendicular lines, as can be used in the current sensor device 3600 of FIG. 36A.

In the example shown, the virtual line segment from H1 to H2 is located higher than the virtual line segment from H3 to H4 for illustrative purposes, but that is not absolutely required, and in another embodiment the line segment from H1 to H2 may intersect the line segment from H3 to H4. In this case, H1 to H4 may be located at the corners of a square or at the corners of a diamond.

In a variant (not shown), H1, H2 and H4 are located on a virtual line, and H1 to H4 are located on a virtual letter T.

**FIG. 36F** shows an illustrative example of a semiconductor substrate 3602 comprising two vertical Hall elements V1, V2, that can also be used in combination with the conductor portions C1, C2 and the package of FIG. 36A. In the example shown, V1 is oriented for measuring Bx1 at a first sensor location above C1, e.g. in the middle of the width direction, and V2 is oriented for measuring By2 at a second sensor location above C2, e.g. substantially halfway between the inner edge and the outer edge of the U-shape. V1 provides signal v1, and V2 provides signal v2.

**FIG. 36G** shows formulas to determine a first and a second current I1, I2 based on signals v1, v2 obtained from the magnetic sensors V1, V2 of FIG. 36F.

**FIG. 36H** shows an illustrative example of a semiconductor substrate 3603 comprising two magnetic sensors s1, s2, each comprising a horizontal Hall element and a pair of integrated magnetic concentrators, that can also be used in combination with the conductors and the package of FIG. 36A.

**FIG. 36I** shows formulas to determine a first and a second current I1, I2 based on signals h1, h2 obtained from the horizontal Hall elements H1, H2 of the magnetic sensors s1, s2 of FIG. 36H.

**FIG. 36A to FIG. 36I** may be jointly referred to as FIG. 36.

The main purpose of FIG. 36 is to show an example of a system comprising a printed circuit board and a current sensor device 3600, where the current sensor device comprises one integrated conductor portion C2, and the PCB comprises one conductor portion C1 located under the footprint of the package of the current sensor device 3600. As can be seen, by locating one of the conductor outside of the package, the package can become very small, (inter alia) because of the number of contacts (e.g. package pins) can be reduced.

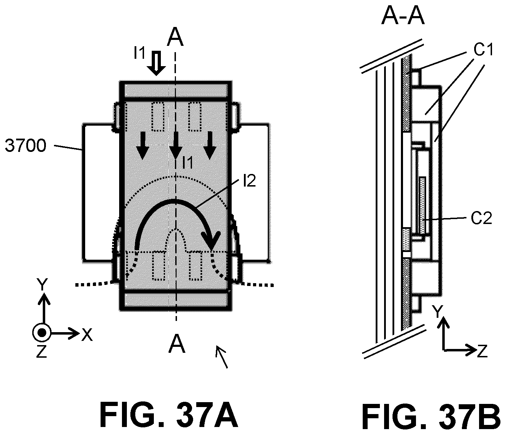

**FIG. 37A** to **FIG. 37B** show a variant of FIG. 38A and FIG. 38C, wherein the external conductor is routed over the packaged device, e.g. by means of a conductive clip.

**FIG. 37A** shows the same integrated current sensor device 3700 comprising a U-shaped conductor portion C2, and comprising a first (straight) conductor portion C1 external to the packaged semiconductor device, but in this example, the first conductor portion is or comprises an electrically conductive clip, arranged over the packaged semiconductor device rather than underneath. The same or similar semiconductor substrates 3601 (see FIG. 36E), 3602 (see FIG. 36F), and 3603 (see FIG. 36H), and the same formulas as mentioned in FIG. 36 can also be used here to determine the currents I1 and I2. It does not really matter whether the first conductor portion C1 is situated under or above the semiconductor substrate. The packaged current sensor device 3700 may still be mounted on a printed circuit board.

**FIG. 37B** shows an illustrative example of a possible cross-sectional view in a plane A-A perpendicular to the semiconductor substrate and/or perpendicular to the PCB (if used). As can be seen, the conductor portion C1 is situated on the right side of (i.e. "above") the packaged semiconductor device. The clip or bridge may contact the plastic or ceramic package.

**FIG. 37A to FIG. 37B** may be jointly referred to as FIG. 37.

The main purpose of FIG. 37 is to show an example of a system where one conductor portion is located inside the current sensor device, and one conductor portion is located above the current sensor device, e.g. in the form of a conductive clip or bridge.

**FIG. 38A** and **FIG. 38B** show a variant of FIG. 1.

**FIG. 38A** shows a current sensor device 3800 comprising a straight conductor portion C1 (extending in the X-direction), and comprising three horizontal Hall elements H1 to H3. The integrated conductor portion C1 may have a width Wi (measured in the Y-direction) smaller than a width Wo of the external conductor portions which are connected to C1 on the left side and the right side of the package. The external conductor C2 may have a narrowed portion formed in the PCB (e.g. as illustrated), for locally increasing the current density. As described above (e.g. in FIG. 1A), the Hall elements H1 to H3 are preferably not situated above the conductor portions C1, C2, but are preferably arranged above the edges, or close to the edges thereof.

**FIG. 38B** shows an illustrative example of a possible cross-sectional view in a plane A-A perpendicular to the semiconductor substrate and/or perpendicular to the PCB (if used).

**FIG. 38A and FIG. 38B** may be jointly referred to as FIG. 38.

The main purpose of FIG. 38 is to show an example of a system where one conductor portion (here: C1) is located inside the packaged current sensor device or chip 3800), and one conductor portion (here: C2) is located outside of the chip.

The same formulas as mentioned in FIG. 1B are applicable, but of course, the values of the coefficients may be different.

**FIG. 39A** shows a current sensor system which can be seen as a variant of FIG.38 where the current sensor device 3900 has four horizontal Hall elements instead of only three. FIG. 39A can also be see as a variant of FIG. 2 where the conductor portion C1 is integrated, and the conductor portion C2 is external of the packaged semiconductor device, e.g. implemented as one or more conductive tracks of a multi-layer PCB.

**FIG. 39B** shows an illustrative example of a possible cross-sectional view in a plane A-A perpendicular to the semiconductor substrate and/or perpendicular to the PCB (if used).

**FIG. 39A and FIG. 39B** may be jointly referred to as FIG. 39.

The same formulas as mentioned in FIG. 2B are applicable, but of course, the values of the coefficients may be different.

The main purpose of **FIG. 36 to FIG. 39** is to provide a few examples of a current sensor device capable of measuring two currents, including a first current I1 flowing through a first conductor C1 portion, and a second current I2 flowing through a second conductor portion C2, where only one conductor portion is incorporated inside the packaged device, and the other conductor portion is situated outside of the packaged device, e.g. under or over the packaged device.

In an embodiment, both conductor portions are implemented as crossing conductive tracks of a multi-layer PCB, rounted under the packaged current sensor device 4000.

In another embodiment, one of the conductor portions is implemented as one or more conductive tracks of a multi-layer PCB, rounted under the packaged current sensor device 4000, and the other of the conductive portions is rounted over the packaged current sensor device 4000, e.g. in the form of a conductive clip.

**FIG. 41** shows a high-level block-diagram of a current sensor device 4100 comprising at least one semiconductor substrate comprising a plurality of magnetic sensors M1, M2 as can be used in embodiments of the present invention, e.g. as any of the integrated current devices 100, 200, ... 4000 illustrated in FIG. 1 to FIG. 40. FIG. 41 is provided for completeness only.

The sensor device 4100 may comprise for example two or three or four horizontal Hall elements, or two or three or four vertical Hall elements, or two or three or four magnetic sensors each comprising a horizontal Hall element and two integrated magnetic concentrators on opposite sides thereof, but the present invention is not limited hereto, and other magnetic sensors may also be used, e.g. magneto-resistive sensors, e.g. AMR, GMR, XMR, TMR sensors.

The sensor device 4100 further comprises a biasing and readout circuit 4112 for biasing the magnetic sensor elements. Biasing and read-out circuits are well known in the art, are not the main focus of the present invention, and hence do not need to be described in more detail here. It suffices to say that the biasing and readout circuit may comprise for example one or more current sources or voltage sources, one or more amplifiers, one or more multiplexer, one or more analog-to-digital convertors (ADC), etc.

The sensor device 4100 typically also comprises at least one temperature sensor T, e.g. arranged for measuring or estimating a temperature of the magnetic sensor elements. It is noted that a single temperature sensor may be sufficient to measure a single temperature that can be used for all the sensor elements, especially if all the sensor elements are embedded in a single semiconductor substrate.

The sensor device 4100 further comprises a processing circuit 4113, e.g. a digital processing circuit, e.g. comprising a programmable processor, e.g. a CPU or a Digital Signal Processor (DSP). The processing circuit may be implemented on the same semiconductor substrate that also comprises the magnetic sensors, but that is not absolutely required, and the processing circuit may also be implemented on a second semiconductor substrate, electrically connected to the first semiconductor substrate that comprises the magnetic sensors, and preferably integrated in the same packaged semiconductor device or "chip".

The sensor device 4100 may further comprise a non-volatile memory 4114, e.g. flash, which may be incorporated in the processing circuit, or may be connected to the processing circuit, and which may store one or more parameters, for example one or more of the weighting factors or scaling factors described above. Of course, the non-volatile memory may also contain other information, such as for example executable instructions.

In preferred embodiments, the sensor device 4100 is a single packaged semiconductor device, typically referred to as "chip package".

The processing circuit is configured to determine a first current value I1 and a second current value I2 using at least one of the sets of formulas described above, and to output the current values I1, I2 as digital values, or as analog signals.

In an embodiment, the two current values I1, I2 are output as digital values using a digital protocol via a single terminal or via an output port or via a communication interface, or via two separate terminals or output ports, or via a bidirectional communication interface.

In an embodiment, the two current values are output as two PWM (pulse width modulated) signals.

In an embodiment, the current sensor device may further comprise one or two digital-to-analog convertor(s) for converting the calculated current values I1, I2 into two analog signals, and the current sensor device may further comprise two analog output ports (e.g. called AOUT1 and AOUT2) for outputting these analog signals. These analog signals may be proportional to the measured current values, e.g. scaled with a predefined or configurable scaling factor. In an embodiment, the scaling factor may be configurable by an external processor communicatively connected to the current sensor device.

In the example illustrated in FIG. 41, the current sensor device 4100 comprises a single processing circuit 4113 to calculate the two current values. For example, the magnetic field component values, and/or pairwise differences can be time-multiplexed in a single signal processing chain. **An** advantage is a more compact and/or more cost effective assembly, in particular a smaller integrated circuit. Alternatively, two signal processing chains may be used.

### REFERENCE NUMBERS:

modulo 100:
   - -00, -50, -60: current sensor device (in the form of a packaged semiconductor device)
   - -01,-02,-03, -51, -61: semiconductor substrate
   - -04: contacts
   - -10: bond wire
   - -11: package contacts (e.g. pins or terminals)
   - -12: biasing and readout circuit
   - -13: processing unit
   - -14: non-volatile memory
other:
   - H1, H2, ...: first, second, ... horizontal Hall element
   - V1, V2, ...: first, second, ... vertical Hall element
   - IMC1a, IMC1b: first pair of two integrated magnetic concentrators
   - C1, C2: first, second conductor
   - T: (optional) temperature sensor
   - I1, I2: first, second current
   - co1, co2, ...: first, second cut-out
   - zz1, zz2: first, second zig-zag

## Claims

1. An integrated current sensor device for measuring two currents (11, I2) flowing through two conductor portions (C1, C2), the integrated current sensor device comprising:
- a semiconductor substrate comprising a plurality of at least two magnetic sensors;
- a processing circuit connected to said plurality of magnetic sensors, and configured for determining a first current value (11) of a first current flowing through a first conductor portion (C1) and for determining a second current value (12) of a second current flowing through a second conductor portion (C2), based on signals obtained from said plurality of magnetic sensors.

2. An integrated current sensor device according to claim 1,
wherein the plurality of magnetic sensors comprises at least two magnetic sensors situated at two different sensor locations;
or wherein the plurality of magnetic sensors comprises at least three magnetic sensors situated at three different sensor locations;
or wherein the plurality of magnetic sensors comprises at least four magnetic sensors situated at four different sensor locations.

3. An integrated current sensor device according to any of the previous claims,
wherein the integrated current sensor device is a packaged semiconductor device;
and wherein at least one of the first conductor portion (C1) and the second conductor portion (C2) is integrated in the packaged semiconductor device.

4. An integrated current sensor device according to any of the previous claims,
wherein the integrated current sensor device is a packaged semiconductor device;
and wherein each of the first conductor portion (C1) and the second conductor portion (C2) is integrated in the packaged semiconductor device.

5. An integrated current sensor device (100; 200; 300; 400; 500; 600; 700; 800) according to any of the previous claims,
wherein each of the first and the second conductor portion (C1, C2) has an elongated shape with a constant thickness; ;
and wherein the first conductor portion (C1) is oriented in a first direction (X);
and the second conductor portion (C2) is oriented in a second direction (Y) perpendicular to the first direction (X);
and wherein the first and the second conductor portions partially overlap each other in an overlapping region.

6. An integrated current sensor device according to any of the claims 1 to 4,
wherein the first conductor portion (C1) and the second conductor portion (C2) are located next to each other, without overlapping each other;
or wherein the first conductor portion (C1) and the second conductor portion (C2) are co-planar.

7. An integrated current sensor device according to claim 6,
wherein each of the first and the second conductor portion (C1, C2) has an elongated shape; and wherein the first conductor portion (C1) and the second conductor portion (C2) extend in the same direction, or are parallel to each.
or wherein each of the first and the second conductor portion (C1, C2) has an overall elongated shape extending along two parallel lines; and wherein the first conductor portion (C1) has two cut-outs on opposite sides forming a first zigzag for orienting the first current (11) to flow in a direction different from the first direction (X);
or wherein each of the first and the second conductor portion (C1, C2) has an overall elongated shape extending along two parallel lines; and the first conductor portion has two cut-outs on opposite sides thereof forming a first zigzag (zz1) to force the first current to flow in a direction different from the first direction; and the second conductor portion has two cut-outs on opposite sides thereof forming a second zigzag (zz2) to force the second current to flow in a direction different from the first direction.

8. An integrated current sensor device (2200; 2300; 2400; 2500; 2600; 2700; 2800; 2900; 3000; 3100; 3200; 3300; 3400; 3500; 3600; 3700) according to any of the previous claims,
wherein at least one, or both of the first and the second conductor portion (C1, C2) has a U-shape or a V-shape; and wherein each end (E1, E2) of the first conductor portion (C1) and each end (E3, E4) of the second conductor portion (C2) is connected to at least two pins or terminals of the package.

9. An integrated current sensor device according to any of the previous claims,
wherein the plurality of magnetic sensors are configured for measuring magnetic field components oriented perpendicular to the semiconductor substrate.

10. An integrated current sensor device according to any of the claims 1 to 8,
wherein the plurality of magnetic sensors are configured for measuring a plurality of magnetic field components parallel to the semiconductor substrate.

11. An integrated current sensor device according to any of the claims 1 to 8,
wherein each of the magnetic sensors comprises a horizontal Hall element and a pair of integrated magnetic concentrators.

12. An integrated current sensor device according to any of the previous claims,
further comprising a non-volatile memory (4114).

13. An integrated current sensor device according to any of the previous claims,
wherein the processing unit is configured for determining the first current (11) as a first function or a first combination of signals obtained from the magnetic sensors using a first set of coefficients;
and wherein the processing unit is configured for determining the second current (12) as a second function or a second combination of signals obtained from the magnetic sensors using a second set of coefficients.

14. An integrated current sensor device according to any of the previous claims,
wherein the plurality of magnetic sensors comprises three magnetic sensors configured for measuring three parallel magnetic field components at three different locations, or wherein the plurality of magnetic sensors comprises four magnetic sensors configured for measuring four parallel magnetic field components at four different locations;
and wherein the processing unit is configured for determining a first pairwise difference (diff1) between a first pair of said magnetic field components, and for determining a second pairwise difference (diff2) between a second pair of said magnetic field components, different from the first pair;
and for determining the first current (11) as a first function of the first pairwise difference (diff1) and the second current (12) as a second function of the second pairwise difference (diff2), or for determining the first current (11) as a first function or a first combination of the first and second pairwise difference and the second current (12) as a second function or a second combination of the first and second pairwise difference.

15. A current sensor system comprising:
- a first conductor portion (C1) for conducting a first current (11) to be measured;
- a second conductor portion (C2) for conducting a second current (12) to be measured;
- an integrated current sensor device according to any of the previous claims;
- wherein at least one of the first conductor portion (C1) and the second conductor portion (C2) is located outside of the integrated current sensor device.
